(19) Europäisches Patentamt
European Patent Office
Office européen des brevets

(11) EP 1 892 257 A1

(12) EUROPEAN PATENT APPLICATION
published in accordance with Art. 153(4) EPC

(43) Date of publication:
**27.02.2008 Bulletin 2008/09**

(21) Application number: **06766520.8**

(22) Date of filing: **09.06.2006**

(51) Int Cl.:
***C08G 61/00*** *(2006.01)* ***C09K 11/06*** *(2006.01)*
***H01L 51/50*** *(2006.01)* ***H05B 33/10*** *(2006.01)*

(86) International application number:
**PCT/JP2006/311608**

(87) International publication number:
**WO 2006/132355 (14.12.2006 Gazette 2006/50)**

(84) Designated Contracting States:
**DE GB**

(30) Priority: **10.06.2005 JP 2005171065**

(71) Applicant: **Sumitomo Chemical Company, Limited**
**Tokyo 104-8260 (JP)**

(72) Inventors:
- **OHUCHI, Kazuei**
  **3050005 (JP)**
- **HIGASHIMURA, Hideyuki**
  **3050045 (JP)**
- **ANRYU, Makoto**
  **3050821 (JP)**

(74) Representative: **Vossius & Partner**
**Siebertstrasse 4**
**81675 München (DE)**

# (54) AROMATIC GRAFT POLYMER

(57) An aromatic graft polymer containing one or more kinds of repeating units represented by the following formula (1). (In the formula, $Ar^1$ represents a divalent residue of a π-conjugated cyclic compound having a side chain represented by the following formula (2), the side chain being bonded to a carbon atom which is included in the ring structure of the divalent π-conjugated-cyclic-compound residue represented by $Ar^1$ and has an $sp^2$ hybrid orbital: (wherein $Ar_2$ represents a divalent group having a residue of a π-conjugated cyclic compound; $X^1$ represents a direct bond or a divalent group selected from the group consisting of $NQ^1$-, -$PQ^2$-, and -$BQ^3$-, wherein $Q^1$ to $Q^3$ each independently represents a substituent; Z represents a direct bond or a divalent connecting group; k is an integer of 3 or larger; and $E^1$ represents hydrogen, halogeno, or a monovalent organic group, provided that when two or more $Ar^{2}$' s, $X^{1}$' s, and Z's are present, then they each may be the same or different and when two or more side chains represented by the formula (2) are present, then they may be the same or different.))

EP 1 892 257 A1

## Description

### TECHNICAL FIELD

The present invention relates to a novel aromatic graft polymer. In particular, the present invention relates to an aromatic graft polymer having a repeating unit in a side chain.

### BACKGROUND ART

It is known that the structure and rigidity of a graft polymer in a solution can be controlled by the presence of a side chain (graft chain) branched from a main chain as compared with the corresponding linear polymer and the application thereof to a drug delivery system is advanced in a medicinal field.
It is also known that the graft polymer has an effect on bulk properties such as mechanical, rheology and optical properties, and development and use development of a new material using the graft polymer are advanced.
The mixing of polymers having different properties is known as an effective method for producing a highly functional polymeric material having new properties. However, it is known that the properties of the graft polymer can be controlled with a relatively high degree of freedom, as compared with mixtures of the corresponding linear random polymer, linear block polymer or linear homopolymers with each other by adjusting the number of branches or a side chain length without considering mutual solubility.
The application of the graft polymer as a compatibilizer for enhancing mutual solubility in the mixture of the corresponding linear polymer is also advanced (for example, see Non-Patent Document 1).
On the other hand, since an aromatic polymer exhibits specific characters in electronic properties such as charge transporting property and luminescence and mechanical properties such as rigidity and heat stability, the application has been heretofore actively advanced in an electronic industry material, chemistry, energy material, and medicinal fields or the like (for example, see Non-Patent Document 2 and Patent Document 1).
In the aromatic polymer, it is known that a polymer having a branch can serve as a material having excellent solubility and film-forming property in the electronic industry material field (for example, see Patent Document 2).
However, as shown in Non-Patent Document 1, as the graft polymer, an aliphatic graft polymer has been heretofore widely known. However, there is not known an example where an aromatic graft polymer having an aromatic repeating unit in a side chain, which is directly bonded to an aromatic ring contained in a main chain, is obtained. As shown in Patent Document 2, the polymer having the branch is known as the aromatic polymer. However, since the branch points of the branched polymer is not limited to only the main chain, there is a problem that an increase in the number of branch points may cause a network-like polymer to generate the gelation of the polymer and to impair the solubility. It is believed to be difficult to freely control the properties, unlike the aromatic graft polymer of the present invention.
Non-Patent Document 1: Encyclopedia of Polymer Science and Technology, John Wiley & Sons, Inc. Article Online Posting Date: July 15, 2002
Non-Patent Document 2: Journal of Polymer Science: Part A: Polymer Chemistry, Vol.39, 1533-1556 (2001)
Patent Document 1: Japanese Patent No. 3606217 (US 2001037000A1)
Patent Document 2: JP-A-2001-342459 (US 2002027623A1)

### DISCLOSURE OF THE INVENTION

#### Problem to be Solved by the Invention

However, when a conventional polymeric compound having an aromatic ring in a main chain is used as a polymer phosphor, the polymer phosphor has insufficient charge transporting property and luminescence.
It is an object of the present invention to provide a novel aromatic graft polymer. More particularly, it is an object of the present invention to provide a novel aromatic polymer having excellent charge transporting property and luminescence.

#### Means for Solving the Problem

The present inventors have intensively studied to solve the above-mentioned problem and resultantly found an aromatic graft polymer having an aromatic repeating unit in a side chain, wherein the nucleus of a main chain is substituted by the side chain so that a carbon atom in the main chain and a carbon atom in the side chain are bonded to form a $\pi$-conjugated system with a $\pi$-conjugated cyclic compound group contained in the main chain, leading to completion of the present invention.
That is, the present invention provides a novel aromatic graft polymer containing one or more kinds of repeating units represented by the following formula (1) in a main chain,

$$-Ar^1- \qquad (1)$$

wherein $Ar^1$ represents a divalent residue of a $\pi$-conjugated cyclic compound having a side chain represented by the following formula (2), and the side chain is bonded to a carbon atom which is contained in a cyclic structure of the divalent residue of a $\pi$-conjugated cyclic compound represented by $Ar^1$ and has an $sp^2$ hybrid orbital,

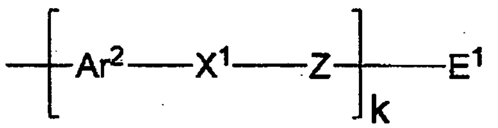

(2)

wherein $Ar^2$ represents a divalent group having a residue of a $\pi$-conjugated cyclic compound; $X^1$ represents a direct bond or a divalent group selected from the group consisting of $NQ^1$-, $-PQ^2$-, and $-BQ^3$-; $Q^1$ to $Q^3$ each independently represents a substituent; Z represents a direct bond or a divalent linking group; k is an integer of 3 or more; $E^1$ represents a hydrogen atom, a halogen atom, or a monovalent organic group; when two or more $Ar^2$'s, $X^1$'s, and Z's are present, they each may be the same or different; and when two or more side chains represented by the formula (2) are present, they may be the same or different.

Advantages of the Invention

The aromatic graft polymer of the present invention is expected as a useful polymeric material for producing various highly functional materials in an electronic industry material, chemistry, energy material and medicinal fields or the like.
Of these, in the electronic industry material field, for example, when the aromatic graft polymer of the present invention is used for a polymer light emitting device (hereinafter, referred to as polymer LED in some cases), the polymer light emitting device can be highly functionalized by applying a functional side chain for improving charge injecting/transporting property to a main chain having charge transporting property to improve charge injecting/transporting property, by applying a functional side chain containing a fluorescent or phosphorescent dye to adjust a light emission wavelength, or by applying a functional side chain having charge injecting property and charge transporting property, or the like to a fluorescent main chain to improve light emitting efficiency and charge injecting/transporting property.
In addition, the aromatic graft polymer of the present invention is expected to be realized while suppressing phase separation as compared with the cases where a polymer has a repeating unit having the corresponding function in a main chain and/or a low molecular weight additive having a the corresponding function is mixed.
It is believed that a random copolymer and a block copolymer or the like prepared by combining a repeating unit having electron injecting/transporting property, a repeating unit having hole injecting/transporting property and a light-emitting repeating unit interfere charge injecting/transporting properties contained in the repeating units with each other. However, in the aromatic polymer of the present invention, functions such as injection of positive charges, injection of negative charges, transportation of positive charges, transportation of negative charges and light emission are separated and shared by the main chain and the side chain, or the side chains as compared with the case where the random copolymer or block copolymer are used. Thereby, the introduction rate of a portion having each of the functions can be freely set without impairing each of the functions. That is, the amount of a functional substituent to be introduced can be controlled to take functional balance between a function originally contained in the main chain and a functional substituent to be introduced. Thereby, the polymer light emitting device is expected to be highly functionalized.
In the chemistry field, when an aromatic polymer is used as a structure material, phase separation can be controlled by using an aromatic graft polymer as a main component or an additive. Thereby, the structure material is expected to be highly functionalized.
Also, an example using an aromatic polymer is known in producing a polymer electrolyte such as a proton conducting film for a fuel cell in the energy material field. However, the high functionalization of the film such as the enhancement of ion exchange capacity is expected while maintaining the film strength as compared with the corresponding linear polymer by using an aromatic graft polymer in which a side chain having a substituent having ionic exchange property is introduced.
Since the main chain and the side chain are bonded by an aromatic ring carbon-aromatic ring carbon conjugated bond in the aromatic graft polymer of the present invention, the aromatic graft polymer is expected to have high thermal and chemical stabilities. The three-dimensional interaction of the side chains or the side chain and main chain in the same

polymer chain can be expected to be controlled by the rigidity of the branched structure of the side chain, and the aromatic graft polymer can be expected to have high thermal stability. Since the π-conjugated cyclic compound groups are bonded by the carbon-carbon conjugated bond, the tuning of the electronic energy level of the main chain is expected to be enabled by the side chain.
Thus, in the aromatic graft polymer of the present invention, the function of the main chain is expected to be adjusted or improved by the side chain, or a new function is expected to be imparted by the side chain without impairing the function of the main chain. Furthermore, various high functionalizations can be expected to be realized with a high degree of freedom with a lower limiting as compared with the mixing of the corresponding various linear polymer, the random copolymer and the block copolymer or the like.

BRIEF DESCRIPTION OF THE DRAWINGS

Fig. 1 shows the measurement result of a voltage/current characteristic of an EL device in Example 5;
Fig. 2 shows the measurement result of a voltage/current characteristic of an EL device in Example 6;
Fig. 3 shows the measurement result of a voltage/current characteristic of an EL device in Example 7;
Fig. 4 shows the measurement result of a voltage/current characteristic of an EL device in Comparative Example 1;
Fig. 5 shows the measurement result of a voltage/current characteristic of an EL device in Comparative Example 2; and
Fig. 6 shows the measurement result of a voltage/current characteristic of an EL device in Comparative Example 3.

BEST MODE FOR CARRYING OUT THE INVENTION

An aromatic graft polymer of the present invention includes one or more kinds of repeating units represented by the formula (1).
The repeating unit represented by the formula (1) is a divalent residue of a π-conjugated cyclic compound having a side chain represented by the formula (2). The side chain is bonded to a carbon atom which is included in the cyclic structure of the divalent residue of the π-conjugated cyclic compound represented by $Ar^1$ and has an $sp^2$ hybrid orbital. That is, the nucleus of the divalent residue of the π-conjugated cyclic compound represented by $Ar^1$ is substituted by the side chain represented by the formula (2).
In the present invention, the divalent residue of the π-conjugated cyclic compound is an atomic group formed by removing two hydrogen atoms among hydrogen atoms bonded to carbon being present in the cyclic structure as a main chain of the π-conjugated cyclic compound and having an $sp^2$ hybrid orbital from the π-conjugated cyclic compound. The divalent residue of the π-conjugated cyclic compound includes those having a condensed ring. The divalent residue of the π-conjugated cyclic compound may have a substituent. However, the side chain represented by the formula (2) is not bonded to the carbon atom of the substituent.
Examples of the divalent residue of the π-conjugated cyclic compound include an arylene group, heterocyclic compound group having a divalent π-conjugated system, and those having a condensed ring.
The number of the side chains that are bonded to the divalent residue of the π-conjugated cyclic compound represented by $Ar^1$ and that are represented by the formula (2) is not more than that of the side chains capable of being bonded to the divalent residue of the π-conjugated cyclic compound represented by $Ar^1$. However, in view of easiness of synthesis, the number of the side chains is preferably 1 or more and 4 or less per divalent residue of the π-conjugated cyclic compound represented by $Ar^1$, more preferably 1 or more and 2 or less, and still more preferably 1.
The arylene group is an atomic group formed by removing two hydrogen atoms bonded to carbon having an $sp^2$ hybrid orbital being present in a cyclic structure from an aromatic hydrocarbon. The arylene group includes those having a condensed ring. The arylene group may have a substituent. The number of carbon atoms of a portion other than the substituent in the arylene group is usually about 6 to 60, and preferably 6 to 20. The number of all carbon atoms including the substituent of the arylene group is usually about 6 to 100. As the arylene group, the following formulae 1A-1 to 1A-14 etc. are exemplified.
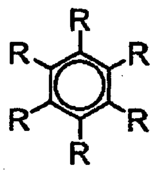

1A-1

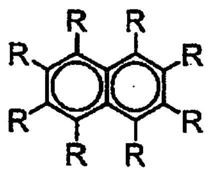

1A-2

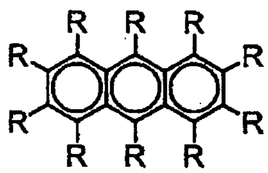

1A-3

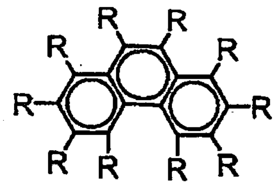

1A-4

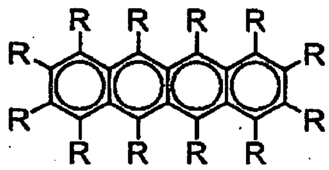

1A-5

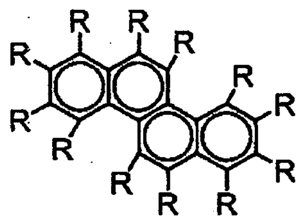

1A-6

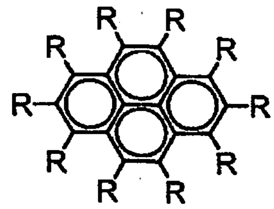

1A-7

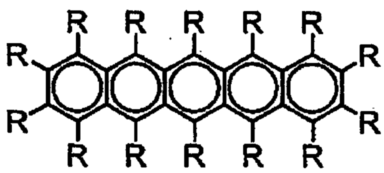

1A-8

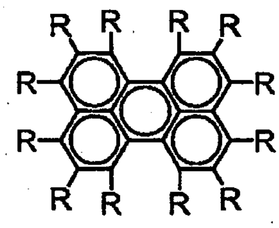

1A-9

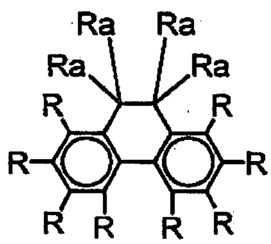

1A-10

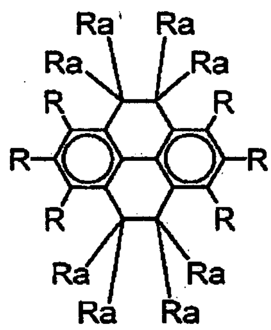

1A-11

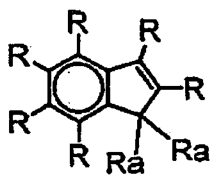

**1A-12**

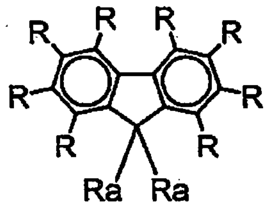

**1A-13**

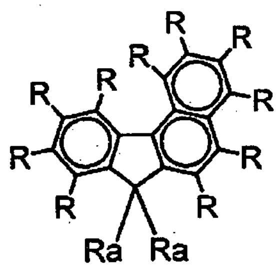

**1A-14**

In the formulae 1A-1 to 1A-14, R represents a linkage, a side chain represented by the formula (2), a hydrogen atom or a substituent. Any two R's of two or more R's which are present represent a linkage. When two or more substituents represented by R are present, they may be the same or different. Ra represents a hydrogen atom or a substituent. When two or more substituents represented by Ra are present, they may be the same or different. When two Ra's are present on the same atom, they may to be combined to form an oxo group and thioxo group, or may be bonded with each other to form a ring.

The substituents represented by R on the adjacent atoms may form an aliphatic ring of a 5 to 7-membered ring or an aromatic ring of a 5 to 7-membered ring which may contain a hetero atom such as an oxygen atom, a sulfur atom and a nitrogen atom.

Among the formulae 1A-1 to 1A-14, in view of easiness of synthesis, a phenylene group (formula 1A-1), a naphthalene-diyl group (formula 1A-2), and a fluorene-diyl group (formula 1A-13) are preferable as the arylene group represented by $Ar^1$. Of these, a phenylene group (formula 1A-1) and a naphthalene-diyl group (formula 1A-2) are preferable.

Among the formulae 1A-1 to 1A-14, in view of improving device properties such as charge transporting property, fluorescence intensity and light-emitting efficiency when using the aromatic graft polymer of the present invention for a polymer LED, a phenylene group (formula 1A-1), a dihydrophenanthrene-diyl group (formula 1A-10), a fluorene-diyl group (formula 1A-13) and a benzofluorene-diyl group (formula 1A-14) are preferable as the arylene group represented by $Ar^1$. Of these, the fluorene-diyl group (formula 1A-13) and benzofluorene-diyl group (formula 1A-14) are preferable.

The heterocyclic compound group having the divalent $\pi$-conjugated system is an atomic group formed by removing two hydrogen atoms from a heterocyclic compound having a $\pi$-conjugated system, the hydrogen atoms bonded to carbon being present in the cyclic structure and having an $sp^2$ hybrid orbital. The heterocyclic compound group includes those having a condensed ring. The heterocyclic compound group having the divalent $\pi$-conjugated system may have a substituent. Herein, the heterocyclic compound means those containing not only a carbon atom but also a hetero atom such as an oxygen atom, a sulfur atom, a nitrogen atom, a phosphorus atom, a boron atom, an arsenic atom, a silicon atom and a selenium atom in a cyclic structure as elements which constitute the cyclic structure among aromatic compounds having a cyclic structure.

The number of carbon atoms of a portion other than the substituent in the heterocyclic compound group having the divalent $\pi$-conjugated system is usually about 2 to 60, and preferably 2 to 20. The number of all carbon atoms containing the substituent of the heterocyclic compound group having the divalent $\pi$-conjugated system is usually about 2 to 100. As the heterocyclic compound group having the divalent $\pi$-conjugated system, the following formulae 2A-1 to 2A-53 etc. are exemplified.

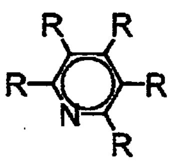

**2A-1**

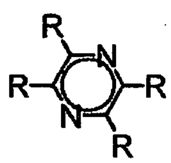

**2A-2**

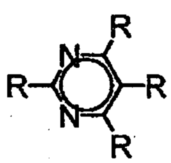

**2A-3**

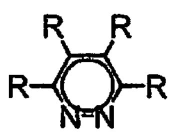

**2A-4**

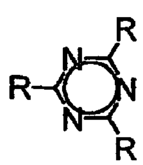

**2A-5**

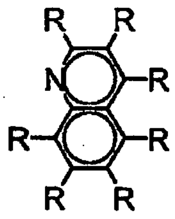
2A-6

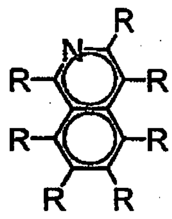
2A-7

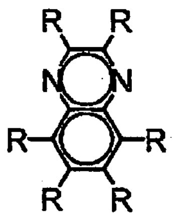
2A-8

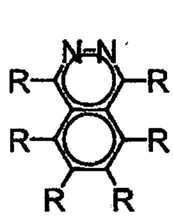
2A-9

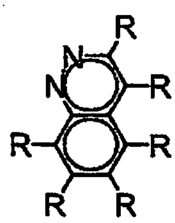
2A-10

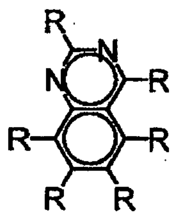
2A-11

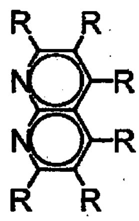
2A-12

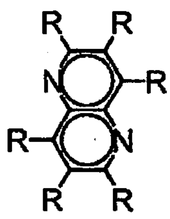
2A-13

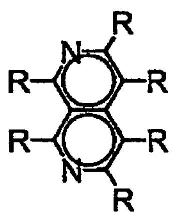
2A-14

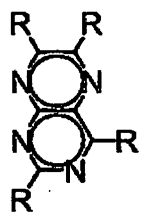
2A-15

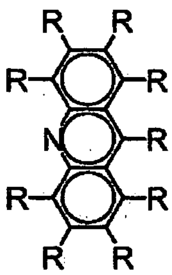
2A-16

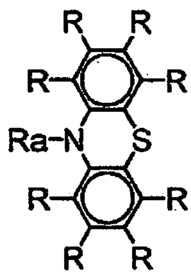
2A-17

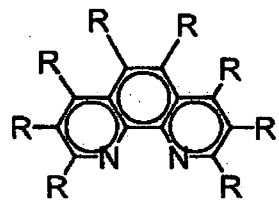
2A-18

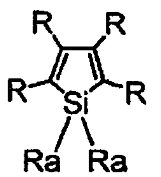
2A-19

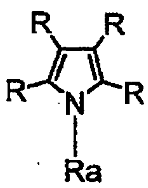
2A-20

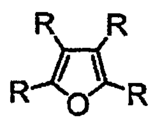
2A-21

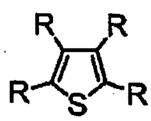
2A-22

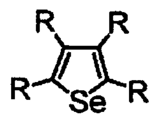
2A-23

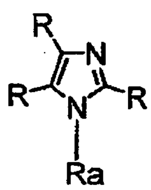
2A-24

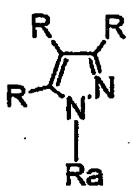
2A-25

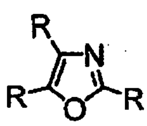
2A-26

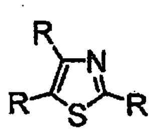
2A-27

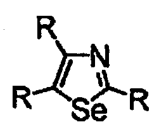
2A-28

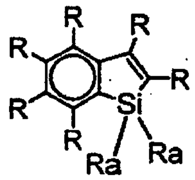
2A-29

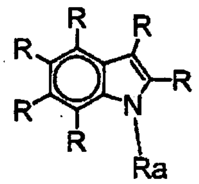
2A-30

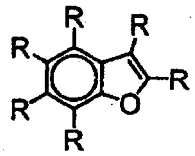
2A-31

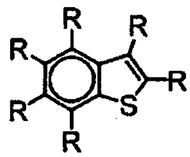
2A-32

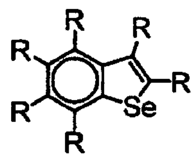
2A-33

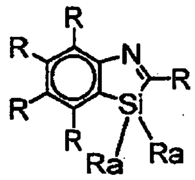
2A-34

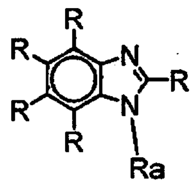
2A-35

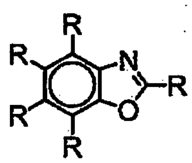
2A-36

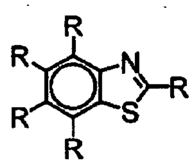
2A-37

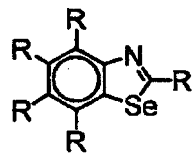
2A-38

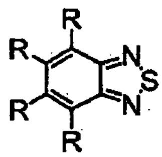
2A-39

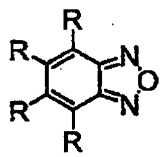
2A-40

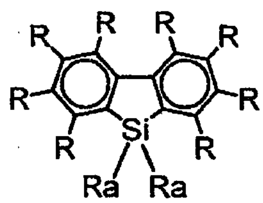
2A-41

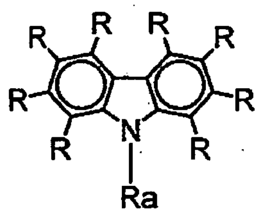
2A-42

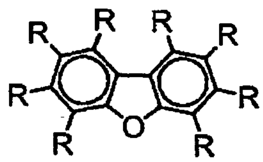
2A-43

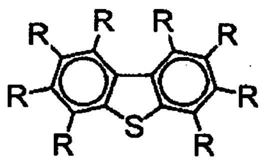
2A-44

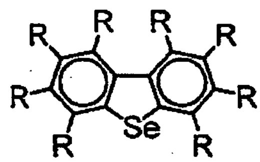
2A-45

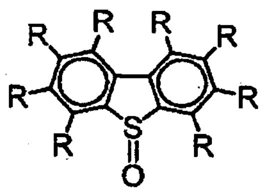
2A-46

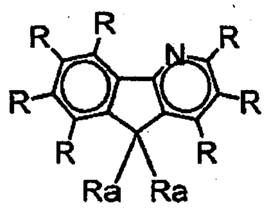

2A-47

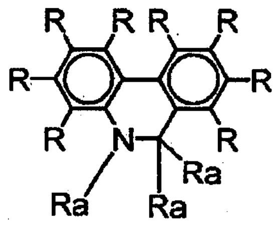

2A-48

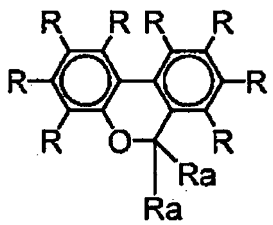

2A-49

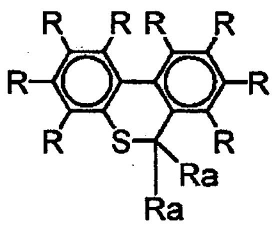

2A-50

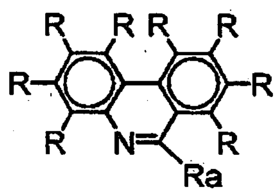

2A-51

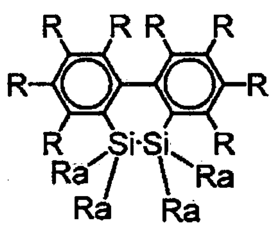

2A-52

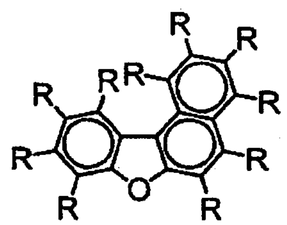

2A-53

In the formulae 2A-1 to 2A-53, R represents a linkage, a side chain represented by the formula (2), a hydrogen atom or a substituent. Any two R's of two or more R's which are present represent a linkage. When two or more substituents represented by R are present, they may be the same or different. Ra represents a hydrogen atom or a substituent. When two or more substituents represented by Ra are present, they may be the same or different. When two Ra's are present on the same atom, they may to be combined to form an oxo group and a thioxo group, or may be bonded with each other to form a ring.

The substituents represented by R on the adjacent atoms may form a 5 to 7-membered aliphatic ring which contains a hetero atom such as oxygen atom, a sulfur atom and a nitrogen atom or a 5 to 7-membered aromatic ring which may contain a hetero atom such as an oxygen atom, a sulfur atom and a nitrogen atom.

Among the formulae 2A-1 to 2A-53, in view of improvement of device properties such as charge transporting property, fluorescence intensity and light-emitting efficiency when using the aromatic graft polymer of the present invention for the polymer LED, as the divalent heterocyclic compound group having the $\pi$-conjugated system represented by $Ar^1$, a pyridine-diyl group (formula 2A-1), a quinoline-diyl group (formula 2A-6), an isoquinoline-diyl group (formula 2A-7), a quinoxaline-diyl group (formula 2A-8), a phenanthroline-diyl group (2A-18), a thiophene-diyl group (formula 2A-22), an imidazole-diyl group (2A-24), an oxazole-diyl group (formula 2A-26), a thiazole-diyl group (2A-27), a 5-membered heterocyclic group (formulae 2A-30 to 2 A-32, 2A-34 to 2A-40) containing nitrogen, sulfur and oxygen as a hetero atom and having a condensed benzene ring, and a heterocyclic group (formulae 2A-41 to 2A-44, 2A-46 to 2A-47) containing silicon, nitrogen, oxygen and sulfur as a hetero atom and having a fluorene-analogous skeleton, and a heterocyclic group having a condensed structure represented by formulae (2A-48 to 2A-53) are preferable. A thiophene-diyl group

(formula 2A-22), a thiazole-diyl group (formula 2A-27), a benzothiadiazole-diyl group (formula 2A-39), a benzooxadiazole-diyl group (2A-40), a dibenzosilole-diyl group (formula 2A-41), a carbazole-diyl group (formula 2A-42), a dibenzofuran-diyl group (formula 2A-43), a dibenzothiophene-diyl group (formula 2A-44), an azafluorene-diyl group (formula 2A-47) and a dibenzopyran-diyl group (formula 2A-49) are more preferable. A carbazole-diyl group (formula 2A-42), a dibenzofuran-diyl group (formula 2A-43), a dibenzoth-iophene-diyl group (formula 2A-44) and a dibenzopyran-diyl group (formula 2 A-49) are still more preferable.

As the group represented by $Ar^1$, an arylene group having a condensed structure and a divalent heterocyclic group are preferable. An arylene group having a condensed structure, and a divalent heterocyclic group having a condensed structure are more preferable, and an arylene group having a condensed structure is still more preferable.

As the substituent represented by R or Ra, there are exemplified an alkyl group, an aryl group, an aralkyl group, a monovalent heterocyclic group (formula R-1), an alkenyl group which may be substituted (formula R-2), an alkynyl group (formula R-3) which may be substituted, a formyl group (formulae R-4 to R-7) which may be substituted, a thioformyl group (formulae R-8 to R-11) which may be substituted, an imine residue (formulae R-12 to R-15, R-28) which may be substituted, a hydroxy group (formulae R-16 to R-19) which may be substituted, a mercapto group (formulae R-20 to R-23) which may be substituted, an amino group (formulae R-24 to R-27, R-29) which may be substituted, a halogen atom (formulae R-30 to R-33), a substituted sulfonyl group (formula R-34), a silyl group (formula R-35) which may be substituted, a silanol group (formula R-36) which may be substituted, a sulfonic group (formula R-37), a phosphono group (formula R-38), a cyano group (formula R-39), and a nitro group (formula R-40).

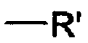
R-1

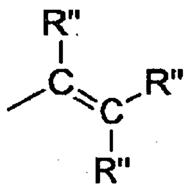
R-2

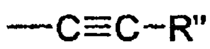
R-3

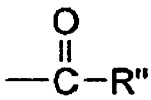
R-4

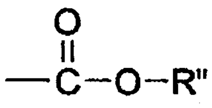
R-5

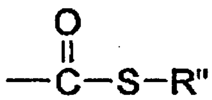
R-6

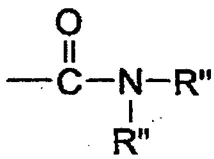
R-7

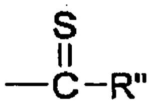
R-8

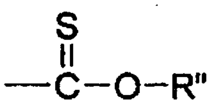
R-9

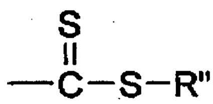
R-10

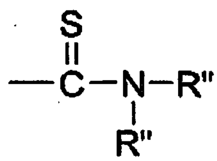
R-11

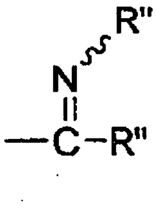 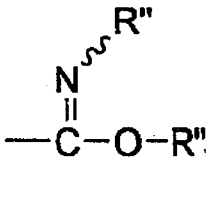 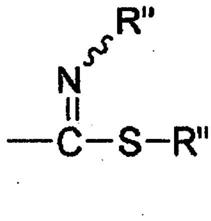 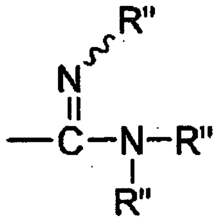

**R-12** **R-13** **R-14** **R-15**

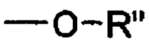 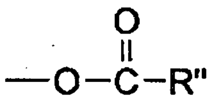 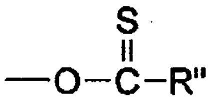 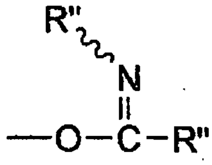

**R-16** **R-17** **R-18** **R-19**

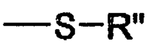 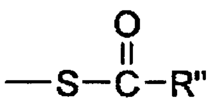 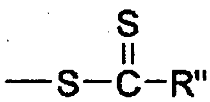 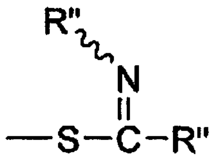

**R-20** **R-21** **R-22** **R-23**

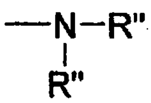 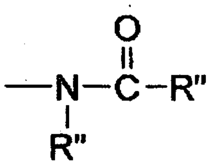 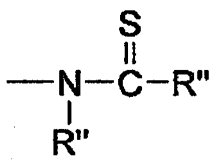 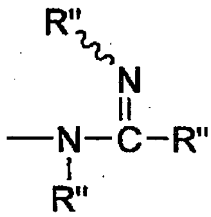

**R-24** **R-25** **R-26** **R-27**

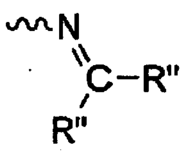 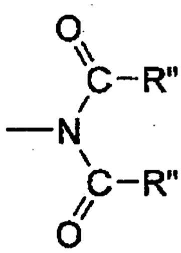

**R-28** **R-29**

$-F$ R-30 $-Cl$ R-31 $-Br$ R-32 $-I$ R-33

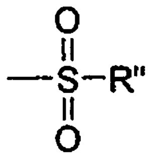
R-34
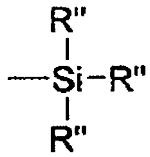
R-35
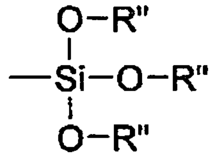
R-36

$-SO_3H$ R-37 $-PO_3H_2$ R-38 $-C{\equiv}N$ R-39 $-NO_2$ R-40

(wherein -R' represents a group selected from an alkyl group, an aryl group, an aralkyl group and a monovalent heterocyclic group, and R" represents a group selected from a hydrogen atom, an alkyl group, an aryl group, an aralkyl group, and a monovalent heterocyclic group.)

The alkyl groups represented by the formulae R-1, -R' and -R" may be any of linear, branched or cyclic. The number of carbon atoms is usually about 1 to 20, and preferably 3 to 20. Specific examples thereof include a methyl group, an ethyl group, a propyl group, an isopropyl group, an n-butyl group, an isobutyl group, an s-butyl group, a t-butyl group, a pentyl group, an isopentyl group, a hexyl group, a cyclohexyl group, a heptyl group, an octyl group, a 2-ethylhexyl group, a nonyl group, a decyl group, a 3,7-dimethyloctyl group, a dodecyl group, and an octadecyl group.

In view of solubility into an organic solvent, and easiness of synthesis or the like, a methyl group, an ethyl group, a propyl group, an isopropyl group, an n-butyl group, an isobutyl group, an s-butyl group, a t-butyl group, a pentyl group, an isopentyl group, a hexyl group, a cyclohexyl group, a heptyl group, a cyclohexylmethyl group, an octyl group, a 2-ethylhexyl group, a 2-cyclohexylethyl group, a nonyl group, a decyl group, a 3,7-dimethyloctyl group, and a dodecyl group are preferable. A methyl group, an ethyl group, a propyl group, an isopropyl group, a butyl group, an isobutyl group, an s-butyl group, a t-butyl group, a pentyl group, an isopentyl group, a hexyl group, a cyclohexyl group, a heptyl group, an octyl group, a 2-ethylhexyl group, a nonyl group, a decyl group, and a 3,7-dimethyloctyl group are more preferable. A propyl group, an isopropyl group, a butyl group, an isobutyl group, an s-butyl group, a t-butyl group, a pentyl group, an isopentyl group, a hexyl group, a cyclohexyl group, a heptyl group, an octyl group, a 2-ethylhexyl group, a nonyl group, a decyl group, and a 3,7-dimethyloctyl group are still more preferable.

The aryl groups represented by the formulae R-1, -R' and -R" are an atomic group formed by removing one hydrogen atom on an aromatic ring from an aromatic hydrocarbon. The aryl group includes those having a condensed ring. The number of carbon atoms of the aryl group is usually about 6 to 60, and preferably 7 to 48. Specific examples thereof include a phenyl group, a $C_1$-$C_{12}$ alkylphenyl group ($C_1$-$C_{12}$ represents the number of carbon atoms 1-12. Hereafter the same), a 1-naphtyl group, a 2-naphtyl group, a 1-anthrAcenyl group, a 2-anthracenyl group, and a 9-anthracenyl group.

In view of solubility into an organic solvent, and easiness of synthesis or the like, or from balance between device properties and heat resistance when using the aromatic graft polymer of the present invention for the polymer LED, the $C_1$-$C_{12}$ alkylphenyl group is preferable.

Specific examples of the $C_1$-$C_{12}$ alkylphenyl group include a methylphenyl group, an ethylphenyl group, a dimethylphenyl group, a dimethyl-t-butylphenyl group, a propylphenyl group, a mesityl group, a methylethylphenyl group, an isopropylphenyl group, an n-butylphenyl group, an isobutylphenyl group, an s-butylphenyl group, a t-butylphenyl group, a pentylphenyl group, an isopentylphenyl group, a hexylphenyl group, a heptylphenyl group, an octylphenyl group, a nonylphenyl group, a decylphenyl group, a 3,7-dimethyloctylphenyl group and a dodecylphenyl group. A dimethylphenyl group, a dimethyl-t-butylphenyl group, a propylphenyl group, a mesityl group, a methylethylphenyl group, an isopropylphenyl group, an n-butylphenyl group, an isobutylphenyl group, an s-butylphenyl group, a t-butylphenyl group, a pentylphenyl group, an isopentylphenyl group, a hexylphenyl group, a heptylphenyl group, an octylphenyl group, a nonylphenyl group, a decylphenyl group, a 3,7-dimethyloctylphenyl group, and a dodecyl phenyl group are preferable.

The number of carbon atoms of the aralkyl group of the groups represented by the formulae R-1, - R' and -R" is usually about 7 to 60, and preferably 7 to 48. Specific examples thereof include a phenyl-$C_1$-$C_{12}$ alkyl group, a $C_1$-$C_{12}$ alkylphenyl-$C_1$-$C_{12}$ alkyl group, a 1-naphtyl-$C_1$-$C_{12}$ alkyl group, and a 2-naphtyl-$C_1$-$C_{12}$ alkyl group.
In view of solubility into an organic solvent, and easiness of synthesis, or from balance between device properties and heat resistance when using the aromatic graft polymer of the present invention for the polymer LED, the $C_1$-$C_{12}$ alkylphenyl-$C_1$-$C_{12}$ alkyl group is preferable.

The monovalent heterocyclic groups represented by the formulae R-1, -R' and -R" are a remaining atomic group formed by removing one hydrogen atom from a heterocyclic compound. The number of carbon atoms thereof is usually about 4 to 60, and preferably 4 to 20. The number of carbon atoms of the substituent is not contained in the number of carbon atoms of the heterocyclic group. Herein, the heterocyclic compound means an organic compound having a cyclic structure in which a hetero atom such as oxygen, sulfur, nitrogen, phosphorus, boron, etc. is contained in the cyclic structure as the element other than carbon atom. Specifically, a thienyl group, a $C_1$-$C_{12}$ alkylthienyl group, a pyroryl group, a furyl group, a pyridyl group, a $C_1$-$C_{12}$ alkylpyridyl group, a piperidyl group, a quinolyl group, and an isoquinolyl group, etc. are exemplified.
In view of solubility into an organic solvent and easiness of synthesis, or from balance between device properties and heat resistance when using the aromatic graft polymer of the present invention for the polymer LED, the thienyl group, a $C_1$-$C_{12}$ alkylthienyl group, a pyridyl group, and a $C_1$-$C_{12}$ alkylpyridyl group are preferable.

As the alkenyl group which is represented by the formula R-2 and may be substituted, a terminal vinyl group, an alkenyl group and an arylalkenyl group are exemplified. The alkenyl group has usually about 3 to 20 carbon atoms, and specifically, a 1-propenyl group, a 2-methyl-1-propenyl group, a 1,5-cyclooctadiene-1-yl group etc. are exemplified. The arylalkenyl group has usually about 8 to 60 carbon atoms, and specifically, a phenyl-$C_2$-$C_{12}$ alkenyl group, a $C_1$-$C_{12}$ alkylphenyl-$C_2$-$C_{12}$ alkenyl group, a 1-naphtyl-$C_2$-$C_{12}$ alkenyl group, and a 2-naphtyl-$C_2$-$C_{12}$ alkenyl group etc. are exemplified.
In view of solubility into an organic solvent and easiness of synthesis, or in view of improving device properties when using the aromatic graft polymer of the present invention for the polymer LED, an arylalkenyl group is preferable. A phenyl-$C_2$-$C_{12}$ alkenyl group and a $C_1$-$C_{12}$ alkylphenyl-$C_2$-$C_{12}$ alkenyl group are preferable.

As the alkynyl group which is represented by the formula R-3 and may be substituted, a terminal acetylene group, an alkynyl group and an arylalkynyl group are exemplified. The alkynyl group has usually about 3 to 20 carbon atoms. Specifically, a 1-hexine-1-yl group, a 3-hexine-3-yl group, etc. are exemplified. The arylalkynyl group has usually about 8 to 60 carbon atoms. Specifically, a phenyl-$C_2$-$C_{12}$ alkynyl group, a $C_1$-$C_{12}$ alkylphenyl-$C_2$-$C_{12}$ alkynyl group, a 1-naphtyl-$C_2$-$C_{12}$ alkynyl group, and a 2-naphtyl-$C_2$-$C_{12}$ alkynyl group, etc. are exemplified.
In view of solubility into an organic solvent and easiness of synthesis, or in view of improving device properties when using the aromatic graft polymer of the present invention for the polymer LED, the arylalkynyl group is preferable. A phenyl-$C_2$-$C_{12}$ alkynyl group, and $C_1$-$C_{12}$ alkylphenyl-$C_2$-$C_{12}$ alkynyl group are preferable.

As the formyl groups which are represented by the formulae R-4 to R-7 and may be substituted, a formyl group, a substituted carbonyl group (formula R-4), a carboxylic group, a substituted oxycarbonyl group (formula R-5), a thiocarboxylic group, a substituted thiocarboxylic group (formula R-6), a formamide group, and a substituted aminocarbonyl group (formula R-7), etc. are exemplified.

As the substituted carbonyl group represented by the formula R-4, a formyl group substituted by an alkyl group, an aryl group, an aralkyl group or a monovalent heterocyclic group is exemplified. The substituted carbonyl group has usually about 2 to 60 carbon atoms, and preferably 2 to 48. Specifically, an acetyl group, a propylcarbonyl group, an n-butylcarbonyl group, an isobutylcarbonyl group, a t-butylcarbonyl group, a benzoyl group, a benzylcarbonyl group, a 2-thiophenecarbonyl group, and a 3-thiophenecarbonyl group, etc. are exemplified.
In view of solubility into an organic solvent, and easiness of synthesis or the like, an acetyl group, a benzoyl group, a benzylcarbonyl group, a 2-thiophenecarbonyl group and a 3-thiophenecarbonyl group are preferable.

As the substituted oxycarbonyl group represented by the formula R-5, a carboxylic group substituted by an alkyl group, an aryl group, an aralkyl group or a monovalent heterocyclic group is exemplified. The substituted oxycarbonyl group has usually about 2 to 60 carbon atoms, and preferably 2 to 48. Specifically, a methoxycarbonyl group, an ethoxycarbonyl group, a propoxycarbonyl group, an isopropoxycarbonyl group, an n-butoxycarbonyl group, an isobutoxycarbonyl group, a t-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a phenoxycarbonyl group, a naphthoxycarbonyl group, and a pyridyloxycarbonyl group, etc. are exemplified.
In view of solubility into an organic solvent, and easiness of synthesis or the like, a methoxycarbonyl group, an ethoxycarbonyl group, an octyloxycarbonyl group, a phenoxycarbonyl group, a naphthoxycarbonyl group, and a pyridyloxycarbonyl group are preferable.

As the substituted thiocarboxylic group represented by the formula R-6, a thiocarboxylic group substituted by an alkyl group, an aryl group, an aralkyl group or a monovalent heterocyclic group is exemplified. The substituted thiocarboxylic group has usually about 2 to 60 carbon atoms and preferably 2 to 48. Specifically, a methylthiocarboxylic group, an ethylthiocarboxylic group, a propylthiocarboxylic group, an isopropylthiocarboxylic group, an n-butylthiocarboxylic group, an isobutylthiocarboxylic group, a t-butylthiocarboxylic group, a pentylthiocarboxylic group, a hexylthiocarboxylic group, a cyclohexylthiocarboxylic group, a heptylthiocarboxylic group, an octylthiocarboxylic group, a 2-ethylhexylthiocarboxylic group, a nonylthiocarboxylic group, a decylthiocarboxylic group, a 3,7-dimethyloctylthiocarboxylic group, a dodecylthiocarboxylic group, a phenylthiocarboxylic group, a naphtylthiocarboxylic group, and a pyridylthiocarboxylic group, etc. are exemplified.
In view of solubility into an organic solvent, and easiness of synthesis or the like, a methylthiocarboxylic group, an ethylthiocarboxylic group, and a phenylthiocarboxylic group are preferable.

As the substituted aminocarbonyl group represented by the formula R-7, an aminocarbonyl group substituted by one or two groups which are selected from an alkyl group, an aryl group, an arylalkyl group or a monovalent heterocyclic group is exemplified. The substituted aminocarbonyl group has usually about 1 to 60 carbon atoms thereof, and preferably 2 to 48.
Specifically, a methylaminocarbonyl group, a dimethylaminocarbonyl group, an ethylaminocarbonyl group, a diethylaminocarbonyl group, a propylaminocarbonyl group, a dipropylaminocarbonyl group, an isopropylaminocarbonyl group, a diisopropylaminocarbonyl group, an n-butylaminocarbonyl group, an isobutylaminocarbonyl group, a t-butylaminocarbonyl group, a pentylaminocarbonyl group, a hexylaminocarbonyl group, a cyclohexylaminocarbonyl group, a heptylaminocarbonyl group, an octylaminocarbonyl group, a 2-ethylhexylaminocarbonyl group, a nonylaminiocarbonyl group, a decylaminiocarbonyl group, a 3,7-dimethyloctylaminocarbonyl group, a dodecylaminiocarbonyl group, a cyclopentylaminocarbonyl group, a dicyclopentylaminocarbonyl group, a cyclohexylaminocarbonyl group, a dicyclohexylaminocarbonyl group, a pyrrolidylcarbonyl group, a piperidylcarbonyl group, a phenylaminocarbonyl group, a diphenylaminocarbonyl group, a ($C_1$-$C_{12}$ alkylphenyl)aminocarbonyl group, a di ($C_1$-$C_{12}$ alkylphenyl)aminocarbonyl group, a 1-naphthylaminocarbonyl group, a 2-naphthylaminocarbonyl group, a pyridylaminocarbonyl group, a pyridazinylamino group, a pyrimidylaminocarbonyl group, a pyrazylaminocarbonyl group, a triazylaminocarbonyl group, a phenyl-$C_1$-$C_{12}$ alkylaminocarbonyl group, a $C_1$-$C_{12}$ alkylphenyl-$C_1$-$C_{12}$ alkylaminocarbonyl group, a di($C_1$-$C_{12}$ alkylphenyl-$C_1$-$C_{12}$ alkyl)aminocarbonyl group, a 1-naphtyl-$C_1$-$C_{12}$ alkylaminocarbonyl group, and a 2-naphtyl-$C_1$-$C_{12}$ alkylaminocarbonyl group, etc. are exemplified.
In view of solubility into an organic solvent, and easiness of synthesis or the like, a methylaminocarbonyl group, a dimethylaminocarbonyl group, an ethylaminocarbonyl group, a diethylaminocarbonyl group, a t-butylaminocarbonyl group, a piperidylcarbonyl group, a phenylaminocarbonyl group, a diphenylaminocarbonyl group, a ($C_1$-$C_{12}$ alkylphenyl) aminocarbonyl group, and a di($C_1$-$C_{12}$ alkylphenyl)aminocarbonyl group are preferable. A dimethylaminocarbonyl group, a diethylaminocarbonyl group, a diphenylaminocarbonyl group, and a di($C_1$-$C_{12}$ alkylphenyl)aminocarbonyl group are more preferable.

In view of easiness of synthesis, as the formyl group which may be substituted, a formyl group, a substituted carbonyl group, a carboxylic group, a substituted oxycarbonyl group, a formamide group and a substituted aminocarbonyl group are preferable. In view of solubility into an organic solvent, a substituted carbonyl group, a substituted oxycarbonyl group and a substituted aminocarbonyl group are preferable.

As the thioformyl groups which are represented by the formulae R-8 to R-11 and may be substituted, a thioformyl group, a substituted thiocarbonyl group (formula R-8), a substituted oxythiocarbonyl group (formula R-9), a dithiocarboxylic group, a substituted dithiocarboxylic group (formula R-10), an aminothiocarbonyl group, and a substituted aminothiocarbonyl group (formula R-11) are exemplified.

As the substituted thiocarbonyl which is represented by the formula R-8, a thioformyl group substituted by an alkyl group, an aryl group, an aralkyl group or a monovalent heterocyclic group is exemplified. The thiocarbonyl has usually about 2 to 60 carbon atoms, and preferably 2 to 48. Specifically, a methylthiocarbonyl group, an ethylthiocarbonyl group, and a phenylthiocarbonyl group, etc. are exemplified.

As the substituted oxythiocarbonyl group represented by the formula R-9, a hydroxythiocarbonyl group substituted by an alkyl group, an aryl group, an aralkyl group or a monovalent heterocyclic group is exemplified. The substituted oxythiocarbonyl group has usually about 2 to 60 carbon atoms, and preferably 2 to 48. Specifically, a methoxythiocarbonyl group, an ethoxythiocarbonyl group, and a phenoxythiocarbonyl group, etc. are exemplified.

As the substituted dithiocarboxylic group represented by the formula R-10, a dithiocarboxylic group substituted by an alkyl group, an aryl group, an aralkyl group or a monovalent heterocyclic group is exemplified. The substituted

dithiocarboxylic group has usually about 2 to 60 carbon atoms, and preferably 2 to 48. Specifically, a methyldithiocarboxylic group, an ethyldithiocarboxylic group, and a phenyldithiocarboxylic group, etc. are exemplified.

As the substituted aminothiocarbonyl group represented by the formula R-11, an aminocarbonyl group substituted by one or two groups selected from an alkyl group, an aryl group, an arylalkyl group or a monovalent heterocyclic group is exemplified. The substituted aminothiocarbonyl group has usually about 2 to 60 carbon atoms, and preferably 2 to 48. Specifically, a dimethylaminothiocarbonyl group, a diethylaminothiocarbonyl group, a phenylaminothiocarbonyl group, and a diphenylaminothiocarbonyl group, etc. are exemplified.

In view of easiness of synthesis, as the thioformyl group which may be substituted, a thioformyl group, a substituted thiocarbonyl group, a substituted oxythiocarbonyl group, an aminothiocarbonyl group and a substituted aminothiocarbonyl group are preferable. In view of solubility into an organic solvent, a substituted thiocarbonyl group, a substituted oxythiocarbonyl group and a substituted aminothiocarbonyl group are preferable.

As the imine residues which are represented by the formulae R-12 to R-15 and R-28 and may be substituted, a residue formed by removing one hydrogen atom from an imine compound (The imine compound means an organic compound having -N=C- in the molecule. Examples thereof include aldimine, ketimine, and compounds whose a hydrogen atom on N is substituted by an alkyl group etc.) is exemplified. The imine residue has usually about 2 to 20 carbon atoms, and preferably 2 to 18. Specifically, groups or the like represented by the following structural formulas are exemplified.

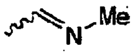 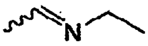 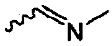 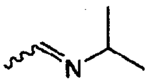 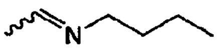 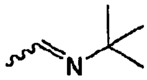

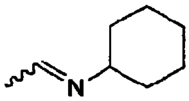 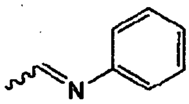 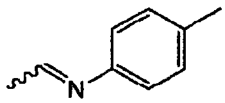

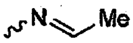 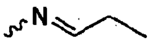 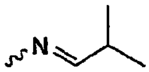 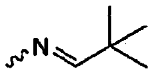 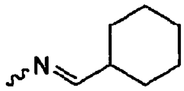 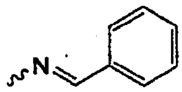

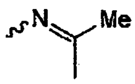 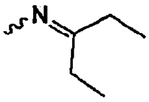 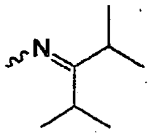 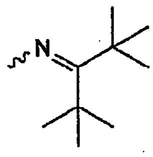 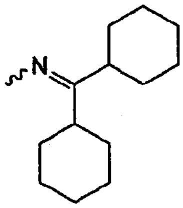 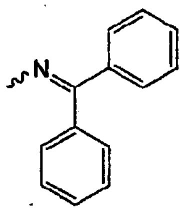

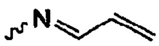 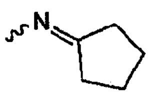 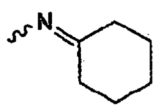

As the hydroxy groups which are represented by the formulae R-16 to R-19 and may be substituted, a hydroxy group, an alkoxy group, an aryloxy group, an aralkyloxy group (formula R-16), and a substituted carbonyloxy group (formula R-17), etc. are exemplified.

The alkoxy group represented by the formula R-16 may be any of linear, branched or cyclic. The number of carbon atoms is usually about 1 to 20, and preferably 3 to 20. Specific examples thereof include a methoxy group, an ethoxy group, a propyloxy group, an isopropyloxy group, an n-butoxy group, an isobutoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, and a dodecyloxy group.

In view of solubility into an organic solvent and easiness of synthesis, or from balance between device properties and heat resistance when using the aromatic graft polymer of the present invention for the polymer LED, a pentyloxy group, a hexyloxy group, an octyloxy group, a 2-ethylhexyloxy group, a decyloxy group, and a 3,7-dimethyloctyloxy group are preferable.

The aryloxy group represented by the formula R-16 has usually about 6 to 60 carbon atoms, and preferably 7 to 48. Specific examples thereof include a phenoxy group, a $C_1$-$C_{12}$ alkylphenoxy group, a 1-naphthyloxy group, and a 2-naphthyl group.

In view of solubility into an organic solvent and easiness of synthesis, or from balance between device properties and heat resistance when using the aromatic graft polymer of the present invention for the polymer LED, a $C_1$-$C_{12}$ alkylphenoxy group is preferable.

Specific examples of $C_1$-$C_{12}$ alkylphenoxy group include a methylphenoxy group, an ethylphenoxy group, a dimethylphenoxy group, a propylphenoxy group, a 1,3,5-trimethylphenoxy group, a methylethylphenoxy group, an isopropylphenoxy group, an n-butyl phenoxy group, an isobutylphenoxy group, a t-butylphenoxy group, a pentylphenoxy group, an isopentylphenoxy group, a hexylphenoxy group, a heptylphenoxy group, an octylphenoxy group, a nonylphenoxy group, a decylphenoxy group, and a dodecylphenoxy group.

The aralkyloxy group represented by the formula R-16 has usually about 7 to 60 carbon atoms, and preferably 7 to 48. Specific examples thereof include a phenyl-$C_1$-$C_{12}$ alkoxy group such as a phenylmethoxy group, a phenylethoxy group, a phenyl-n-butoxy group, a phenylpentyloxy group, a phenylhexyloxy group, a phenylheptyloxy group, and a phenyloctyloxy group; a $C_1$-$C_{12}$ alkylphenyl-$C_1$-$C_{12}$ alkoxy group, a 1-naphtyl-$C_1$-$C_{12}$ alkoxy group, and a 2-naphtyl-$C_1$-$C_{12}$ alkoxy group.

In view of solubility into an organic solvent and easiness of synthesis or the like, or from balance between device properties and heat resistance when using the aromatic graft polymer of the present invention for the polymer LED, a $C_1$-$C_{12}$ alkylphenyl-$C_1$-$C_{12}$ alkoxy group is preferable.

As the substituted carbonyloxy group represented by the formula R-17, a carbonyloxy group substituted by an alkyl group, an aryl group, an aralkyl group or a monovalent heterocyclic group is exemplified. The substituted carbonyloxy group has usually about 2 to 60 carbon atoms, and preferably 2 to 48. Specific examples thereof include an acetyloxy group, a propylcarbonyloxy group, an n-butylcarbonyloxy group, an isobutylcarbonyloxy group, a t-butylcarbonyloxy group, a benzoyloxy group, a benzilcarbonyloxy group, a 2-thiophenecarbonyloxy group, and a 3-thiophenecarbonyloxy group.

In view of easiness of synthesis, as the hydroxy group which may be substituted, a hydroxy group, an alkoxy group, an aryloxy group, and an aralkyloxy group are preferable. In view of solubility into an organic solvent, or from balance between device properties and heat resistance when using the aromatic graft polymer of the present invention for the polymer LED, an alkoxy group, an aryloxy group and an aralkyloxy group are preferable.

As the mercapto group which are represented by the formulae R-20 to R-23 and may be substituted, a mercapto group, an alkylthio group, an arylthio group, an aralkylthio group (formula R-20), and a substituted carbonylthio group (formula R-21), etc. are exemplified.

The alkylthio group represented by the formula R-20 may be any of linear, branched or cyclic. The number of carbon atoms is usually about 1 to 20, and preferably 3 to 20. Specific examples thereof include a methylthio group, an ethylthio group, a propylthio group, an isopropylthio group, an n-butylthio group, an isobutylthio group, a t-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, and a dodecylthio group.

In view of solubility into an organic solvent, and easiness of synthesis, or from balance between device properties and heat resistance when using the aromatic graft polymer of the present invention for the polymer LED, a pentylthio group, a hexylthio group, an octylthio group, a 2-ethylhexylthio group, a decylthio group, and a 3,7-dimethyloctylthio group are preferable.

The arylthio group represented by the formula R-20 has usually about 3 to 60 carbon atoms, and specific examples thereof include a phenylthio group, a $C_1$-$C_{12}$ alkylphenylthio group, a 1-naphthylthio group, and a 2-naphthylthio group.

In view of solubility into an organic solvent and easiness of synthesis, or from balance between device properties and heat resistance when using the aromatic graft polymer of the present invention for the polymer LED, a $C_1$-$C_{12}$ alkylphenylthio group is preferable.

The arylalkylthio group represented by the formula R-20 has usually about 7 to 60 carbon atoms, and preferably 7 to 48. Specific examples thereof include a phenyl-$C_1$-$C_{12}$ alkylthio group, a $C_1$-$C_{12}$ alkylphenyl-$C_1$-$C_{12}$ alkylthio group, a 1-naphtyl-$C_1$-$C_{12}$ alkylthio group, and a 2-naphtyl-$C_1$-$C_{12}$ alkylthio group.

In view of solubility into an organic solvent and easiness of synthesis, or from balance between device properties and heat resistance when using the aromatic graft polymer of the present invention for the polymer LED, a $C_1$-$C_{12}$ alkylphenyl-$C_1$-$C_{12}$ alkylthio group is preferable.

As the substituted carbonylthio group represented by the formula R-21, a carbonylthio group substituted by

an alkyl group, an aryl group, an aralkyl group or a monovalent heterocyclic group is exemplified. The number of carbon atoms thereof is usually about 2 to 60, and preferably 2 to 48.
Specific examples thereof include an acetylthio group, a propylcarbonylthio group, an n-butylcarbonylthio group, an isobutylcarbonylthio group, a t-butylthio group, a benzoylthio group, and a benzilcarbonylthio group.

In view of easiness of synthesis, as the mercapto group which may be substituted, a mercapto group, an alkylthio group, an arylthio group, and an aralkylthio group are preferable. In view of solubility into an organic solvent, or from balance between device properties and heat resistance when using the aromatic graft polymer of the present invention for the polymer LED, an alkylthio group, an arylthio group and an aralkylthio group are preferable.

As the amino groups which are represented by the formulae R-24 to R-27 and R-29 and may be substituted, an amino group, a substituted amino group (formula R-24), an amide group (formula R-25), and an acid imide group (formula R-29), etc. are exemplified.

The substituted amino group represented by the formula R-24 includes an amino group substituted by 1 or 2 groups selected from an alkyl group, an aryl group, an-arylalkyl group or a monovalent heterocyclic group. The number of carbon atoms thereof is usually about 1 to 60, and preferably 2 to 48.
Specific examples thereof include a methylamino group, a dimethylamino group, an ethylamino group, a diethylamino group, a propylamino group, a dipropylamino group, an isopropylamino group, a diisopropylamino group, an n-butylamino group, an isobutylamino group, a t-butylamino group, a pentylamino group, a hexylamino group, a cyclohexylamino group, a heptylamino group, an octyl amino group, a 2-ethylhexylamino group, a nonylamino group, a decylamino group, a 3,7-dimethyloctylamino group, a dodecylamino group, a cyclopentylamino group, a dicyclopentylamino group, a cyclohexylamino group, a dicyclohexylamino group, a pyrrolidyl group, a piperidyl group, adiphenylamino group, a ($C_1$-$C_{12}$ alkylphenyl)amino group, a di ($C_1$-$C_{12}$ alkylphenyl)amino group, a 1-naphtyl amino group, a 2-naphtyl amino group, a pyridylamino group, a pyridazinylamino group, a pyrimidylamino group, a pyrazylamino group, a triazylamino group, a phenyl-$C_1$-$C_{12}$ alkylamino group, a $C_1$-$C_{12}$ alkylphenyl-$C_1$-$C_{12}$ alkylamino group, a di ($C_1$-$C_{12}$ alkylphenyl-$C_1$-$C_{12}$ alkyl) amino group, a 1-naphtyl-$C_1$-$C_{12}$ alkylamino group, and a 2-naphtyl-$C_1$-$C_{12}$ alkylamino group.
In view of solubility into an organic solvent, and easiness of synthesis or the like, a methylamino group, a dimethylamino group, an ethylamino group, a diethylamino group, a t-butylamino group, a piperidyl group, a phenylamino group, a diphenylamino group, a $C_1$-$C_{12}$ alkylphenylamino group and a di($C_1$-$C_{12}$ alkylphenyl)amino group are preferable.
In view of solubility into an organic solvent, easiness of synthesis, or balance between device properties and heat resistance when using the aromatic graft polymer of the present invention for the polymer LED, a diphenylamino group and a di($C_1$-$C_{12}$ alkylphenyl)amino group are preferable.

As the amide group represented by the formula R-25, an amide group substituted by one or two groups selected from an alkyl group, an aryl group, an arylalkyl group or a monovalent heterocyclic group is exemplified, and the number of carbon atoms thereof is usually about 1 to 60, and preferably 2 to 48.
Specific examples thereof include a formamide group, an acetamide group, a propioamide group, a butyroamide group, a benzamide group, a trifluoroacetamide group, a pentafluoro benzamide group, an N-methylformamide group, an N-phenylacetamide group, and an N-phenylbenzamide group.
In view of solubility into an organic solvent, and easiness of synthesis or the like, a formamide group, an acetamide group, an N-methylformamide group, an N-phenylacetamide group, and an N-phenylbenzamide group are preferable.

Examples of the acid imide group represented by the formula R-29 include a residue obtained by removing a hydrogen atom bonded to nitrogen atom from acid imide such as succinimide, phthalimide and pyromellitimide, and the number of carbon atoms thereof is about 4 to 20. Preferably, the following groups are exemplified.

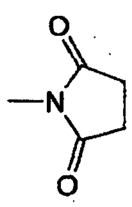 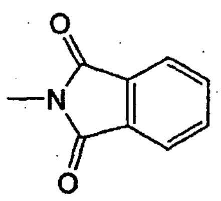 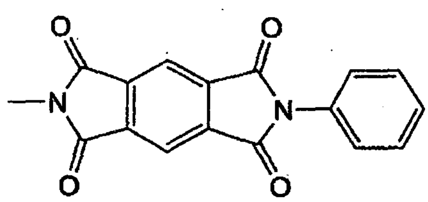

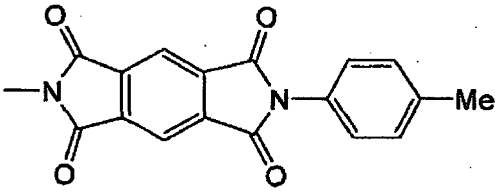
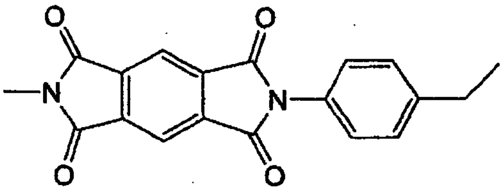

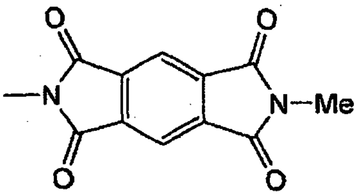
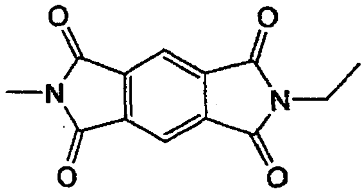
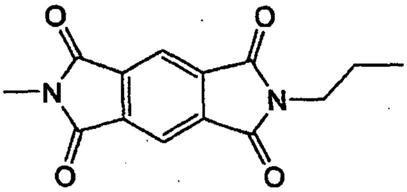

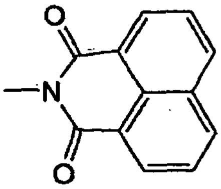
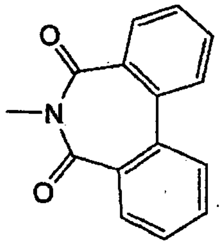

In view of easiness of synthesis, as the amino group which may be substituted, an amino group, a substituted amino group, an amide group, and an acid imide group are preferable. In view of solubility into an organic solvent, or from balance between device properties and heat resistance when using the aromatic graft polymer of the present invention for the polymer LED, a substituted amino group and an acid imide group are preferable.

As the halogen atom, a fluorine atom, a chlorine atom, a bromine atom, and an iodine atom are exemplified. In view of the stability of the aromatic graft polymer of the present invention, a fluorine atom is preferable.

As the substituted sulfonyl group represented by the formula R-34, a sulfonyl group substituted by an alkyl group, an aryl group, an aralkyl group or a monovalent heterocyclic group is exemplified. The number of carbon atoms thereof is usually about 2 to 60, and preferably 2 to 48. Specific examples include a $C_1$-$C_{12}$ alkylsulfonyl group, a benzenesulfonyl group, a $C_1$-$C_{12}$ alkoxyphenylsulfonyl group, a $C_1$-$C_{12}$ alkylphenylsulfonyl group, a 1-naphtylsulfonyl group, a 2-naphtylsulfonyl group, a phenyl-$C_1$-$C_{12}$ alkylsulfonyl group, a $C_1$-$C_{12}$ alkylphenyl-$C_1$-$C_{12}$ alkylsulfonyl group, a 1-naphtyl-$C_1$-$C_{12}$ alkylsulfonyl group, and a 2-naphtyl-$C_1$-$C_{12}$ alkylsulfonyl group.
In view of heat resistance and solubility into an organic solvent, a benzenesulfonyl group, a $C_1$-$C_{12}$ alkylphenylsulfonyl group, a 1-naphtylsulfonyl group, a 2-naphtylsulfonyl group, and a phenyl-$C_1$-$C_{12}$ alkylsulfonyl group are preferable. In view of heat resistance, a benzenesulfonyl group, a 1-naphtylsulfonyl group, and a 2-naphtylsulfonyl group are more preferable.

As the silyl group which is represented by the formula R-35 and may be substituted, a silyl group substituted by one, two or three groups selected from an alkyl group, an aryl group, an arylalkyl group or a monovalent heterocyclic group is exemplified. The number of carbon atoms of the substituted silyl group is usually about 1 to 60, and preferably 3 to 48.
Specific examples of the silyl group include a trimethylsilyl group, a triethylsilyl group, a tripropylsilyl group, a triisopropylsilyl group, a dimethylisopropylsilyl group, a diethylisopropylsilyl group, a t-butylsilyldimethylsilyl group, a pentyldimethylsilyl group, a hexyldimethylsilyl group, a heptyldimethylsilyl group, an octyldimethylsilyl group, a 2-ethylhexyldimethylsilyl group, a nonyldimethylsilyl group, a decyl dimethylsilyl group, a 3,7-dimethyloctyl-dimethylsilyl group, a dodecyldimethylsilyl group, a phenyl-$C_1$-$C_{12}$ alkylsilyl group, a $C_1$-$C_{12}$ alkylphenyl-$C_1$-$C_{12}$ alkylsilyl group, a 1-naphtyl-$C_1$-$C_{12}$ alkylsilyl group, a 2-naphtyl-$C_1$-$C_{12}$ alkylsilyl group, a phenyl-$C_1$-$C_{12}$ alkyl dimethylsilyl group, a triphenylsilyl group, a tri-p-methylphenylsilyl group, a tribenzylsilyl group, a diphenylmethylsilyl group, a t-butyldiphenylsilyl group, and a dimethylphenylsilyl group.

As the silanol group which is represented by the formula R-36 and may be substituted, a silanol group substituted

by one, two or three groups selected from an alkyl group, an aryl group, an arylalkyl group or a monovalent heterocyclic group is exemplified. The number of carbon atoms of the substituted silanol group is usually about 1 to 60, and preferably 3 to 48. Specifically, a trimethoxysilyl group, a triethoxysilyl group, and a triphenoxysilyl group, etc. are exemplified.

In view of improving solubility into an organic solvent, as the substituent represented by R or Ra in the aromatic graft polymer of the present invention, an alkyl group, an aryl group, an aralkyl group, a monovalent heterocyclic group, an alkenyl group which may be substituted, an alkynyl group which may be substituted, a substituted carbonyl group, a substituted oxycarbonyl group, a substituted oxythiocarbonyl group, a substituted aminocarbonyl group, a substituted aminothiocarbonyl group, an imine residue which may be substituted, an alkoxy group, an aryloxy group, an aralkyloxy group, a substituted carbonyloxy group, an alkylthio group, an arylthio group, an aralkylthio group, a substituted carbonylthio group, a substituted amino group, an amide group, an acid imide group, a substituted sulfonyl group, and a silyl group which may be substituted are preferable. An alkyl group, an aryl group, an aralkyl group, a monovalent heterocyclic group, an alkoxy group, an aryloxy group, an aralkyloxy group, an alkylthio group, an arylthio group, and an aralkylthio group are more preferable. An alkyl group, an alkoxy group, and an alkylthio group are still more preferable.

In view of improving heat resistance and chemical stability, an alkyl group, an aryl group, an aralkyl group, a monovalent heterocyclic group, a substituted carbonyl group, a substituted aminocarbonyl group, an alkoxy group, an aryloxy group, an aralkyloxy group, an alkylthio group, an arylthio group, an aralkylthio group, a substituted amino group, an amide group, an acid imide group, a halogen atom and a substituted sulfonyl group are preferable. An alkyl group, an aryl group, an aralkyl group, a substituted aminocarbonyl group, an alkoxy group, an aryloxy group, an aralkyloxy group, an alkylthio group, an arylthio group, an aralkylthio group, a substituted amino group, an amide group, an acid imide group, and a fluorine atom are more preferable. An alkyl group, an aryl group, and an aralkyl group are still more preferable.

From balance between the view of solubility into an organic solvent, device properties and easiness of synthesis or the like, and heat resistance when using the aromatic graft polymer of the present invention for the polymer LED, an alkyl group, an aryl group, an aralkyl group, a monovalent heterocyclic group, an alkenyl group which may be substituted, an alkynyl group which may be substituted, an imine residue which may be substituted, an alkoxy group, an aryloxy group, an aralkyloxy group, an alkylthio group, an arylthio group, an aralkylthio group, a substituted amino group, an acid imide group, a halogen atom, a silyl group which may be substituted, and a cyano group are preferable. An alkyl group, an aryl group, an aralkyl group, a monovalent heterocyclic group, an imine residue which may be substituted, an alkoxy group, an aryloxy group, an aralkyloxy group, an alkylthio group, an arylthio group, an aralkylthio group, an acid imide group, a fluorine atom, and a cyano group are more preferable. An alkyl group, an aryl group, a monovalent heterocyclic group, an imine residue which may be substituted, an alkoxy group, an aryloxy group, an alkylthio group, an arylthio group, an acid imide group, a fluorine atom, and a cyano group are still more preferable.

From balance of view improving easiness of synthesis, solubility into an organic solvent, heat resistance and ion exchange capacity when using the aromatic graft polymer of the present invention for a polymer electrolyte such as a proton conducting film for a fuel cell, an alkyl group, an aryl group, a substituted carbonyl group, a carboxylic group, a substituted aminocarbonyl group, a hydroxy group, an alkoxy group, an aryloxy group, an amide group, an acid imide group, a halogen atom, a substituted sulfonyl group, a sulfonic group, and a phosphono group are preferable. An alkyl group, a substituted carbonyl group, a fluorine atom, a substituted sulfonyl group, a sulfonic group, and a phosphono group are more preferable.

The hydrogen atom on the substituent represented by R' and R" may be substituted by halogen atom such as F, Cl, Br and I. A fluorine atom is preferable among halogen atoms. Specific examples thereof include an alkyl group substituted by a fluorine atom such as a trifluoromethyl group, a pentafluoroethyl group, a perfluorobutyl group, a perfluorohexyl group and a perfluorooctyl group; an aryl group substituted by a fluorine atom such as a pentafluorophenyl group; a substituted carbonyl group substituted by a fluorine atom such as a trifluoroacetyl group and a pentafluorobenzoyl group; a substituted oxycarbonyl group substituted by a fluorine atom such as a trifluoromethoxycarbonyl group, a pentafluoroethoxycarbonyl group, a perfluorobutoxycarbonyl group, a perfluorohexyloxycarbonyl group, a perfluorooctyloxycarbonyl group; a substituted thiocarboxylic group substituted by a fluorine atom such as a trifluoromethylthiocarboxylic group, a pentafluoroethylthiocarboxylic group, a perfluorobutylthiocarboxylic group, a perfluorohexylthiocarboxylic group, and a perfluorooctylthiocarboxylic group; a substituted aminocarbonyl group substituted by a fluorine atom such as a ditrifluoromethylaminocarbonyl group and a pentafluorophenylaminocarbonyl group; a substituted alkoxy group substituted by a fluorine atom such as a trifluoromethoxy group, a pentafluoroethoxy group, a perfluorobutoxy group, a perfluorohexyl group and a perfluorooctyl group; a substituted carbonyloxy group substituted by a fluorine atom such as a trifluoroacetyloxy group and a pentafluorobenzoyloxy group; a substituted mercapto group substituted by a fluorine atom such as a trifluoromethylthio group; a substituted carbonylthio group substituted by a fluorine atom such as a trifluoroacetylthio group and a pentafluorobenzoylthio group; a substituted amino group substituted by a fluorine atom such as a ditrifluoromethylamino group; and a substituted sulfonyl group substituted by a fluorine atom such as a pentafluorophenylsulfonyl group.

When the substituents each represented by R' and R" contain an aryl group or monovalent heterocyclic group,

a hydrogen atom on the aryl group or monovalent heterocyclic group may be substituted by an alkenyl group which may be substituted by an alkyl group, an alkynyl group which may be substituted by an alkyl group, a formyl group which may be substituted by an alkyl group, a thioformyl group which may be substituted by an alkyl group, an imine residue which may be substituted by an alkyl group, a hydroxy group which may be substituted by an alkyl group, a mercapto group which may be substituted by an alkyl group, an amino group which may be substituted by an alkyl group, a sulfonyl group substituted by a halogen atom and an alkyl group, a silyl group which may be substituted by an alkyl group, a silanol group which may be substituted by an alkyl group, a sulfonic group, a phosphono group, a cyano group, or a nitro group. Of these, an alkenyl group which may be substituted by an alkyl group, an alkynyl group which may be substituted by an alkyl group, a formyl group which may be substituted by an alkyl group, an imine residue which may be substituted by an alkyl group, a hydroxy group which may be substituted by an alkyl group, a mercapto group which may be a substituted by an alkyl group, an amino group which may be substituted by an alkyl group, a halogen atom, a sulfonic group, a phosphono group, a cyano group and a nitro group are preferable. A formyl group which may be substituted by an alkyl group, an imine residue which may be substituted by an alkyl group, a hydroxy group which may be substituted by an alkyl group, a mercapto group which may be substituted by an alkyl group, an amino group which may be substituted by an alkyl group, a halogen atom, a sulfonic group, a phosphono group, a cyano group and a nitro group are more preferable. An alkoxy group and an alkylthio group are still more preferable. Specific examples thereof include groups having a $C_1$-$C_{12}$ alkoxy substituent such as a $C_1$-$C_{12}$ alkoxyphenyl group, a $C_1$-$C_{12}$ alkoxyphenyl-$C_1$-$C_{12}$ alkyl group, a $C_1$-$C_{12}$ alkoxyphenyl-$C_2$-$C_{12}$ alkenyl group, a $C_1$-$C_{12}$ alkoxyphenyl-$C_2$-$C_{12}$ alkynyl group, a $C_1$-$C_{12}$ alkoxyphenylaminocarbonyl group, a di($C_1$-$C_{12}$ alkoxyphenyl)aminocarbonyl group, a $C_1$-$C_{12}$ alkoxyphenyl-$C_1$-$C_{12}$ alkylaminocarbonyl group, a di($C_1$-$C_{12}$ alkoxyphenyl-$C_1$-$C_{12}$ alkyl)aminocarbonyl group, a $C_1$-$C_{12}$ alkoxyphenoxy group, a $C_1$-$C_{12}$ alkoxyphenyl-$C_1$-$C_{12}$ alkoxy group, a $C_1$-$C_{12}$ alkoxyphenylthio group, a $C_1$-$C_{12}$ alkoxyphenyl-$C_1$-$C_{12}$ alkylthio group, a $C_1$-$C_{12}$ alkoxyphenylamino group, a di($C_1$-$C_{12}$ alkoxyphenyl)amino group, a $C_1$-$C_{12}$ alkoxyphenyl-$C_1$-$C_{12}$ alkylamino group, a di($C_1$-$C_{12}$ alkoxyphenyl-$C_1$-$C_{12}$ alkyl)amino group and a $C_1$-$C_{12}$ alkoxyphenyl-$C_1$-$C_{12}$ alkylsilyl group. Specific examples of the $C_1$-$C_{12}$ alkoxy include methoxy, ethoxy, propyloxy, isopropyloxy, n-butoxy, isobutoxy, s-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy and dodecyloxy.

When the substituents represented by R' and R" contain an alkylene chain, any $-CH_2-$ group in the alkylene chain may be substituted by the divalent group which contains a divalent hetero atom such as oxygen, sulfur and nitrogen, a divalent group containing a hetero atom, or a divalent group of combined two or more groups. As the divalent hetero atom and the divalent group containing a hetero atom, groups represented by the following formulas X-1 to X-6 are exemplified.

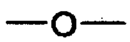
X-1

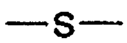
X-2

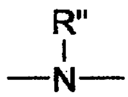
X-3

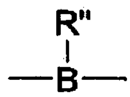
X-4

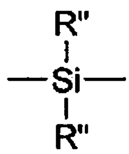
X-5

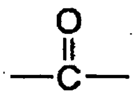
X-6

Herein, R" represents the same meaning as the above.

As the divalent group in which two or more divalent hetero atoms or divalent groups containing a hetero atom are combined, groups represented, for example, by the following formulas X-7 to X-10 are exemplified.

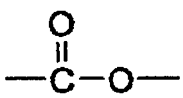
X-7

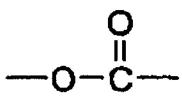
X-8

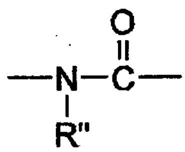
X-9

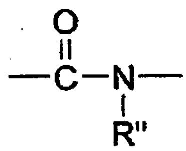
X-10

In the formulae X-1 to X-10, groups represented by the formulae X-1, X-2, X-3, X-5 and X-6 are preferable, and the groups represented by the formulae X-1 and X-2 are more preferable. The group represented by the formula X-1 is still more preferable. Specifically, a methoxymethyloxy group and a 2-methoxyethyloxy group, etc. are exemplified.

In the formula (2), k represents an integer of 3 or more.

In the formula (2), $E^1$ represents a hydrogen atom, a halogen atom or a substituent. As the halogen atom represented by $E^1$, a fluorine atom, a chlorine atom, a bromine atom and an iodine atom are exemplified. As the halogen atom represented by $E^1$, a fluorine atom is preferable in view of chemical stability.

As the substituent represented by $E^1$, an alkyl group (preferably, $C_1$-$C_{12}$ alkyl group), an alkoxy group (preferably, a $C_1$-$C_{12}$ alkoxy group), and an alkylthio group (preferably, a $C_1$-$C_{12}$ alkylthio group) are exemplified. The definition and example thereof are the same as those of an alkyl group, an alkoxy group and an alkylthio group in the substituent of $Ar^1$.

As the group represented by $E^1$, a hydrogen atom, a fluorine atom, an alkyl group (preferably, a $C_1$-$C_{12}$ alkyl group), and an alkoxy group (preferably, a $C_1$-$C_{12}$ alkoxy group) are preferable. A hydrogen atom and an alkyl group (preferably, a $C_1$-$C_{12}$ alkyl group) are more preferable, and an alkyl group (preferably, a $C_1$-$C_{12}$ alkyl group) is still more preferable.

In the formula (2), $Ar^2$ represents a group having a divalent residue of a $\pi$-conjugated cyclic compound. As the group represented by $Ar^2$ and having the divalent residue of the $\pi$-conjugated cyclic compound, a divalent residue of a $\pi$-conjugated cyclic compound and a divalent residue of a metal complex compound having an organic ligand having a $\pi$-conjugated cyclic compound structure are exemplified.

As the divalent residue of the $\pi$-conjugated cyclic compound represented by $Ar^2$, one in which the side chain represented by the formula (2) is substituted by a hydrogen atom or a substituent is defined and exemplified in the definition and example of the divalent residue of the $\pi$-conjugated cyclic compound represented by $Ar^1$.

In view of easiness of synthesis, as the arylene group represented by $Ar^2$, a phenylene group (formula 1A-1), a naphthalene-diyl group (formula 1A-2) and a fluorene-diyl group (formula 1A-13) are preferable among the formulae 1A-1 to 1A-14. Of these, a phenylene group (formula 1A-1) and a naphthalene-diyl group (formula 1A-2) are preferable.

In view of improving device properties such as charge transporting property, fluorescence intensity and light-emitting efficiency when using the aromatic graft polymer of the present invention for the polymer LED, as the arylene group represented by $Ar^2$, a phenylene group (formula 1A-1), a naphthalene-diyl group (formula 1A-2), a dihydrophenanthrene-diyl group (formula 1A-10), a fluorene-diyl group (formula 1A-13) and a benzofluorene-diyl group (formula 1A-14) are preferable among the formulae 1A-1 to 1A-14. Of these, a phenylene group (formula 1A-1), a fluorene-diyl group (formula 1A-13) and a naphthalene-diyl group (formula 1A-2) are preferable.

As the divalent residue of the $\pi$-conjugated cyclic compound represented by $Ar^2$, the following formulae 3A-1 to 3A-4 are also exemplified.

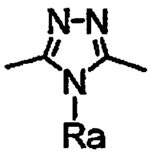

**3A-1**

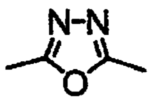

**3A-2**

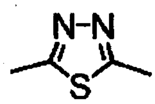

**3A-3**

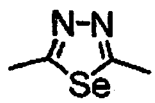

**3A-4**

(wherein Ra represents the same meaning as the above.)

In view of improving device properties such as charge transporting property, fluorescence intensity and light-emitting efficiency when using the aromatic graft polymer of the present invention for the polymer LED, as the divalent heterocyclic compound group having the $\pi$-conjugated system represented by $Ar^2$, a pyridine-diyl group (formula 2A-1), a quinoline-diyl group (formula 2A-6), an isoquinoline-diyl group (formula 2A-7), a quinoxaline-diyl group (formula 2A-8), a phenanthroline-diyl group (2A-18), a thiophene-diyl group (formula 2A-22), an imidazole-diyl group (2A-24), an oxazole-diyl group (formula 2A-26), a thiazole-diyl group (2A-27), a 5-membered heterocyclic group (formulae 2A-30 to 2 A-32, 2A-34 to 2A-40, 3A-1 to 3A-3) containing nitrogen, sulfur and oxygen as a hetero atom and having a condensed benzene ring, a heterocyclic group (formula 2A-41 to 2A-44, 2A-46 to 2A-47) having a fluorene-analogous skeleton containing silicon, nitrogen, oxygen and sulfur as a hetero atom, and heterocyclic group having a condensed structure represented by formulae (2A-48 to 2A-53) are preferable among the formulae 2A-1 to 2A-53 and 3A-1 to 3A-4. A thiophene-diyl group (formula 2A-22), a thiazole-diyl group (formula 2A-27), a benzothiadiazole-diyl group (formula 2A-39), a dibenzosilole-diyl group (formula 2A-41), a carbazole-diyl group (formula 2A-42), a dibenzofuran-diyl group (formula 2A-43), a dibenzothiophene-diyl group (formula 2A-44), an azafluorene-diyl group (formula 2A-47), a dibenzopyran-diyl

group (formula 2A-49), an oxadiazole-diyl group (3A-2), and a thioxadiazole-diyl group (3A-3) is more preferable. Of these, a thiophene-diyl group (formula 2A-22), a thiazole-diyl group (formula 2A-27), a benzothiadiazole-diyl group (formula 2A-39), a dibenzosilole-diyl group (formula 2A-41), a carbazole-diyl group (formula 2A-42), a dibenzofuran-diyl group (formula 2A-43), a dibenzothiophene-diyl group (formula 2A-44), a dibenzopyran-diyl group (formula 2A-49), and an oxadiazole-diyl group (3A-2) are still more preferable.

The divalent residue of the metal complex compound having the organic ligand having the π-conjugated cyclic compound structure represented by $Ar^2$ is the remaining divalent group obtained by removing two hydrogen atoms on carbon atom contained in the π-conjugated system of the ligand of the metal complex compound having the organic ligand having the π-conjugated cyclic compound structure.

The number of carbon atoms of the organic ligand is usually about 4 to 60, and examples thereof include 8-quinolinol and derivatives thereof, benzoquinolinol and derivatives thereof, 2-phenyl-pyridine and derivatives thereof, 2-phenyl-benzoquinolinol and derivatives thereof, 2-phenyl-benzoxazole and derivatives thereof, and porphyrin and derivatives thereof.

As the central metal of the complex, aluminum, zinc, beryllium, iridium, platinum, gold, europium, and terbium, etc. are exemplified.

As the metal complex compound having the organic ligand having the π-conjugated cyclic compound structure, known metal complexes and triplet light-emitting complexes, etc. as a low molecular weight fluorescence material and phosphorescence material are exemplified.

Specifically, as the divalent residue of the metal complex compound having the organic ligand having the π-conjugated cyclic compound structure, the following formulae 4A-1 to 4A-7 are exemplified.

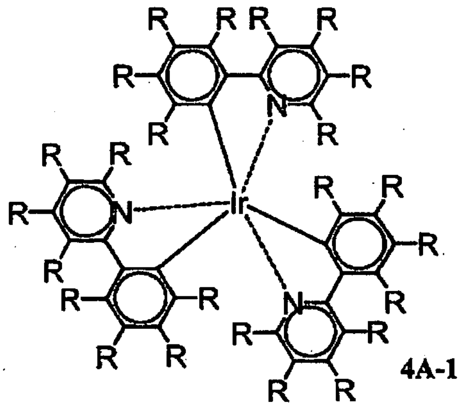

4A-1

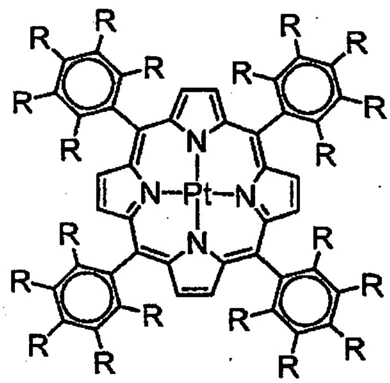

4A-2

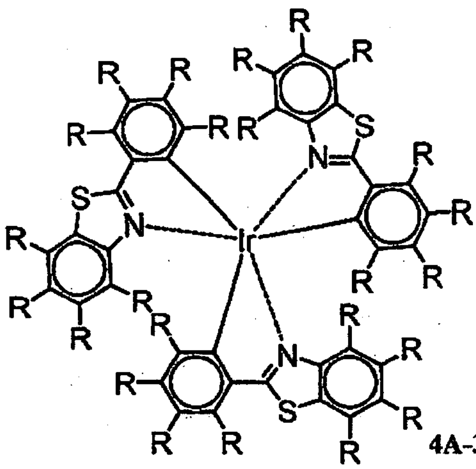

4A-3

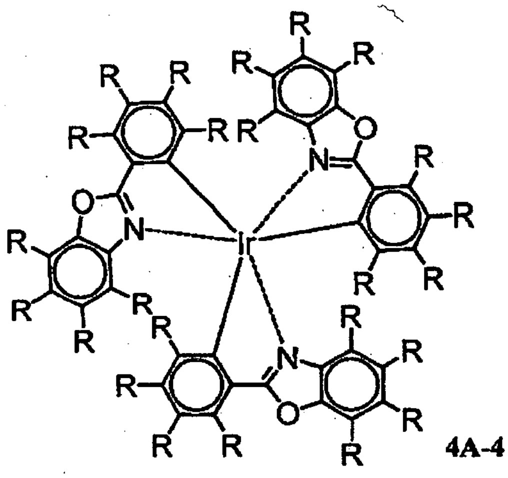

4A-4

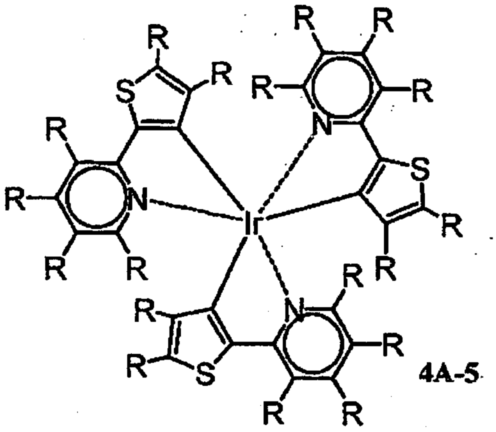

4A-5

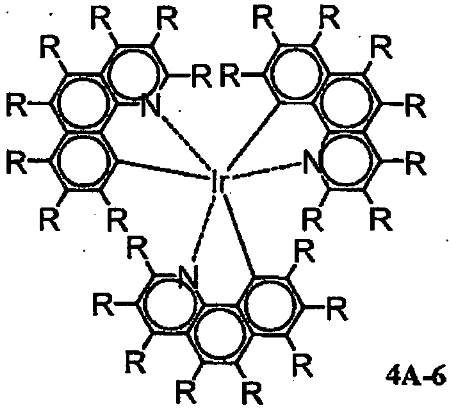

4A-6

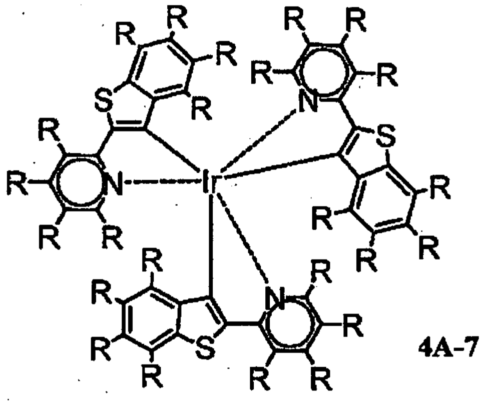

4A-7

In the formulae 4A-1 to 4A-7, R represents a linkage, a hydrogen atom or a substituent. Any two R's of two or more R's which are present represent a linkage. When two or more substituents represented by R are present, they may be the same or different. The same substituents as the above are exemplified as the substituent represented by R.

As the group which is represented by $Ar^2$ and has the divalent residue of the $\pi$-conjugated cyclic compound, an arylene group and divalent heterocyclic group are preferable. An arylene group having a condensed structure and a divalent heterocyclic group are more preferable. An arylene group having a condensed structure, and a divalent heterocyclic group having a condensed structure are still more preferable.

In the formula (2), $X^1$ represents a divalent group selected from the group consisting of a direct bond, $-NQ^1-$, $-PQ^2-$ and $-BQ^3-$. $Q^1$, $Q^2$ and $Q^3$ represent a substituent. As the substituents represented by $Q^1$ to $Q^3$, an alkyl group, an aryl group, an aralkyl group and a monovalent heterocyclic group are exemplified, and the definition and specific examples thereof are the same as those of an alkyl group, an aryl group, an aralkyl group and a monovalent heterocyclic group in the substituent of $Ar^1$. As the substituents represented by $Q^1$, $Q^2$ and $Q^3$, an aryl group and a monovalent heterocyclic group are particularly preferable. In the divalent group represented by $X^1$, the group represented by $-NQ^1-$ is particularly preferable in view of using the aromatic polymer of the present invention for the polymer LED.

In the formula (2), Z represents a direct bond or a divalent linking group. As the divalent linking group represented by Z, groups represented by the following formulae or a phthalimide-N,4-diyl group and pyromellitimide-N,N'-diyl group are exemplified. Furthermore, a divalent group in which two or more groups which are selected therefrom and may be the same or different are combined, and a divalent group prepared by combining one or more groups which are selected therefrom and may be the same or different and one or more groups selected from the divalent groups represented by $X^1$ are exemplified.

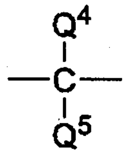 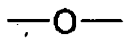 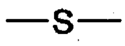 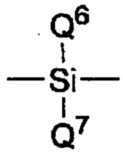

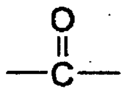 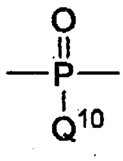 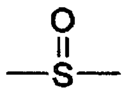 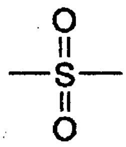

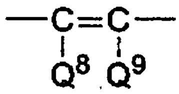 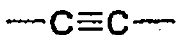 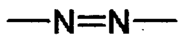

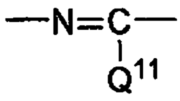 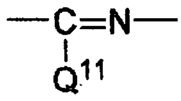 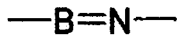 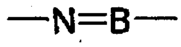

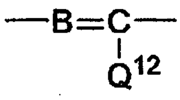 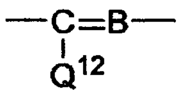 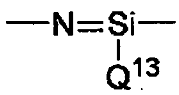 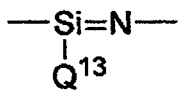

(wherein $Q^4$, $Q^5$, $Q^6$, $Q^7$, $Q^8$, $Q^9$, $Q^{10}$, $Q^{11}$, $Q^{12}$ and $Q^{13}$ each independently represent a group selected from the group consisting of a hydrogen atom, an alkyl group, an aryl group, an aralkyl group, a monovalent heterocyclic group, a formyl group, a substituted carbonyl group, a halogen atom and a cyano group. When two or more $Q^4$, $Q^5$, $Q^6$, $Q^7$, $Q^8$, $Q^9$, $Q^{10}$, $Q^{11}$, $Q^{12}$ and $Q^{13}$ are respectively present, they may be the same or different. The definition and specific examples of an alkyl group, an aryl group, an aralkyl group, a monovalent heterocyclic group and a substituted carbonyl group represented by $Q^4$, $Q^5$, $Q^6$, $Q^7$, $Q^8$, $Q^9$, $Q^{10}$, $Q^{11}$, $Q^{12}$ and $Q^{13}$ are the same as those of an alkyl group, an aryl group, an aralkyl group, a monovalent heterocyclic group, a substituted carbonyl group and a halogen atom in the substituent of $Ar^1$.)

As the divalent group in which two or more groups which are selected from the above and may be the same or different are combined, and the divalent group prepared by combining one or more groups which are selected from the above and may be the same or different and one or more groups selected from the divalent organic groups represented by $X^1$, there are exemplified groups which are represented by the following formulae, and groups in which any $-CH_2-$ groups of one or more in a $C_2$ to $C_{20}$ alkyl chain and a $C_2$ to $C_{20}$ alkyl chain are substituted by one or more groups which are selected from the above and may be the same or different.

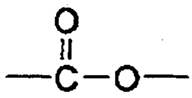 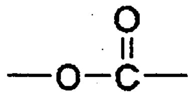 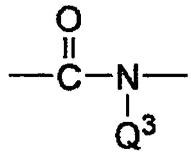

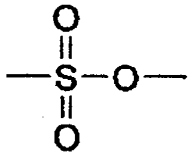 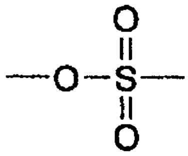 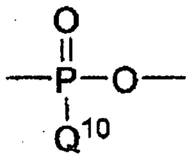 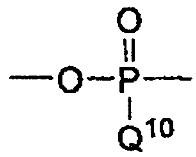

In the formula (2), in view of heat resistance and solubility into an organic solvent, Z is preferably a direct bond or a group represented by $NQ^1$-, $-CQ^4Q^5$-, $-SiQ^6Q^7$-, -C(=O)- or $SO_2$-, and a group obtained by combining two or more groups selected therefrom. The direct bond, the alkylene chain, or the alkylene chain containing a group represented by $NQ^1$-, -O-, -S-, $-SiQ^6Q^7$-, -C(=O)- or $-SO_2$- are more preferable, and the direct bond is still more preferable.
From balance between views such as solubility into an organic solvent, device properties and easiness of synthesis, and heat resistance when using the aromatic graft polymer of the present invention for the polymer LED, the direct bond and the groups represented by $-NQ^1$-, $-SiQ^6Q^7$-, $-CQ^8=CQ^9$-, and -C≡C- are preferable. The direct bond and the groups represented by $-NQ^1$- and $-SiQ^6Q^7$- are more preferable, and the direct bond or the group containing the alkyl chain is still more preferable.
When contribution to charge transport and charge injection properties is expected as the effect of the side chain represented by the formula (2) when using the aromatic graft polymer of the present invention for the polymer LED, Z is preferably a direct bond.

In the formula (2), when k represents an integer of 3 or more and two or more $Ar^2$'s, $X^1$'s, and Z's are present, they each may be the same or different. When two or more side chains represented by the formula (2) are present in the aromatic graft polymer of the present invention, they each may be the same or different.

In the aromatic graft polymer of the present invention, the side chain represented by the formula (2) has the repeating unit, thereby effectively exhibiting the function. Therefore, the side chain represented by the formula (2) requires that k is an integer of 3 or more. Preferably, k is an integer of 4 or more, more preferably 5 or more, and still more preferably 6 or more.
Although the upper limit of k is not particularly limited, a value which does not lose the solubility of the aromatic graft polymer of the present invention into the organic solvent is set to the upper limit of k. k is preferably an integer of $1 \times 10^4$ or less, and more preferably $5 \times 10^3$ or less, still more preferably 1000 or less, and particularly preferably 500 or less. When two or more organic side chains represented by the formula (2) are contained in the aromatic graft polymer of the present invention, two or more k's which are present may be the same or different, and k may not be contained in the preferable range.

Since the aromatic graft polymer of the present invention contains the divalent organic group represented by $X^1$ in the repeating unit represented by the formula (2), the function of the side chain is expected to be strengthened. Therefore, in the parameter f representing the length of the side chain defined by the following formula (3), the condition of $f \geq 4$ is preferably satisfied, more preferably $f \geq 5$, and still more preferably $f \geq 6$.

$$f = k + m \quad (3)$$

In the parameter f, m represents the number of the divalent groups among the direct bond and divalent groups represented by $X^1$ in the side chain represented by the formula (2).

The aromatic polymer of the present invention is expected to be highly functionalized by the side chain represented by the formula (2). For example, the aromatic polymer of the present invention has charge transporting property or photoluminescence in the solid state. Therefore, it is preferable that the side chain represented by the formula (2) has a function in response to a use. For example, when using the compound of the present invention for the polymer LED, it is preferable that the compound applies a charge injecting/transporting function such as a hole injecting/transporting function and an electron injecting/transporting function and functions such as fluorescence or phosphorescence light-emission, solubility, heat resistance to the main chain. From such a view, as the side chain represented by the formula (2), the followings are exemplified.

As the side chain having hole-injecting/transporting properties, there are exemplified side chains containing skeletons such as polyvinylcarbazole or derivatives thereof, polysilane or derivatives thereof, polysiloxane derivatives having an aromatic amine in the side chain or the main chain, pyrazoline derivatives, arylamine derivatives, stilbene derivatives, triphenyldiamine derivatives, polyaniline or derivatives thereof, polythiophene or derivatives thereof, polypyrrole or derivatives thereof, poly(p-phenylenevinylene) or derivatives thereof, poly(2,5-thienylenevinylene) or derivatives thereof, or the like.

As the substituents having electron injecting and transporting properties, there are exemplified side chains containing a skeleton such as oxadiazole derivatives, anthraquinonedimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof, and polyfluorene or derivatives thereof.

As the fluorescent substituents, there can be used side chains containing a skeleton such as naphthalene derivatives, anthracene or derivatives thereof, perylene or derivatives thereof, dyes such as polymethine dyes, xanthene dyes, coumarine dyes, cyanine dyes, metal complexes of 8-hydroxyquinoline or derivatives thereof, aromatic amine, tetraphenylcyclopentane or derivatives thereof, or tetraphenylbutadiene or derivatives thereof.

As the phosphorescent substituents, side chains containing a skeleton such as triplet light-emitting complex compounds such as $Ir(ppy)_3$ and $Btp_2Ir(acac)$ with iridium as the central metal atom, PtOEP with platinum as the central metal atom, and $Eu(TTA)_3phen$ with europium as the central metal atom are listed.

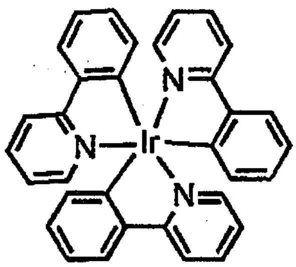

$Ir(ppy)_3$

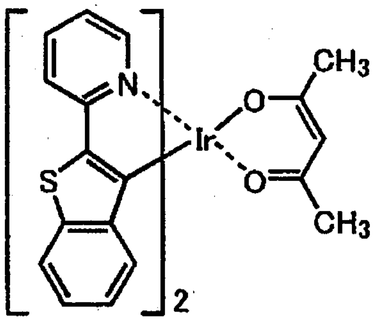

$Btp_2Ir(acac)$

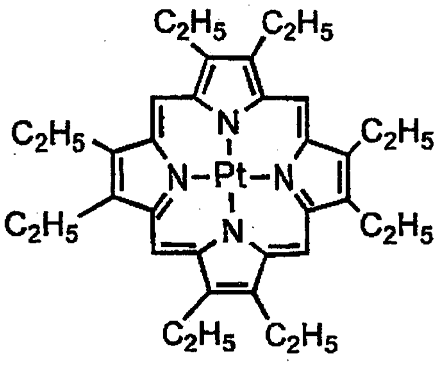

PtOEP

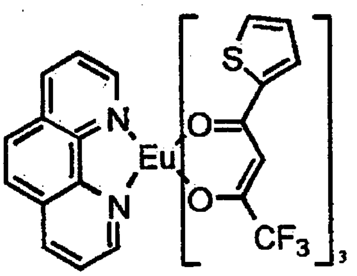

Eu(TTA)$_3$phen

The aromatic graft polymer of the present invention may contain another repeating unit in addition to the repeating unit represented by the formula (1). As the another repeating unit, a repeating unit selected from the group consisting of the following formulae (5), (6), (7), (8) and (9) is preferable.

$-Ar^4-$ (5)

$-Ar^5-$ (6)

$$-\left(Ar^6-X^2\right)_p-Ar^7- \quad (7)$$

$-Ar^8-X^3-$ (8)

$-X^4-$ (9)

Wherein $Ar^4$ represents a repeating unit in which in the side chain represented by the formula (2) in $Ar^1$ in the formula (1) is substituted by a hydrogen atom. $Ar^5$, $Ar^6$, $Ar^7$ and $Ar^8$ each independently represent a divalent group having a divalent residue of a $\pi$-conjugated cyclic compound. $X^2$, $X^3$ and $X^4$ each independently represent a divalent linking group. p represents 1 or 2.

The definition and examples of the divalent group having the divalent residue of the $\pi$-conjugated cyclic compound represented by $Ar^5$, $Ar^6$, $Ar^7$ and $Ar^8$ are the same as those of the divalent group represented by $Ar^2$ and having the divalent residue of the $\pi$-conjugated cyclic compound.

The divalent linking groups represented by $X^2$, $X^3$ and $X^4$ are defined and exemplified as in the groups represented by $X^1$ or Z.

As the divalent linking groups represented by $X^2$, $X^3$ and $X^4$, groups represented by $-NQ^1-$, $-CQ^4Q^5-$, - $SiQ^6Q^7-$, -C(=O)- and $-SO^2-$, and a group prepared by combining two or more groups selected therefrom are preferable in view of heat resistance.

In view of solubility into an organic solvent, an alkyl chain; a group represented by $-NQ^1-$, - O-, -S-, $-CQ^4Q^5-$, $-SiQ^6Q^7-$, -C(=O)- or $-SO_2-$; and an alkyl chain containing groups thereof are preferable.
The groups represented by $-NQ^1-$, $-SiQ^6Q^7-$, - $CQ^8=CQ^9-$ and -C=C- are preferable from the balance of views such as solubility into an organic solvent, device properties and easiness of synthesis, and heat resistance when using the aromatic graft polymer of the present invention for the polymer LED, and the groups represented by $-NQ^1-$ and $-SiQ^6Q^7-$ is more preferable.

When the aromatic graft polymer of the present invention consists only of the repeating units represented by the formulae (1) and (9), and when the aromatic graft polymer consists only of the repeating units represented by the formulae (1), (5) and (9), the rate of the repeating unit represented by the formula (9) to the all the repeating units represented by the formulae (1), (5) and (9) is preferably 40% or less in view of heat resistance and chemical stability, and more preferably 30% or less.

When the aromatic graft polymer of the present invention consists only of the repeating units represented by the formulae (1) and (8), and when the aromatic graft polymer consists only of the repeating units represented by the formulae (1), (5) and (8), the rate of the repeating unit represented by the formula (8) to the all the repeating units represented by the formulae (1), (5) and (8) is preferably 50% or less in view of heat resistance and chemical stability, and more preferably 30% or less.

As the repeating units other than $Ar^1$ directly bonded to the repeating unit represented by $Ar^1$ in the formula (1), the repeating units represented by the formulae (5), (6), (7) and the repeating unit in which the divalent residue of the $\pi$-conjugated cyclic compound represented by $Ar^8$ in the repeating unit represented by the formula (8) is bonded to $Ar^1$ are preferable among the repeating units represented by the formulae (5), (6), (7), (8) and (9). The repeating units represented by the formulae (5), (6) and (7) are more preferable.

As the repeating unit contained in the aromatic graft polymer of the present invention in addition to the repeating unit represented by the formula (1), in view of heat resistance and chemical stability, the repeating units represented by the formulae (5), (6) and (7) are preferable.

When the aromatic graft polymer of the present invention is used for an electronic material field of the polymer LED or the like, the main chain containing the repeating unit represented by the formula (1) is preferably a conjugated polymeric compound.

In views of changing a light emission wavelength, improving light-emitting efficiency and improving heat resistance when the aromatic graft polymer of the present invention is used for the polymer LED, as the repeating unit represented by the formula (6), a phenylene group (formula 1A-1), a naphthalene-diyl group (formula 1A-2), a dihydrophenanthrene-diyl group (formula 1A-10), a fluorene-diyl group (formula 1A-13), a benzofluorene-diyl group (formula 1A-14), a thiophene-diyl group (formula 2A-22), a thiazole-diyl group (formula 2A-27), a benzothiadiazole-diyl group (formula 2A-39), a dibenzosilole-diyl group (formula 2A-41), a carbazole-diyl group (formula 2A-42), a dibenzofuran-diyl group (formula 2A-43), a dibenzothiophene-diyl group (formula 2A-44), an azafluorene-diyl group (formula 2A-47), a dibenzopyran-diyl group (formula 2A-49), an oxadiazole-diyl group (3A-2) and a thioxadiazole-diyl group (3A-3) are preferable among the formulae 1A-1 to 1A-14, 2A-1 to 2A-53 and 3A-1 to 3A-4. Of these, a phenylene group (formula 1A-1), a naphthalene-diyl group (formula 1A-2), a fluorene-diyl group (formula 1A-13), a benzofluorene-diyl group (formula 1A-14), a thiophene-diyl group (formula 2 A-22), a thiazole-diyl group (formula 2 A-27), a benzothiadiazole-diyl group. (formula 2A-39), a dibenzosilole-diyl group (formula 2A-41), a carbazole-diyl group (formula 2A-42), a dibenzofuran-diyl group (formula 2A-43), a dibenzothiophene-diyl group (formula 2A-44), a dibenzopyran-diyl group (formula 2 A-49), an oxadiazole-diyl group (3A-2) are more preferable. A phenylene group (formula 1A-1), a naphthalene-diyl group (formula 1A-2), a fluorene-diyl group (formula 1A-13), and a benzofluorene-diyl group (formula 1 A-14) are still more preferable.

In views of changing a light emission wavelength, improving light-emitting efficiency and improving heat resistance when the aromatic graft polymer of the present invention is used for the polymer LED, repeating units represented by the following formulae (10) and (11) are preferable as the repeating unit represented by the formula (7).

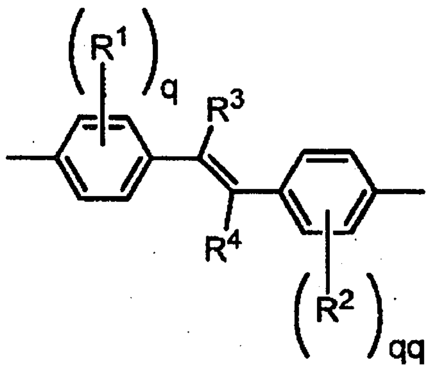

(1 0)

Wherein $R^1$ and $R^2$ each independently represent an alkyl group, alkoxy group, alkylthio group, aryl group, aryloxy group, arylthio group, aralkyl group, aralkyloxy group, aralkylthio group, arylalkenyl group, arylalkynyl group, amino group, substituted amino group, silanol group, substituted silyl group, halogen atom, substituted carbonyl group, substituted carbonyloxy group, imine residue, amide group, acid imide group, monovalent heterocyclic group, carboxylic group, substituted oxycarbonyl group, cyano group or nitro group. q and qq each independently represent an integer of 0 to 4. $R^3$ and $R^4$ each independently represent a hydrogen atom, alkyl group, aryl group, monovalent heterocyclic group, carboxylic group, substituted oxycarbonyl group or cyano group. When two or more $R^1$ and $R^2$ are present, they may be the same or different.

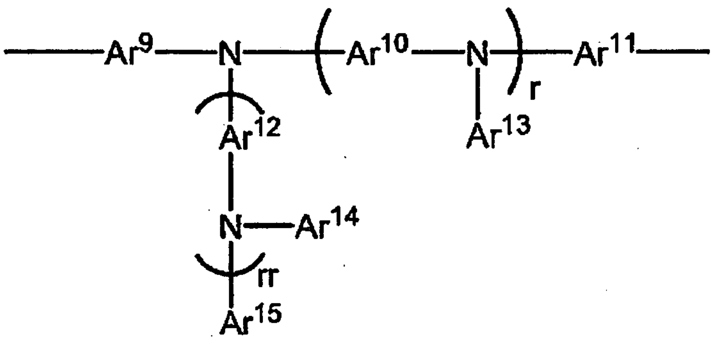

(1 1)

Wherein $Ar^9$, $Ar^{10}$, $Ar^{11}$, and $Ar^{12}$ each independently represent a divalent residue of a π-conjugated cyclic compound. $Ar^{13}$, $Ar^{14}$, and $Ar^{15}$ each independently represent an aryl group or monovalent heterocyclic group. $Ar^9$, $Ar^{10}$, $Ar^{11}$, $Ar^{12}$, $Ar^{13}$, $Ar^{14}$, and $Ar^{15}$ may have a substituent. r and rr each independently represent 0 or 1.

Among the repeating units represented by the formulae (10) and (11), in view of heat resistance, the repeating unit represented by the formula (11) is more preferable.

In views of changing a light emission wavelength, improving light-emitting efficiency and improving heat resistance when the aromatic graft polymer of the present invention is used for the polymer LED, repeating units which are obtained by the combination of the repeating units represented by the formulae (6) to (9) and are represented by the following formulae (12), (13), (14) and (15) are preferable.

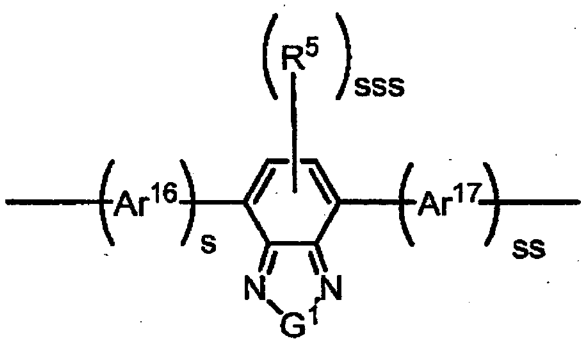

(1 2)

Wherein $R^5$ represents an alkyl group, alkoxy group, alkylthio group, aryl group, aryloxy group, arylthio group, aralkyl group, aralkyloxy group, aralkylthio group, arylalkenyl group, arylalkynyl group, amino group, substituted amino group, silanol group, substituted silyl group, halogen atom, substituted carbonyl group, substituted carbonyloxy group, imine residue, amide group, acid imide group, monovalent heterocyclic group, carboxylic group, substituted oxycarbonyl group, cyano group or nitro group. sss represents an integer of 0 to 2. $Ar^{16}$ and $Ar^{17}$ each independently represent a divalent group having a divalent residue of a $\pi$-conjugated cyclic compound. s and ss each independently represent 0 or 1. $G^1$ represents O, S, SO, $SO_2$, Se or Te. When two or more $R^5$s are present, they may be the same or different.

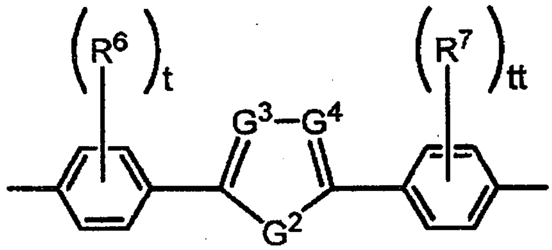

(1 3)

Wherein $R^6$ and $R^7$ each independently represents an alkyl group, alkoxy group, alkylthio group, aryl group, aryloxy group, arylthio group, aralkyl group, aralkyloxy group, aralkylthio group, arylalkenyl group, arylalkynyl group, amino group, substituted amino group, silanol group, substituted silyl group, halogen atom, substituted carbonyl group, substituted carbonyloxy group, imine residue, amide group, acid imide group, monovalent heterocyclic group, carboxylic group, substituted oxycarbonyl group, cyano group or nitro group. t and tt each independently represent an integer of 0 to 4. $G^5$ represents O, S, $SO_2$, Se, Te, N-$R^8$, or $SiR^9R^{10}$. $G^6$ and $G^7$ each independently represent N or C-$R^{11}$. $R^8$, $R^9$, $R^{10}$, and $R^{11}$ each independently represent a hydrogen atom, alkyl group, aryl group, arylalkyl group, or monovalent heterocyclic group. When two or more $R^6$, $R^7$ and $R^{11}$ are present, they may be the same or different.
As the examples of central 5-membered ring in the repeating unit represented by formula (15), thiadiazole, oxadiazole, triazole, thiophene, furan, silole or the like are exemplified.

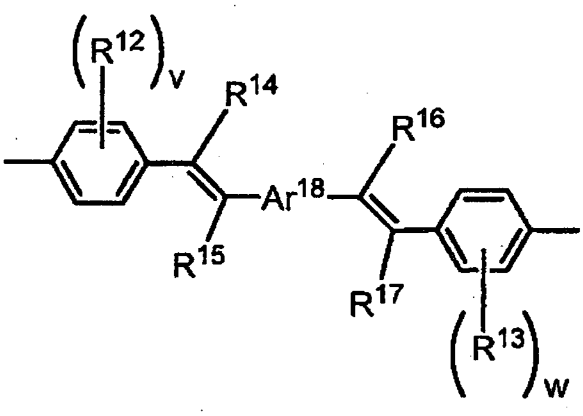

(14)

Wherein $R^{12}$ and $R^{13}$ each independently represent an alkyl group, alkoxy group, alkylthio group, aryl group, aryloxy group, arylthio group, aralkyl group, aralkyloxy group, aralkylthio group, arylalkenyl group, arylalkynyl group, amino group, substituted amino group, silanol group, substituted silyl group, halogen atom, substituted carbonyl group, substituted carbonyloxy group, imine residue, amide group, acid imide group, monovalent heterocyclic group, carboxylic group, substituted oxycarbonyl group, cyano group or nitro group. v and w each independently represent an integer of 0 to 4. $R^{14}$, $R^{15}$, $R^{16}$, and $R^{17}$ each independently represent a hydrogen atom, alkyl group, aryl group, monovalent heterocyclic group, carboxylic group, substituted oxycarbonyl group or cyano group. $Ar^{18}$ represents a divalent group having a divalent residue of a π-conjugated cyclic compound. When two or more $R^{12}$ and $R^{13}$ are present, they may be the same or different.

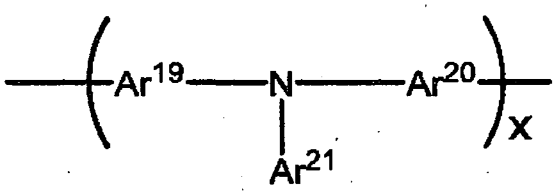

(15)

Wherein $Ar^{19}$ and $Ar^{20}$ each independently represent a divalent group having a divalent residue of a π-conjugated cyclic compound. x represents 1 or 2.

As the repeating unit contained in the aromatic graft polymer of the present invention in addition to the repeating unit represented by the formula (1) when the aromatic graft polymer of the present invention is used for the polymer LED, in views of changing a light emission wavelength, improving light-emitting efficiency and improving heat resistance, the repeating units represented by the formulae (5), (6), (7), (10), (11), (12), (13), (14) and (15) are preferable, and the repeating units represented by the formulae (5), (6), (11), (12), (13) and (15) are still more preferable.

Among the aromatic graft polymer of the present invention, that consisting of only any one of the repeating units represented by the formula (1), that consisting of two or more repeating units selected from the repeating units represented by the formula (1), that consisting of only any one of the repeating units represented by the formula (1) and the repeating unit represented by the formula (5), that consisting of two or more repeating units selected from the repeating units represented by the formula (1) and the repeating unit represented by the formula (5), and that consisting substantially of one or more repeating units selected from the repeating units represented by the formula (1) and one or more repeating units represented by the formulae (5) to (15) are preferable.

The aromatic graft polymer of the present invention may also be a random or block copolymer in the main chain structure, or a polymer having an intermediate structure thereof, for example, a random copolymer having block property. In view of obtaining high light-emitting efficiency when the aromatic graft polymer of the present invention is used for the polymer LED, it is preferable that the main chain structure is not a complete random copolymer but a random copolymer and block copolymer having block property.

The aromatic graft polymer of the present invention may also be a random or block copolymer in the structure of the side chain represented by the formula (2), or a copolymer having an intermediate structure thereof, for example, a random copolymer having block property.

In the aromatic graft polymer of the present invention, the repeating unit represented by the formula (1) is located at a main chain end, and thereby the side chain represented by the formula (2) may have a substantial main chain end structure.

Since a polymerization active group remaining as it is may reduce light emitting property and life in the case of producing the device when the aromatic graft polymer of the present invention is used for the polymer LED, the polymerization active group may be protected by a stable group.

In the aromatic graft polymer of the present invention, the function of the main chain is expected to be adjusted and improved by the side chain represented by the formula (2), or a new function is expected to be applied by the side chain without impairing the function of the main chain, thereby, it is preferable that the structure of the main chain and the structure of the side chain exhibit different properties respectively. More specifically, it is preferable that that the repeating unit in the side chain and the repeating unit in the main chain are substantially different repeating units, or the combination of the repeating units in the side chain and the combination of the repeating units in the main chain are a substantially different combination.

In the aromatic graft polymer of the present invention, the rate of the total amount of all the repeating unit represented by the formula (1) to the total amount of are the repeating units contained in the main chain of the aromatic graft polymer of the present invention is not particularly limited as long as the property of the side chain represented by the formula (2) contained in the repeating unit represented by the formula (1) in the aromatic graft polymer of the present invention can be exhibited. In view of easiness of synthesis, it is preferable that the rate is usually 0.1 mol% or more and 100 mol% or less, preferably 1.0 mol% or more, more preferably 5 mol% or more, still more preferably 10 mol% or more, and particularly preferably 20 mol% or more. The main chain in the present invention is defined as a polymer chain containing the most repeating units represented by the formula (1). When the repeating unit represented by the formula (1) is located at the polymer chain end, the total amount of all the repeating units contained in the main chain does not contain the repeating unit in the side chain represented by the formula (2) contained in the repeating unit represented by the formula (1) located at the end.

The rate of the total amount of the repeating unit represented by the formula (1) in the aromatic graft polymer of the present invention to the total amount of the repeating units represented by the formulae (1) and (5) to (9) contained in the main chain of the aromatic graft polymer of the present invention is usually 0.1 mol% or more and 100 mol% or less, and preferably 1 mol% or more and 100 mol% or less. Of these, when the side chain represented by the formula (2) is a functional side chain for applying charge injecting and transporting properties when the aromatic graft polymer of the present invention is used for the polymer LED, the rate is preferably 11 mol% or more for more effectively attaining the high functionalization, more preferably 16 mol% or more, and still more preferably 20 mol% or more. When the side chain contains a fluorescent or phosphorescent dye so that the dye is introduced to adjust the light emission wavelength, the amount of the dye is preferably 0.3 mol% or more, and more preferably 1 mol% or more.

On the other hand, in view of easiness of synthesis, the upper limit is preferably 80 mol% or less, more preferably 60 mol% or less, and still more preferably 40 mol% or less. Of these, when the side chain represented by the formula (2) contains the fluorescent or phosphorescent dye so that the dye is introduced to adjust the light emission wavelength, the amount of the dye is preferably 30 mol% or less in view of efficiency, more preferably 20 mol% or less, and still more preferably 15 mol% or less.

The number average molecular weight of the aromatic graft polymer of the present invention in terms of polystyrene, without being particularly limited, is about $10^3$ to $10^8$ in view of solubility and film-forming property, preferably $3\times10^3$ to $10^6$, and more preferably $5\times10^3$ to $5\times10^5$. The weight average molecular weight in terms of polystyrene is usually about $10^3$ to $10^8$, preferably $3\times10^3$ to $1\times10^7$ in view of film-forming property, and more preferably $5\times10^3$ to $5\times10^6$.

Although the dispersion degree (weight average molecular weight/number average molecular weight) of the aromatic graft polymer of the present invention is not particularly limited, the dispersion degree is preferably low in the application using the aromatic graft polymer of the present invention as an additive to the other polymer, and more preferably 12 or less.

When the aromatic graft polymer of the present invention consists only of the repeating unit represented by the formula (1), and consists of the repeating unit represented by the formula (1) and the repeating unit represented by the formula (5), it is preferable that the elution curve of GPC has a substantial single-peak and the dispersion degree is 1.0 or more and 12 or less, and more preferably 1.0 or more and 7 or less.

The elution curve of GPC is generally measured by GPC (gel permeation chromatography). The elution curve of GPC in the present invention is measured in terms of the standard polystyrene using a differential refractometer for a detector. The GPC may be referred to as SEC (size exclusion chromatography).

As the good solvent to the aromatic graft polymer of the present invention, exemplified are chlorine solvents such as chloroform, methylene chloride, dichloroethane and o-dichlorobenzene; ether solvents such as tetrahydrofuran and anisole; and hydrocarbon solvents such as toluene, xylene, mesitylene, n-butyl benzene, tetralin and decalin. Although it depends on the structure and the molecular weight of the aromatic graft polymer, usually the aromatic graft polymer can be dissolved in these solvents in 0.1% by weight or more.

As the methods for synthesizing the aromatic graft polymer of the present invention, there are exemplified (a) a method for separately synthesizing a main chain and a side chain which have characteristic groups which are reacted with each other to generate a bond, and then bonding the main chain and the side chain by a reaction to provide an aromatic graft polymer, (b) a method for synthesizing a main chain having a characteristic group which is reacted with a monomer as a side chain to generate a bond, further polymerizing the monomer as the side chain, and growing the side chain from the main chain to provide an aromatic graft polymer, and (c) a method for synthesizing a macro monomer having a side chain, then polymerizing the macro monomer to synthesize a main chain having a side chain to provide an aromatic graft polymer, or the like.

As the methods for synthesizing the main chain in the synthesizing methods (a), (b) and (c), there are exemplified a method for dissolving a corresponding monomer or macro monomer having a characteristic group which is linked to condensation polymerization in an organic solvent if needed using a known condensation reaction, and, for example, conducting condensation polymerization using alkali or a suitable catalyst.

As the methods for condensation polymerization, known methods can be used, which are described in, for example: Organic Reactions, Volume 14, page 270-490, John Wiley & Sons, Inc., 1965; Organic Syntheses, Collective Volume VI, page 407-411, John Wiley & Sons, Inc., 1988; Chemical Review (Chem. Rev.), Volume 95, page 2457 (1995); Journal of Organometallic Chemistry (J. Organomet. Chem.), Volume 576, page 147 (1999); and Macromolecular Chemistry, Macromolecular Symposium (Makromol. Chem., Macromol. Symp.), Volume 12th, page 229 (1987).

As the method of condensation polymerization, in case of generating a double bond, it can be produced by, for example, a method described in JP-A-5-202355. That is, exemplified are: polymerization by Wittig reaction of a compound having a formyl group and a compound having a phosphonium methyl group; polymerization by Wittig reaction of a compound having a formyl group and a phosphonium methyl group; polymerization by the Heck reaction of a compound having a vinyl group and a compound having a halogen atom; polycondensation by dehydrohalogenation method of a compound having two or more of mono-halogenated methyl groups; polycondensation by sulfonium-salt decomposition method of a compound having two or more sulfonium methyl groups; polymerization by Knoevenagel reaction of a compound having a formyl group and a compound having a cyanomethyl group; and polymerization by McMurry reaction of a compound having two or more formyl groups.

When the polymeric compound of the present invention generates a triple bond in the main chain by condensation polymerization, for example, there can be used polymerization by Stille acetylene coupling reaction of a compound having an acetylide group such as tin and a compound having a halogen atom, and polymerization by Sonogashira reaction of a compound having an acetylene group and a compound having a halogen atom.

When generating neither a double bond nor a triple bond, for example, there are exemplified a method of polymerization by Suzuki coupling reaction of a compound having a boric acid group or a borate ester group and a compound having a sulfonate group such as a halogen atom or a trifluoromethanesulfonate group, a method of polymerization by Grignard reaction of a compound having a halogenated magnesium group and a compound having a halogen atom, a method of polymerization of compounds having a sulfonate group such as a halogen atom or trifluoromethanesulfonate by Ni(0) complex, a method of polymerization by an oxidizing agent such as $FeCl_3$, an electrochemical oxidization polymerization, and a method by decomposition of an intermediate polymer having an appropriate leaving group.

Among these, the polymerization by Wittig reaction, polymerization by Heck reaction, polymerization by Knoevenagel reaction, polymerization by Suzuki coupling reaction, method of polymerization by Grignard reaction, and method of polymerization by Ni(O) complex are preferable, since it is easy to control the structures.

In detail, as the methods for synthesizing a main chain in the synthesizing methods (a) and (b), there are exemplified: (d) a method for synthesizing a main chain by the method, then introducing a characteristic group which is reacted with a side chain or a monomer as a side chain to generate a bond by halogenation by a halogenating agent such as bromine and N-halogenosuccinimide, electrophilic substitution reaction such as lithiation by a lithiating agent such as alkyllithium, and further functional group conversion reaction, or the like to synthesize the main chain having the characteristic group; and (e) a method for synthesizing a main chain having a characteristic group using a monomer having a characteristic group which is reacted with a main chain or a monomer as a side chain when synthesizing the main chain by the method to generate a bond; and (f) a method for synthesizing a main chain having a characteristic group by a method for synthesizing a main chain using a monomer having a functional group which can be changed into a characteristic group when synthesizing the main chain by the method, and then changing the functional group into a characteristic group by various known functional group conversion reactions, or the like.

As the methods for synthesizing the side chain in the method (a), the method by condensation polymerization is exemplified. In detail, there are exemplified: (g) a method for synthesizing a side chain by the method, then introducing a characteristic group which is reacted with a main chain to generate a bond by halogenation by a halogenating agent such as bromine and N-halogenosuccinimide, electrophilic substitution reaction such as lithiation by a lithiating agent such as alkyllithium, and further functional group conversion reaction, or the like, to synthesize the side chain having the characteristic group; (h) a method for synthesizing a side chain having a characteristic group using a monomer

having a characteristic group which is reacted with a main chain to generate a bond when synthesizing the side chain by the method; and (i) a method for synthesizing a side chain having a characteristic group by a method for synthesizing a side chain using a monomer having a functional group which can be changed into a characteristic group, and then changing the functional group into a characteristic group by various known functional group conversion reactions to the side chain having the characteristic group when synthesizing the side chain by the method, or the like.

As the reactions for coupling the main chain with the side chain in the method (a) to generate a carbon-carbon conjugated bond, there are exemplified a coupling method by Suzuki coupling reaction, a coupling method by Grignard reaction, and a coupling method by Ni(O) complex. In view of suppressing a cross-linking reaction and easiness of reaction control, the coupling method by Suzuki coupling reaction and the coupling method by Grignard reaction are preferable.

As the methods for conducting condensation polymerization of the main chain and the monomer as the side chain in the method (b) to generate a carbon-carbon conjugated bond, there are exemplified: a method of polymerization by Suzuki coupling reaction; a method of polymerization by Grignard reaction; and a method of polymerization by Ni(O) complex. In view of suppressing a cross-linking reaction and easiness of reaction control, the method of polymerization by Suzuki coupling reaction and the method of polymerization by Grignard reaction are preferable. As the characteristic groups which are contained in the monomer as the side chain and are linked to condensation polymerization, that containing characteristic groups is preferably used, which are bonded with each other to form a bond in the same monomer, such as a halogen atom-boric acid group, a halogen atom-borate ester group, and a halogen atom-halogenating magnesium group, thereby suppressing the cross-linking reaction.

Next, the use of the aromatic graft polymer of the present invention is explained.

The aromatic graft polymer of the present invention has fluorescence or phosphorescence in the solid state, and it can be used as a light emitting polymer (high-molecular weight light emitting material).

Moreover, the polymeric compound has excellent charge transportating property, and can use it suitably as a material for the polymer light emitting device and a charge transporting material. The polymer light emitting device comprising the light emitting polymer is a polymer light emitting device of high performance which can be driven at low-voltage and at high efficiency. Therefore, the polymer light emitting device can be preferably used for apparatus, such as a liquid crystal display device as a back light, a flat or curved light source for lighting, a segment display device, and a dot matrix flat-panel display or the like.

Moreover, the aromatic graft polymer of the present invention can be used also as laser dye, organic solar-cell material, organic semiconductor for organic transistors, and electric conductive thin film material such as conductive thin film and organic semiconductor thin film.

Furthermore, it can be used also as a light emitting thin film material which emits fluorescence and phosphorescence.

Next, the polymer light emitting device of the present invention is explained.

The polymer light emitting device of the present invention is characterized by having a layer which contains an organic layer between the electrodes consisting of an anode and a cathode, and the organic layer comprises the aromatic graft polymer of the present invention.

The organic layer may be any of a light emitting layer, a hole transporting layer, a hole injecting layer, an electron transporting layer, an electron injecting layer and an interlayer. However, preferably, the organic layer is a light emitting layer.

Herein, the light emitting layer is a layer having function to emit a light. The hole transporting layer is a layer having function to transport a hole, and the electron transporting layer is a layer having function to transport an electron. An interlayer is adjacently present to the light emitting layer between the light emitting layer and the anode, and plays a role for isolating the light emitting layer from the anode, or the light emitting layer from the hole injecting layer or the hole transporting layer.

Herein, the electron transporting layer and the hole transporting layer are generically called a charge transporting layer. In addition, the electron injecting layer and the hole injecting layer are generically called a charge injecting layer. The light emitting layer, hole transporting layer, hole injecting layer, electron transporting layer and electron injecting layer may be each independently used as two or more layers.

When the organic layer is a light emitting layer, the light emitting layer which is an organic layer may contain further a hole transporting material, an electron transporting material, or light emitting material. Herein, the light emitting material means the material which exhibits fluorescence and/or phosphorescence.

When the aromatic graft polymer of the present invention and a hole transporting material are mixed, the mixing rate of the hole transporting material based on whole the mixture is 1 wt% to 80 wt%, and preferably 5 wt% to 60 wt%. When the polymeric material of the present invention and an electron transporting material are mixed, the mixing rate of the electron transporting material based on whole the mixture is 1 wt% to 80 wt%, and preferably 5 wt% to 60 wt%. Moreover, when the aromatic graft polymer of the present invention and a light emitting material are mixed, the mixing rate of the light emitting material based on whole the mixture is 1 wt% to 80 wt%, and preferably 5 wt% to 60 wt%. When the aromatic graft polymer of the present invention, a light emitting material, a hole transporting material and/or an

electron transporting material are mixed, the mixing rate of the light emitting material based on whole the mixture is 1 wt% to 50 wt%, preferably 5 wt% to 40 wt%. The rate of the hole transporting material and the electron transporting material based on total thereof is 1 wt% to 50 wt%, preferably 5 wt% to 40 wt%. Thereby, the content of the aromatic graft polymer of the present invention is 98 wt% to 1 wt%, and preferably 90, wt% to 20 wt %.

As the hole transporting material, electron transporting material, and light emitting material to be mixed, known low molecular weight compounds, triplet light-emitting complexes or polymeric compounds can be used, and it is preferable to use a polymeric compound.

As the hole transporting material, electron transporting material and light emitting material of the polymeric compound, there are exemplified: polyfluorene, derivative and copolymer thereof; polyarylene, derivative and copolymer thereof; polyarylene vinylene, derivative and copolymer thereof; and aromatic amine, derivative and (co)polymer thereof; and they are disclosed in WO 99/13692, WO99/48160, GB2340304A, WO00/53656, WO01/19834, WO00/55927, GB2348316, WO00/46321, WO00/06665, WO99/54943, WO99/54385, US5777070, WO98/06773, WO97/05184, WO00/35987, WO00/53655, WO01/34722, WO99/24526, WO00/22027, WO00/22026, WO98/27136, US573636, WO 98/21262, US5741921, WO 97/09394, WO 96/29356, WO 96/10617, EP0707020, WO95/07955, JP-A-2001-181618, JP-A-2001-123156, JP-A-2001-3045, JP-A-2000-351967, JP-A-2000-303066, JP-A-2000-299189, JP-A-2000-252065, JP-A-2000-136379, JP-A-2000-104057, JP-A-2000-80167, JP-A-10-324870, JP-A-10-114891, JP-A-9-111233, and JP-A-9-45478 or the like.

As the low molecular weight light emitting material, there can be used, for example, naphthalene derivatives, anthracene or derivatives thereof, perylene or derivatives thereof; dyes such as polymethine dyes, xanthene dyes, coumarine dyes, cyanine dyes; metal complexes of 8-hydroxyquinoline or derivatives thereof, aromatic amine, tetraphenylcyclopentane or derivatives thereof, or tetraphenylbutadiene or derivatives thereof.

Specifically, there can be used known compounds such as those described in JP-A-57-51781 and JP-A-59-194393, for example.

As the triplet light-emitting complex, for example, $Ir(ppy)_3$ and $Btp_2Ir$ (acac) with iridium as the central metal atom, PtOEP with platinum as the central metal atom, $Eu(TTA)_3$ phen with europium as the central metal atom are exemplified.

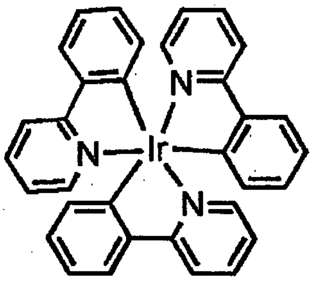

$Ir(ppy)_3$

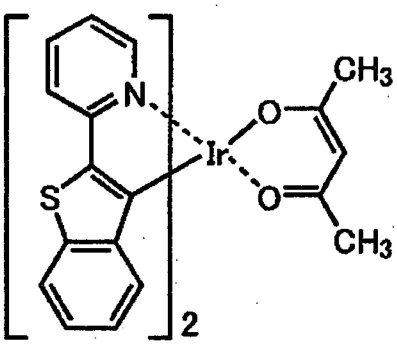

$Btp_2Ir(acac)$

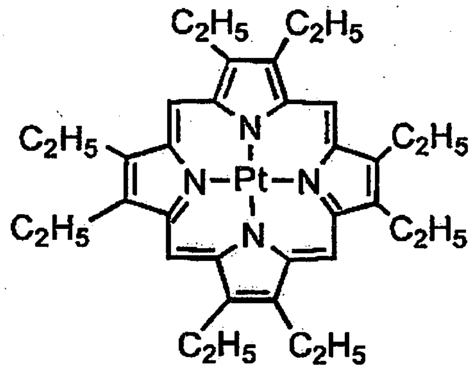

PtOEP

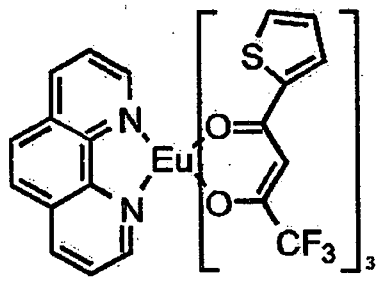

Eu(TTA)3phen

The triplet light-emitting complex compounds are disclosed in, for example, Nature, (1998) 395, 151; Appl. Phys. Lett. (1999), 75(1), 4; Proc. SPIE-Int. Soc. Opt. Eng. (2001), 4105 (Organic Light emitting materials and Devices IV), 119; J. Am. Chem. Soc., (2001), 123, 4304; Appl. Phys. Lett., (1997), 71(18), 2596; Syn. Met., (1998), 94(1), 103; Syn. Met., (1999), 99(2), 1361; Adv. Mater., (1999), 11 (10), 852, Jpn.J.Appl.Phys.,34, 1883 (1995).

The composition of the present invention contains at least one kind of material selected from a hole transport, electron transport and light-emitting materials, and the aromatic graft polymer of the present invention. The composition can be used as a light-emitting material or an electron transporting material.

The content ratio of at least one kind of material selected from a hole transport, electron transport and light emitting materials to the aromatic graft polymer of the present invention can be determined depending on the use of the composition. However, when the composition is used as a light-emitting material, preferably the content ratio is the same as that of the light emitting layer.

The number average molecular weight of the polymer composition of the present invention in terms of polystyrene is usually about $10^3$ to $10^8$, and preferably $10^4$ to $10^6$. The weight average molecular weight in terms of polystyrene is usually about $10^3$ to $10^8$, and preferably $1\times10^4$ to $5\times10^6$ in view of film-forming property and efficiency when being used for a device. Herein, the average molecular weight of the polymer composition means a value determined by analyzing a composition obtained by mixing two or more kinds of polymeric compounds using GPC.

As the thickness of the light emitting layer in the polymer light emitting device of the present invention, the optimum value differs depending on material used, and may be selected so that the driving voltage and the light-emitting efficiency become moderate values. For example, it is 1 nm to 1 μm, preferably 2 nm to 500 nm, and more preferably 5 nm to 200 nm.

As the forming method of the light emitting layer, for example, film forming method from a solution is exemplified. As the film-forming method from solution, there can be used coating methods such as a spin coating method, a casting method, a micro gravure coating method, a gravure coating method, a bar coating method, a roll coating method, a wire bar coating method, a dip coating method, a spray coating method, a screen printing method, a flexo printing method, an offset printing method, and an inkjet printing method. At the point that a pattern forming and multicolored printing are easy, printing methods such as a screen printing method, a flexo printing method, an offset printing method, and an inkjet printing method are preferable.

As the ink composition used by the printing method etc., at least one kind of the aromatic graft polymer of the present invention may be contained, and a hole transporting material, an electron transporting material, a light emitting material, a solvent, and additive such as a stabilizing agent, may be contained in addition to the aromatic graft polymer

of the present invention.
The rate of the aromatic graft polymer of the present invention in the ink composition is usually 20 wt% to 100 wt% to the total weight of the composition excluding the solvent, and preferably 40 wt% to 100 wt%.
When a solvent is contained in the ink composition, the rate of the solvent is 1 wt% to 99.9 wt% to the total weight of a composition, preferably 60 wt% to 99.5 wt%, and more preferably 80 wt% to 99.0 wt%.
Viscosity of the ink composition changes according to a printing method, and when the ink composition goes through a discharging apparatus, such as inkjet printing method, it is preferable that the viscosity is in a range of 1 to 20 mPa·s at 25°C in order to prevent clogging and flight bending at the time of discharging.

The solution of the present invention may contain an additive for adjusting viscosity and/or surface tension in addition to the aromatic graft polymer of the present invention. As the additive, a high-molecular weight polymeric compound (thickener) for enhancing viscosity, a poor solvent, a low-molecular weight compound for reducing viscosity, and a surface-active agent for reducing surface tension or the like may be appropriately combined and used.
As the high-molecular weight polymeric compound described above, there may be used those which are soluble in the same solvent as the aromatic graft polymer of the present invention and blocks neither light emission nor charge transporting property. For example, high-molecular weight polystyrene, polymethylmethacrylate, or a high-molecular weight aromatic graft polymer of the present invention or the like can be used. The weight average molecular weight is preferably 500,000 or more, and more preferably 1,000,000 or more.
A poor solvent can be also used as a thickener. That is, the viscosity of a solution can be enhanced by adding a poor solvent of a small amount to solid content in the solution. When the poor solvent is added for this object, the kind and addition amount of the solvent may be selected in a range where the solid content in the solution is not deposited. The amount of the poor solvent is preferably 50 wt% or less to whole of the solution while considering stability in storage, and still more preferably 30 wt% or less.

The solution of the present invention may contain an antioxidant other than the aromatic graft polymer of the present invention for improving storage stability. As the antioxidants, there may be used those which are soluble in the same solvent as the aromatic graft polymer of the present invention and disturb neither light emission nor charge transporting property, and a phenolic antioxidant and a phosphorus antioxidant or the like are exemplified.

Although the solvent used for ink composition is not particularly limited, those which can dissolve or disperse uniformly the materials constituting the ink composition other than solvent are preferable. As the solvents, there are exemplified chlorine solvents such as chloroform, methylene chloride, 1,2-dichloroethane, 1,1,2-trichloroethane, chlorobenzene and o-dichlorobenzene, ether solvents such as tetrahydrofuran, dioxane and anisole, aromatic hydrocarbon solvents such as toluene and xylene, aliphatic hydrocarbon solvents such as cyclohexane, methylcyclohexane, n-pentane, n-hexane and n-heptane, n-octane, n-nonane, and n-decane, ketone solvents such as acetone, methyl ethyl ketone, cyclohexanone, benzophenone and acetophenone, ester solvents such as ethyl acetate, butyl acetate, ethylcellosolve acetate, methyl benzoate and phenyl acetate, polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, and 1,2-hexanediol, alcoholic solvents such as methanol, ethanol, propanol, isopropanol and cyclohexanol, sulfoxide solvents such as dimethyl sulfoxide, and amide solvents such as N-methyl-2-pyrolidone and N,N-dimethylformamide. These organic solvents may be used singly or in combination.
Among them, in view of the solubility, homogeneity in film-forming, and viscosity property or the like of the polymeric compound or the like, the aromatic hydrocarbon solvents, ether solvents, aliphatic hydrocarbon solvents, ester solvents, ketone solvents are preferable. Toluene, xylene, ethyl benzene, diethyl benzene, trimethyl benzene, n-propyl benzene, isopropyl benzene, n-butyl benzene, isobutyl benzene, s-butyl benzene, n-hexyl benzene, cyclohexyl benzene, 1-methylnaphthalene, tetralin, anisole, ethoxy benzene, cyclohexane, bicyclohexyl, cyclohexenyl cyclohexanone, n-heptylcyclohexane, n-hexyl cyclohexane, decalin, methyl benzoate, cyclohexanone, 2-propyl cyclohexanone, 2-heptane, 3-heptane, 4-heptane, 2-octanone, 2-nonanone, 2-decanone, dicyclohexylketone, acetophenone, and benzophenone are preferable.

Regarding the kind of solvent in the solution, two or more kinds are preferable in view of film-forming property and device property or the like, more preferably 2 to 3 kinds, and still more preferably two kinds.
When the solution contains two kinds of solvents, one kind of solvent may be in a solid state at 25°C. In view of film-forming property, it is preferable that one kind of solvent has a boiling point of 180°C or more, and more preferably 200°C or more. In view of viscosity, it is preferable that the aromatic graft polymer of 1 wt% or more is dissolved with two kinds of solvents at 60°C, and,the aromatic graft polymer of 1 wt% or more is dissolved in one kind of two kinds of solvents at 25°C.
When two or more kinds of solvents are contained in the solution, it is preferable that the weight of a solvent having the highest boiling point is 40 to 90 wt% of the weight of all solvents in the solution in view of viscosity and film-forming property, and more preferably 50 to 90 wt%, and still more preferably 65 to 85 wt%.

The solution may contain one kind or two kinds or more of the aromatic graft polymers of the present invention,

and may contain polymeric compounds other than the aromatic graft polymer of the present invention in a range where device property or the like is not impaired.

The solution of the present invention may contain water, metals and salts thereof in a range of 1 to 1000 ppm. As the metals, lithium, sodium, calcium, potassium, iron, copper, nickel, aluminum, zinc, chromium, manganese, cobalt, platinum, and iridium or the like are specifically exemplified. The solution may contain silicon, phosphorus, fluoride, chlorine, and bromine in a range of 1 to 1000 ppm.

A thin film can be produced by a spin coating method, a casting method, a micro gravure coating method, a gravure coating method, a bar coating method, a roll coating method, a wire bar coating method, a dip coating method, a spray coating method, a screen printing method, a flexo printing method, an offset printing method and an inkjet printing method or the like using the solution of the present invention. Of these, the solution of the present invention is preferably used for film-forming use by a screen printing method, a flexo printing method, an offset printing method, and an inkjet printing method. The solution is more preferably used for film-forming use by the ink-jet method.

Among the printing methods, the ink-jet method is more preferable for pattern forming or multicolor coating a thin film of 1 $\mu$m or less, and the screen printing method, flexo printing method, offset printing method, or gravure printing method is preferable in view of productivity or cost for pattern forming or multicolor coating a thin film of 1 $\mu$m or more.

As the thin films capable of produced by using the solution of the present invention, a light emitting thin film, a conductive thin film, and an organic semiconductor thin film are exemplified.

It is preferable that the conductive thin film of the present invention has a surface resistance of 1 K$\Omega$/ square or less. The electric conductivity of the thin film can be enhanced by doping Lewis acid and an ionic compound or the like into the thin film. The surface resistance is more preferably 100 $\Omega$/square or less, and still more preferably 10 $\Omega$/square or more.

Regarding the organic semiconductor thin film of the present invention, larger one of electron mobility, or hole mobility is preferably $10^{-5}$cm$^2$/V/second or more, more preferably $10^{-3}$cm$^2$/V/second, and still more preferably $10^{-1}$ cm$^2$/V/second. The organic semiconductor thin film is formed on an Si substrate on which an insulating film made of $SiO_2$ or the like and a gate electrode are formed. A sauce electrode and a drain electrode are formed of Au or the like, and thereby an organic transistor can be formed.

Regarding the polymer light emitting device of the present invention, the maximum external quantum yield is preferably 1% or more when a voltage of 3.5 V or more is applied between an anode and a cathode in view of the luminance or the like of the device, and more preferably 1.5% or more.

As the polymer light emitting device of the present invention, there are listed a polymer light emitting device having an electron transporting layer provided between a cathode and a light emitting layer, a polymer light emitting device having a hole transporting layer provided between an anode and a light emitting layer, and a polymer light emitting device having an electron transporting layer provided between a cathode and a light emitting layer, and a hole transporting layer provided between an anode and a light emitting layer.

For example, the following structures of a)-d) are specifically exemplified.

a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode (wherein, "/" indicates adjacent lamination of layers. Hereinafter, the same).

Regarding each of these structures, a structure in which an interlayer is adjacently provided to the light emitting layer between the light emitting layer and the anode is also exemplified. That is, the following structures a')-d') are exemplified.

a') anode/interlayer/light emitting layer/cathode
b') anode/hole transporting layer/interlayer/light emitting layer/cathode
c') anode/interlayer/light emitting layer/electron transporting layer/cathode
d') anode/hole transporting layer/interlayer/light emitting layer/electron transporting layer/cathode

When the polymer light emitting device of the present invention has a hole transporting layer, as the hole transporting materials used, there are exemplified polyvinylcarbazole or derivatives thereof, polysilane or derivatives thereof, polysiloxane derivatives having an aromatic amine in the side chain or the main chain, pyrazoline derivatives, arylamine derivatives, stilbene derivatives, triphenyldiamine derivatives, polyaniline or derivatives thereof, polythiophene or derivatives thereof, polypyrrole or derivatives thereof, poly(p-phenylenevinylene) or derivatives thereof, ad poly(2,5-thienylenevinylene) or derivatives thereof, or the like.

Specifically, as the hole transporting materials, there are exemplified those described in JP-A-63-70257, 63-175860, 2-135359, 2-135361, 2-209988, 3-37992 and 3-152184.

Among them, as the hole transporting materials used in the hole transporting layer, preferable are polymer hole transporting materials such as polyvinylcarbazole or derivatives thereof, polysilane or derivatives thereof, polysiloxane derivatives having an aromatic amine compound group in the side chain or the main chain, polyaniline or derivatives thereof, polythiophene or derivatives thereof, poly(p-phenylenevinylene) or derivatives thereof, and poly(2,5-thienylenevinylene) or derivatives thereof, and further preferable are polyvinylcarbazole or derivatives thereof, polysilane or derivatives thereof, and polysiloxane derivatives having an aromatic amine compound group in the side chain or the main chain.

As the hole transporting materials having a low molecular compound, there are exemplified pyrazoline derivatives, arylamine derivatives, stilbene derivatives and triphenyldiamine derivatives. In the case of a hole transporting material having lower molecular weight, it is preferably dispersed in a polymer binder for use.

The polymer binder to be mixed is preferably that which does not extremely disturb a charge transporting property, and that does not have strong absorption of a visible light is suitably used. As such polymer binder, poly(N-vinylcarbazole), polyaniline or derivatives thereof, polythiophene or derivatives thereof, poly(p-phenylene vinylene) or derivatives thereof, poly(2,5-thienylene vinylene) or derivatives thereof, polycarbonate, polyacrylate, polymethyl acrylate, polymethyl methacrylate, polystyrene, polyvinyl chloride, polysiloxane or the like are exemplified.

Polyvinylcarbazole or derivative thereof can be obtained, for example, by cation polymerization or radical polymerization of a vinyl monomer.

As the polysilane or derivatives thereof, there are exemplified compounds described in Chem. Rev., 89, 1359 (1989) and GB 2300196 published specification, or the like. For synthesis, methods described in them can be used, and a Kipping method can be suitably used particularly.

As the polysiloxane or derivatives thereof, those having the structure of the hole transporting material having lower molecular weight in the side chain or main chain are appropriately used, since the siloxane skeleton structure has poor hole transporting property. Particularly, there are exemplified those having an aromatic amine having hole transporting property in the side chain or main chain.

The method for forming a hole transporting layer is not limited, and in the case of a hole transporting layer having lower molecular weight, a method in which the layer is formed from a mixed solution with a polymer binder is exemplified. In the case of a polymer hole transporting material, a method in which the layer is formed from a solution is exemplified.

It is preferable that the solvent used for the film forming from a solution can dissolve or uniformly disperse a hole transporting material.

As the solvents, there are exemplified chlorine solvents such as chloroform, methylene chloride, 1,2-dichloroethane, 1,1,2-trichloroethane, chlorobenzene and o-dichlorobenzene, ether solvents such as tetrahydrofuran, dioxane and anisole, aromatic hydrocarbon solvents such as toluene and xylene, aliphatic hydrocarbon solvents such as cyclohexane, methylcyclohexane, n-pentane, n-hexane, n-heptane, n-octane, n-nonane and n-decane, ketone solvents such as acetone, methyl ethyl ketone, cyclohexanone, benzophenone and acetophenone, ester solvents such as ethyl acetate, butyl acetate, ethylcellosolve acetate, methyl benzoate and phenyl acetate, and polyhydric alcohols and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin, 1,2-hexanediol, alcoholic solvents such as methanol, ethanol, propanol, isopropanol and cyclohexanol, sulfoxide solvents such as dimethyl sulfoxide, and amide solvents such as N-methyl-2-pyrolidone and N,N-dimethylformamide. These organic solvents may be used singly or in combination.

As the film forming method from a solution, there can be used coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.

Regarding the thickness of the hole transporting layer, the optimum value differs depending on material used, and may properly be selected so that the driving voltage and the light emitting efficiency become moderate values, and at least a thickness at which no pin hole is produced is necessary, and too large thickness is not preferable since the driving voltage of the device increases. Therefore; the thickness of the hole transporting layer is, for example, 1 nm to 1 $\mu$m, preferably 2 nm to 500 nm, and more preferably 5 nm to 200 nm.

When the polymer light emitting device of the present invention has an electron transporting layer, known compounds are used as the electron transporting materials, and there are exemplified oxadiazole derivatives, anthraquinonedimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof, and polyfluorene or derivatives thereof, or the like.

Specifically, there are exemplified those described in JP-A-63-70257, 63-175860, 2-135359, 2-135361, 2-209988, 3-37992 and 3-152184.

Among them, oxadiazole derivatives, benzoquinone or derivatives thereof, anthraquinone or derivatives thereof, or metal complexes of 8-hydroxyquinoline or derivatives thereof, polyquinoline or derivatives thereof, polyquinoxaline or derivatives thereof, polyfluorene or derivatives thereof are preferable, and 2-(4-biphenyl)-5-(4-t-butylphenyl)-1,3,4-oxadiazole, benzoquinone, anthraquinone, tris(8-quinolinol)aluminum and polyquinoline are further preferable.
The method for forming the electron transporting layer is not particularly limited. In the case of an electron transporting material having lower molecular weight, a vapor deposition method from a powder, or a method of film-forming from a solution or melted state is exemplified, and in the case of a polymer electron transporting material, a method of film-forming from a solution or molten state is exemplified, respectively. At the time of film-forming from a solution or molten state, the polymer binder can be used together.
It is preferable that the solvent used in the film-forming from a solution can dissolve or uniformly disperse electron transporting materials and/or polymer binders. As the solvent, there are exemplified chlorine solvents such as chloroform, methylene chloride, 1,2-dichloroethane, 1,1,2-trichloroethane, chlorobenzene, o-dichlorobenzene, ether solvents such as tetrahydrofuran, dioxane and anisole, aromatic hydrocarbon solvents such as toluene and xylene, aliphatic hydrocarbon solvents such as cyclohexane, methylcyclohexane, n-pentane, n-hexane, n-heptane, n-octane, n-nonane and n-decane, ketone solvents such as acetone, methyl ethyl ketone, cyclohexanone, benzophenone and acetophenone, ester solvents such as ethyl acetate, butyl acetate, ethylcellosolve acetate, methyl benzoate and phenyl acetate, polyhydric alcohols and derivatives thereof such as ethylene glycol, diethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, alcoholic solvents such as methanol, ethanol, propanol, isopropanol and cyclohexanol, sulfoxide solvents such as dimethyl sulfoxide, and amide solvents such as N-methyl-2-pyrrolidone and N,N-dimethylformamide. These organic solvents may be used singly or in combination.
As the film-forming method from a solution or melted state, there can be used coating methods such as a spin coating method, casting method, micro gravure coating method, gravure coating method, bar coating method, roll coating method, wire bar coating method, dip coating method, spray coating method, screen printing method, flexo printing method, offset printing method, and inkjet printing method.
Regarding the thickness of the electron transporting layer, the optimum value differs depending on material used, and may be selected so that the driving voltage and the light-emitting efficiency become moderate values. At least a thickness at which no pin hole is produced is necessary, and too large thickness is not preferable since the driving voltage of the device increases. Therefore, the thickness of the electron transporting layer is, for example, 1 nm to 1 μm, preferably 2 nm to 500 nm, and more preferably 5 nm to 200 nm.

Among the charge transporting layers which are adjacently provided to the electrode, particularly, that having a function for improving charge injection efficiency from the electrode and having an effect for lowering the driving voltage of the device may be generally referred to as a charge injecting layer (hole injecting layer, electron injecting layer).
Further, for the improvement of adhesion and charge injection from the electrode, the charge injecting layer or an insulating layer having a film thickness of 2 nm or less may be adjacently provided to the electrode, and for the improvement of adhesion of the interface and prevention of mixing, a thin buffer layer may be inserted into the interface of a charge transporting layer and a light emitting layer.
The order and number of layers laminated and the thickness of each layer can be appropriately used while considering light-emitting efficiency and life of the device.
In the present invention, as the polymer light emitting device having a charge injecting layer (electron injecting layer, hole injecting layer) provided, there are listed a polymer light emitting device having a charge injecting layer adjacently provided to a cathode and a polymer light emitting device having a charge injecting layer adjacently provided to an anode.
For example, the following structures e) to p) are specifically exemplified.

e) anode/charge injecting layer/light emitting layer/cathode
f) anode/light emitting layer/charge injecting layer/cathode
g) anode/charge injecting layer/light emitting layer/charge injecting layer/cathode
h) anode/charge injecting layer/hole transporting layer/light emitting layer/cathode
i) anode/hole transporting layer/light emitting layer/charge injecting layer/cathode
j) anode/charge injecting layer/hole transporting layer/light emitting layer/charge injecting layer/cathode
k) anode/charge injecting layer/light emitting layer/electron transporting layer/cathode
1) anode/light emitting layer/electron transporting layer/charge injecting layer/cathode
m) anode/charge injecting layer/light emitting layer/electron transporting layer/charge injecting layer/cathode
n) anode/charge injecting layer/hole transporting layer/light emitting layer/electron transporting layer/cathode
o) anode/hole transporting layer/light emitting layer/electron transporting layer/charge injecting layer/cathode
p) anode/charge injecting layer/hole transporting layer/light emitting layer/electron transporting layer/charge injecting layer/cathode

Regarding each of these structures, a structure where an interlayer is adjacently provided to the light emitting layer between the light emitting layer and the anode is also exemplified. In this case, the interlayer may double as the hole

injecting layer and/or the hole transporting layer.

As the specific examples of the charge injecting layer, there are exemplified layers containing a conducting polymer, layers which are provided between an anode and a hole transporting layer and contain a material having an intermediate ionization potential between the ionization potential of an anode material and the ionization potential of a hole transporting material contained in the hole transporting layer, and layers which are provided between a cathode and an electron transporting layer and contain a material having an intermediate electron affinity between the electron affinity of a cathode material and the electron affinity of an electron transporting material contained in the electron transporting layer, or the like.

When the charge injecting layer is a layer containing a conducting polymer, the electric conductivity of the conducting polymer is preferably $10^{-5}$ S/cm or more and $10^3$ S/cm or less, and for decreasing the leak current between light emitting pixels, more preferably $10^{-5}$ S/cm or more and $10^2$ S/cm or less, more preferably $10^{-5}$ S/cm or more and $10^1$ S/cm or less.

When the charge injecting layer is a layer containing a conducting polymer, the electric conductivity of the conducting polymer is preferably $10^{-5}$ S/cm or more and $10^3$ S/cm or less, and for decreasing the leak current between light emitting pixels, more preferably $10^{-5}$ S/cm or more and $10^2$ S/cm or less, more preferably $10^{-5}$ S/cm or more and $10^1$ S/cm or less.

Usually, to provide the electric conductivity of the conducting polymer of $10^{-5}$ S/cm or more and $10^3$ S/cm or less, a suitable amount of ions are doped into the conducting polymer.

Regarding the kind of an ion doped, an anion is used in a hole injecting layer and a cation is used in an electron injecting layer. As examples of the anion, a polystyrene sulfonate ion, alkylbenzene sulfonate ion, camphor sulfonate ion or the like are exemplified, and as examples of the cation, a lithium ion, sodium ion, potassium ion, tetrabutyl ammonium ion or the like are exemplified.

The thickness of the charge injecting layer is, for example, 1 nm to 100 nm, and preferably 2 nm to 50 nm.

Materials used in the charge injecting layer may be properly selected in view of relation with the materials of electrode and adjacent layers, and there are exemplified conducting polymers such as polyaniline and derivatives thereof, polythiophene and derivatives thereof, polypyrrole and derivatives thereof, polyphenylene vinylene and derivatives thereof, polythienylene vinylene and derivatives thereof, polyquinoline and derivatives thereof, polyquinoxaline and derivatives thereof, polymers containing aromatic amine structures in the main chain or the side chain, or the like, metal phthalocyanine (copper phthalocyanine or the like), and carbon or the like.

The insulating layer having a thickness of 2 nm or less has function to make charge injection easy. As the material of the insulating layer, metal fluoride, metal oxide, organic insulation materials or the like are listed. As the polymer light emitting device having an insulating layer having a thickness of 2 nm or less, there are listed polymer light emitting devices having an insulating layer adjacently provided to a cathode and having a thickness of 2 nm or less, and polymer light emitting devices having an insulating layer adjacently provided to an anode and having a thickness of 2 nm or less.

Specifically, there are listed the following structures q) to ab) for example.

q) anode/insulating layer having a thickness of 2 nm or less/light emitting layer/cathode
r) anode/light emitting layer/insulating layer having a thickness of 2 nm or less/cathode
s) anode/insulating layer having a thickness of 2 nm or less/light emitting layer/insulating layer having a thickness of 2 nm or less/cathode
t) anode/insulating layer having a thickness of 2 nm or less/hole transporting layer/light emitting layer/cathode
u) anode/hole transporting layer/light emitting layer/insulating layer having a thickness of 2 nm or less/cathode
v) anode/insulating layer having a thickness of 2 nm or less/hole transporting layer/light emitting layer/insulating layer having a thickness of 2 nm or less/cathode
w) anode/insulating layer having a thickness of 2 nm or less/light emitting layer/electron transporting layer/cathode
x) anode/light emitting layer/electron transporting layer/insulating layer having a thickness of 2 nm or less/cathode
y) anode/insulating layer having a thickness of 2 nm or less/light emitting layer/electron transporting layer/insulating layer having a thickness of 2 nm or less/cathode
z) anode/insulating layer having a thickness of 2 nm or less/hole transporting layer/light emitting layer/electron transporting layer/cathode
aa) anode/hole transporting layer/light emitting layer/electron transporting layer/insulating layer having a thickness of 2 nm or less/cathode
ab) anode/insulating layer having a thickness of 2 nm or less/hole transporting layer/light emitting layer/electron transporting layer/insulating layer having a thickness of 2 nm or less/cathode

Regarding each of these structures, a structure where an interlayer is adjacently provided to the light emitting layer between the light emitting layer and the anode is also exemplified. In this case, the interlayer may also serve as the hole injecting layer and/or the hole transporting layer.

Regarding a structure where the interlayer is applied to the structures a)-ab), it is preferable that the interlayer

is made of a material which is provided between an anode and a light emitting layer and has an intermediate ionization potential between the ionization potential of an anode, a hole injecting layer, or a hole transporting layer, and the ionization potential of a polymeric compound constituting a light emitting layer.
As the materials used for the interlayer, there are exemplified polyvinylcarbazole or derivatives thereof, polyarylene derivatives having an aromatic amine in a side chain or a main chain, and a polymer containing an aromatic amine such as arylamine derivatives and triphenyldiamine derivatives.
The method for film-forming the interlayer is not particularly limited. For example, when the polymeric material is used, a method in which the layer is formed from a solution is exemplified.
As the solvents used for forming the film from the solution, those capable of dissolving and uniformly dispersing a material used for the interlayer are preferable. As the solvents, there are exemplified chlorine solvents such as chloroform, methylene chloride, 1,2-dichloroethane, 1,1,2-trichloroethane, chlorobenzene and o-dichlorobenzene, ether solvents such as tetrahydrofuran, dioxane and anisole, aromatic hydrocarbon solvents such as toluene and xylene, aliphatic hydrocarbon solvents such as cyclohexane, methylcyclohexane, n-pentane, n-hexane and n-heptane, n-octane, n-nonane and n-decane, ketone solvents such as acetone, methyl ethyl ketone, cyclohexanone, benzophenone and acetophenone, ester solvents such as ethyl acetate, butyl acetate, ethylcellosolve acetate, methyl benzoate and phenyl acetate, polyhydric alcohol and derivatives thereof such as ethylene glycol, ethylene glycol monobutyl ether, ethylene glycol monoethyl ether, ethylene glycol monomethyl ether, dimethoxyethane, propylene glycol, diethoxymethane, triethylene glycol monoethyl ether, glycerin and 1,2-hexanediol, alcoholic solvents such as methanol, ethanol, propanol, isopropanol and cyclohexanol, sulfoxide solvents such as dimethyl sulfoxide, and amide solvents such as N-methyl-2-pyrrolidone and N,N-dimethylformamide. These organic solvents may be used singly or in combination.
As methods for forming a film from a solution, there can be used applying methods such as a spin coating method from a solution, casting method, micro gravure coating method, gravure coating method, bar coating method, roll coating method, wire bar coating method, dip coating method, spray coating method, screen printing method, flexo printing method, offset printing method, and inkjet printing method.
As the thickness of the interlayer, the optimum value differs depending on material used, and may be selected so that the driving voltage and the light-emitting efficiency become moderate values. For example, it is 1 nm to 1 μm, preferably 2 nm to 500 nm, and more preferably 5 nm to 200 nm.
When the interlayer is adjacently provided to the light emitting layer, and particularly both the layers are formed by the applying method, the mixing of the materials of two layers may have undesirable influence on the property or the like of the device. When the interlayer is formed by the applying method and the light emitting layer is formed by the applying method, as the method for reducing the mixing of the materials of two layers, there is exemplified a method for forming an interlayer by the applying method, heating the interlayer to make the heated interlayer insoluble in an organic solvent used for producing a light emitting layer, and forming the light emitting layer. The heating temperature is usually about 150°C to 300°C, and the time is usually about 1 minute to 1 hour. In this case, the interlayer can be rinsed and removed by a solvent used for forming the light emitting layer after heating and before forming the light emitting layer in order to remove components which were not insoluble in the solvent by heating. When the insolubilization of the solvent by heating is sufficiently carried out, the rinse using the solvent can be removed. It is preferable that the polymeric compound used for the interlayer contains at least one polymerizable group in the molecule for sufficiently carrying out the insolubilization of the solvent by heating. It is preferable that the number of groups capable of being polymerized is 5% or more to the number of the repeating units in the molecule.

The substrate forming the polymer light emitting device of the present invention may preferably be that does not change in forming an electrode and layers of organic materials, and there are exemplified glass, plastics, polymer film, silicon substrates or the like. In the case of an opaque substrate, it is preferable that the opposite electrode is transparent or semitransparent.
Usually, at least one of an anode and cathode of the polymer light emitting device of the present invention is transparent or semitransparent. It is preferable that the anode is transparent or semitransparent.

As the material of the anode, conductive metal oxide films, semitransparent metal thin films or the like are used. Specifically, there are used indium oxide, zinc oxide, tin oxide, films (NESA or the like) fabricated by using a conductive glass composed of indium/tin oxide (ITO), indium/zinc oxide or the like, which are metal oxide complexes, and gold, platinum, silver, copper or the like are used. Among them, ITO, indium/zinc oxide, tin oxide are preferable. As the fabricating method, a vacuum vapor deposition method, sputtering method, ion plating method, plating method or the like are exemplified. As the anode, there may be also used organic transparent conducting films such as polyaniline or derivatives thereof, polythiophene or derivatives thereof or the like.
The thickness of the anode can be appropriately selected while considering transmission of a light and an electric conductivity, and for example, 10 nm to 10 μm, preferably 20 nm to 1 μm, more preferably 50 nm to 500 nm.
Further, for easy charge injection, there may be provided on the anode a layer comprising a phthalocyanine derivative, conducting polymers, carbon or the like, or a layer comprising a metal oxide, metal fluoride, and organic insulating material or the like and having an average film thickness of 2 nm or less.

As the material of a cathode used in the polymer light emitting device of the present invention, that having lower work function is preferable. For example, there are used metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium or the like, or alloys comprising two of more of them, or alloys comprising one or more of them and one or more of gold, silver, platinum, copper, manganese, titanium, cobalt, nickel, tungsten and tin, graphite or graphite intercalation compounds or the like. Examples of alloys include a magnesium-silver alloy, magnesium-indium alloy, magnesium-aluminum alloy, indium-silver alloy, lithium-aluminum alloy, lithium-magnesium alloy, lithium-indium alloy, calcium-aluminum alloy or the like. The cathode may be formed into a laminated structure of two or more layers.

The thickness of the cathode can be appropriately selected while considering electric conductivity and durability, and for example, 10 nm to 10 μm, preferably 20 nm to 1 μm, further preferably 50 nm to 500 nm.

As the method for fabricating a cathode, there are used a vacuum vapor deposition method, sputtering method, lamination method in which a metal thin film is adhered under heat and pressure, or the like. Further, there may also be provided between a cathode and an organic layer, a layer comprising a conducting polymer, or a layer having an average film thickness of 2 nm or less comprising a metal oxide, metal fluoride, organic insulating material or the like. After fabrication of the cathode, a protective layer may also be provided which protects the polymer LED. For stable use of the polymer light emitting device for a long period of time, it is preferable to provide a protective layer and/or protective cover for protection of the device from outside.

As the protective layer, there can be used a polymeric compound, metal oxide, metal fluoride, metal borate or the like. As the protective cover, there can be used a metal plate, a glass plate, plastic plate having a surface subjected to lower-water-permeation treatment, or the like. There is suitably used a method in which the cover is pasted with a device substrate by a thermosetting resin or light-curing resin for sealing. If space is maintained using a spacer, it is easy to prevent a device from being injured. If an inert gas such as nitrogen and argon is sealed in this space, it is possible to prevent oxidation of a cathode, and further, by placing a desiccant such as barium oxide in the space, it is easy to suppress the damage of a device by moisture adhered in the production process or a small amount of moisture passing through a cured resin. Among them, any one or more means are preferably adopted.

The polymer light emitting device of the present invention can be used for a flat light source, a segment display device, a dot matrix display device, and a liquid crystal display device as a back light.

For obtaining light emission in plane form using the polymer light emitting device of the present invention, an anode and a cathode in the plane form may be placed so that they are laminated each other. Further, for obtaining light emission in pattern form, there is a method in which a mask with a window in pattern form is placed on the plane light emitting device, a method in which an organic layer in non-light emission part is formed to obtain extremely large thickness providing substantial non-light emission, and a method in which any one of an anode or a cathode, or both of them are formed in the pattern. By forming a pattern by any of these methods and by placing some electrodes so that independent on/off is possible, there is obtained a display device of segment type which can display digits, letters, simple marks or the like. Further, for forming a dot matrix device, anodes and cathodes may be made in the form of stripes and placed so that they cross at right angles. By a method in which a plurality of kinds of polymeric fluorescence substances emitting different colors of lights are placed separately or a method in which a color filter or fluorescent converting filter is used, area color displays and multi color displays can be obtained. A dot matrix display device can be driven by passive driving, or by active driving combined with TFT or the like. These display devices can be used as a display device such as a computer, television, portable terminal, portable telephone, car navigation, and view finder of a video camera.

Further, the light emitting device in plane form is a thin self-light-emitting one, and can be appropriately used as a flat light source for backlight of a liquid crystal display device, or as a flat light source for illumination. Further, if a flexible plate is used, it can be also used as a curved light source or a display device.

Hereinafter, the following examples will illustrate the present invention further in detail, but the present invention is not limited thereto.

(Number Average Molecular Weight and Weight Average Molecular Weight)

Here, the number average molecular weight (Mn), weight average molecular weight (Mw) and peak top molecular weight (Mp) were determined as the number average molecular weight (Mn), weight average molecular weight (Mw) and peak top molecular weight (Mp) in terms of polystyrene by GPC.

<GPC Analysis Method A> Analysis carried out by GPC (LC-10Avp (product name) manufactured by Shimadzu Corporation) using a column system consisting of two TSKgel SuperHM-H (product name, manufactured by Tosoh Corporation) columns connected in series to a SuperH2000 (product name, manufactured by Tosoh Corporation) column with tetrahydrofuran as the developing solvent at a flow rate of 0.6 mL/min at 40°C. A differential refractive index detector (RID-10A (product name), manufactured by Shimadzu Corporation) was used as the detector.

<GPC Analysis Method B> Analysis carried out by the PL-GPC210 System (product name) manufactured by Polymer

Laboratories Ltd. (RI detection), using a column consisting of three PLgel 10 μm MIXED-B (product name) columns manufactured by Polymer Laboratories Ltd., with o-dichlorobenzene (0.01% 2,6-di-t-butyl-4-methylphenol w/v content) as the developing solvent at 70°C.

<GPC Analysis Method C> Analysis carried out by the HLC-8220GPC System (product name) manufactured by Tosoh Corporation (RI detection) using a column consisting of three TSKgel SuperHM-H (product name, manufactured by Tosoh Corporation) columns directly connected together with tetrahydrofuran as the developing solvent at a flow rate of 0.5 mL/min at 40°C. A differential refractive index detector was used as the detector.

(HPLC Analysis)

Analyzer: LC-10AVp (product name) manufactured by Shimadzu Corporation
Analysis Conditions: L-Column ODS (product name), 5 μm, 2.1 × 150 mm;
A Liquid: Acetonitrile; B Liquid: THF
Gradient
B Liquid: 0% → (60 min.) → 0% → (10 min.) → 100% → (10 min.) → 100%,
Sample Concentration: 5.0 mg/mL (THF solution),
Charged Amount: 1 μL
Detection Wavelength: 254 nm

(NMR Analysis)

NMR analysis was carried out at room temperature using the INOVA 300 nuclear magnetic resonance apparatus manufactured by Varian Inc. with a deuterated tetrahydrofuran solution as the polymer.

Synthesis Example 1

<Synthesis of Polymer 1: Condensation polymerization of 2,7-dibromo-9,9-di-n-octylfluorene and 2,7-dibromo-9,9-bis (3-methylbutyl)fluorene>

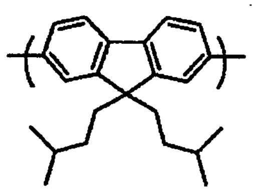

(P-1)

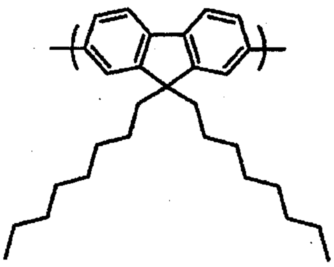

(P-2)

26.3 g of 2,7-dibromo-9,9-di-n-octylfluorene (48.0 mmol), 5.6 g of 2,7-dibromo-9,9-bis(3-methylbutyl)fluorene (12.0 mmol) and 22 g of 2,2'-bipyridyl (14.1 mmol) were dissolved in 1,600 mL of anhydrous tetrahydrofuran. Nitrogen was then bubbled therein to purge the system with nitrogen. Under a nitrogen atmosphere, the solution was charged with bis(1,5-cyclooctadiene)nickel(0){$Ni(COD)_2$} (40.66 g (147.8 mmol)). The temperature was increased to 60°C, and the solution was reacted for 8 hours while stirring. After the reaction, the reaction solution was cooled to room temperature (about 25°C). The solution was then added dropwise to a mixed solution of 1,200 mL of 25% ammonia water, 1,200 mL of methanol and 1,200 mL of deionized water, and the resultant solution was stirred for 0.5 hours. The formed precipitate was then filtered off and dried for 2 hours under reduced pressure. Then, resultant product was dissolved in 1,110 mL of toluene, and then the solution was filtered. The filtrate was charged with toluene to obtain a solution of about 2,800 mL. The organic layer was then washed for 1 hour with 2,000 mL of 1 N aqueous hydrochloric acid, for 1 hour with 2,200 mL of 4% ammonium water, for 10 minutes with 1,000 mL of deionized water and for another 10 minutes with 1,000 mL of deionized water. The organic layer was concentrated under reduced pressure at 50°C to 592 g, and then added dropwise to 3,330 mL of methanol. The resultant solution was stirred for 0.5 hours. The formed precipitate was filtered

off, washed twice with 500 mL of methanol and then dried under reduced pressure for 5 hours at 50°C. The yield amount of the obtained copolymer was 12.6 g. This copolymer shall be referred to as "polymer 1". The number average molecular weight and weight average molecular weight in terms of polystyrene were respectively Mn = $8.7 \times 10^4$ and Mw = $1.8 \times 10^5$ (GPC analysis method B). In polymer 1, the ratio of the 9,9-di-n-octylfluorene to the 9,9-bis(3-methylbutyl)fluorene repeating units was 80:20. $^1$H-NMR (300 MHz/$CDCl_3$): Integral value (protons derived from alkyl groups/protons derived from aryl groups) = 5.25.

Synthesis Example 2

<Synthesis of Polymer 2: Bromination of Polymer 1>

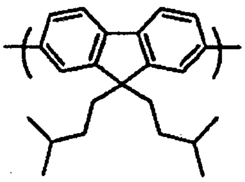
(P-1)

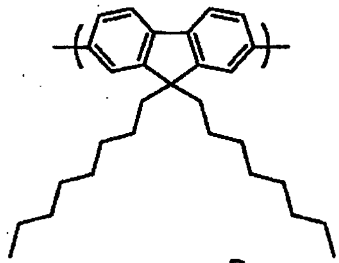
(P-2)

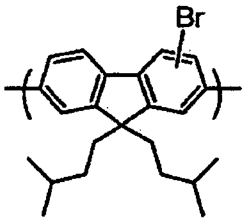
(P-3)

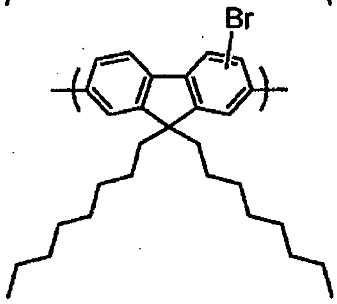
(P-4)

Under an argon gas atmosphere, polymer 1 (500 mg, 1.345 mmol in terms of fluorene repeating units) and 25 mL of chloroform were charged into a 50 mL flask, and the resultant solution was dissolved by stirring at room temperature. The solution was then successively charged with 2.07 mL of trifluoroacetic acid and 29.0 μL of bromine (0.57 mmol, 42 mole% of the benzofluorene units) and stirred for 16 hours under light-shielding. The reaction mass was added dropwise to 500 mL of methanol under stirring to cause a precipitate to form.

The obtained precipitate was filtered off, washed with methanol and dried under reduced pressure to obtain 526 mg of a polymer. The obtained polymer shall be referred to as "polymer 2". Polymer 2 had, in terms of polystyrene, a number average molecular weight of Mn = $8.4 \times 10^4$, weight average molecular weight of Mw = $1.8 \times 10^5$, peak top molecular weight of Mp = $1.5 \times 10^5$ and degree of dispersion of Mw/Mn = 2.1 (GPC Analysis Method B).

The results of elemental analysis showed that the ratio of repeating units having a Br group (Formula P-3, P-4) to repeating units without a Br group (Formula P-1, P-2) was {(P-1)+(P-2)}/{(P-3)+(P-4)} = 66/34, and that (total fluorene repeating units)/Br groups was 75/25.

Elemental Analysis Measurement Result: C 83.58%, H 9.38%, N <0.3%, Br 6.74%

Elemental Analysis Calculated Result: C 83.83%, H 9.43%, N 0%, Br 6.74% (values calculated by {(P-1)+(P-2)}/{(P-3}+(P-4)} = 66/34)

The results of $^1$H-NMR analysis showed that there was no change in the peak deriving from the protons of the alkyl group on the high magnetic field side, although there was a change in the peak deriving from the protons of the aryl group on the low magnetic field side. Further, there was a decrease in the integral ratio of the aryl group protons to alkyl group protons, thereby proving that Br groups had been introduced onto the aromatic ring moiety of the fluorene.

$^1$H-NMR (300 MHz/$CDCl_3$): δ 0.83 (bs), 1.16 (bs), 2.19 (bs), 7.3 to 9.3 (m), integral value (protons derived from alkyl groups/protons derived from aryl groups) = 5.65.

Synthesis Example 3

<Synthesis of N,N',N'-tri-(4-n-butylphenyl)-N-(4-(4,4,5,5-tetramethyl-[1,3,2]dioxaborolan-2-yl)phenyl)-1,1'-biphenyl-4,4'-diamine (Compound M-3)>

(Synthesis of Compound M-1)

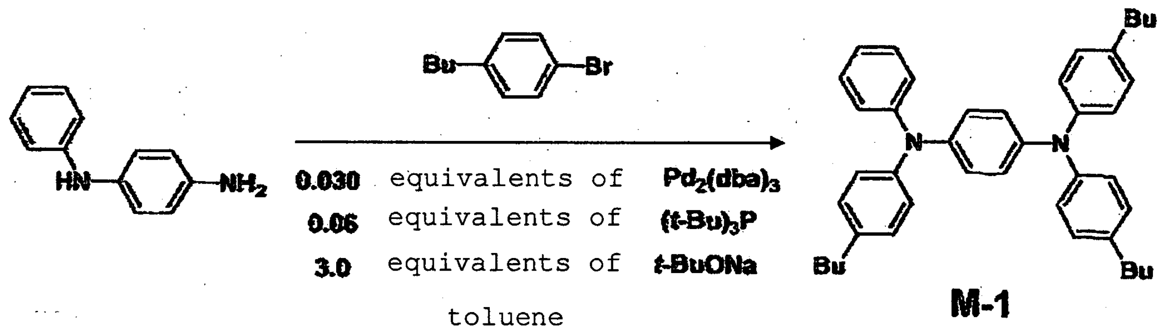


Under an argon atmosphere, N-phenyl-1,4-phenylenediamine (5.53 g, 30 mmol), 4-bromo-n-butylbenzene (25.57 g, 120 mmol), $Pd_2(dba)_3$ (820 mg, 0.9 mmol), t-BuONa (8.65 g, 90 mmol) and toluene (120 mL) were mixed in a 300 mL, 4-necked flask. The reaction solution was then charged with $(t\text{-}Bu)_3P$ (360 mg, 1.8 mmol), and then heated at 100°C for 3 hours. After cooling, the solution was charged with 200 mL of toluene, then washed with aqueous NaCl (100 mL × 3) and water (200 mL). The organic layer was dried over sodium sulfate, and then concentrated. The obtained liquid was purified by silica gel column chromatography (toluene:hexane = 1:3), and the resultant solution was then again purified by silica gel column chromatography (hexane → toluene:hexane = 1:3) to obtain 10.2 g of compound M-1.
$^1$H-NMR; δ0.97(9H,t), 1.37(6H,m), 1.58(6H,m), 2.55(6H,t), 6.85-7.07(18H,m), 7.17(2H,t).

(Synthesis of Compound M-2)

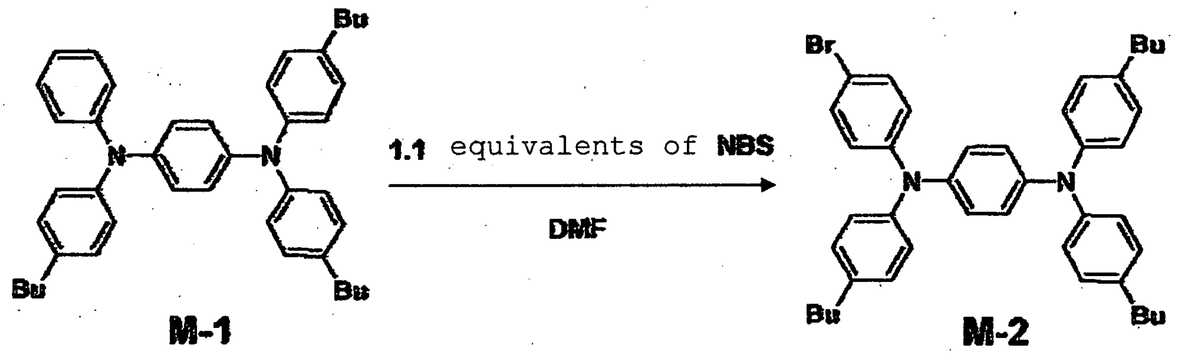


Under an argon atmosphere, compound M-1 (1.45 g, 2.5 mmol), NBS (0.49 g, 0.27 mmol) and DMF (20 mL) were mixed in a 100 mL, 4-necked flask, and the resultant solution was then stirred at 0°C for 4 hours. After the reaction had finished, the solution was charged with 100 mL of hexane, then washed with aqueous KCl (100 mL × 2) and water (100 mL × 2). The organic layer was dried over sodium sulfate, and then concentrated. The obtained liquid was twice purified by silica gel column chromatography (toluene:hexane = 1:6), to obtain 960 mg of compound M-2. LC-MS (APCI Method; m/z 660.2 ($[M+H]^+$)

(Synthesis of Compound M-3)

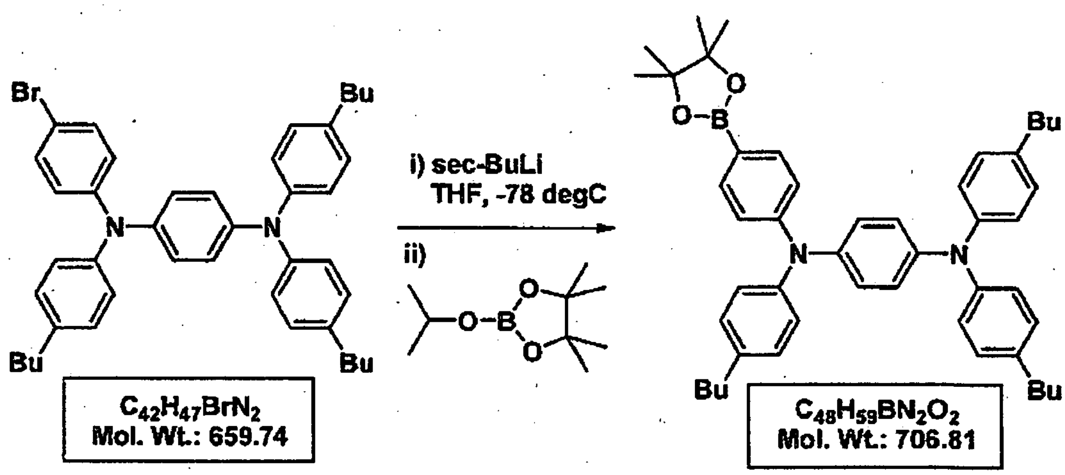


M-2

M-3

Under an argon atmosphere, compound M-2 (1.06 g, 1.6 mmol) and THF (10 mL) were mixed in a 200 mL, 4-necked flask, and the resultant solution was cooled to -78°C. Sec-BuLi (0.99 M hexane solution) (2 mL, 1.7 mmol) was then added dropwise over 20 minutes. The reaction solution was stirred for 3 hours at -78°C, and then IPA-pinacolato diboran (0.33 g, 1.7 mmol) was added dropwise. The temperature of the solution was increased to room temperature, and the solution was then stirred for 3 hours. After the reaction had finished, the solution was charged with toluene (50 mL), then washed with water (50 mL × 2). After silica gel flash column chromatography (toluene), concentration to dryness, and recrystallization from ethanol, the title product was obtained (720 mg, 64%).
$^1$H-NMR; δ0.94(9H,t), 1.29(12H,s), 1.34-1.41(6H,m), 1.58(6H,m), 2.56(6H,t), 6.96-7.10(18H,m), 7.55(2H,t).

Example 1

<Synthesis of Aromatic Graft Polymer 1>

Polymer 2 (300 mg, 0.742 mmol in terms of fluorene repeating units), compound M-3 (271 mg, 0.384 mmol), palladium(II) acetate (2.9 mg, 0.013 mmol) and tricyclohexylphosphine (7.07 mg, 0.025 mmol) were charged into a 200 mL flask. After the flask was purged with argon gas, 75 mL of commercially-available anhydrous toluene was charged into the flask, and the resultant solution was dissolved by stirring at room temperature. The temperature was increased to 110°C, and then the solution was charged with aqueous tetraethylammonium hydroxide (1.4 mol/L, 1.13 mL, 1.59 mmol). The solution was then stirred for 2.5 hours at 110°C. After cooling to room temperature, the solution was washed by charging with 60 mL of distilled water. The organic layer was concentrated and then dissolved in chloroform. This mixture was added dropwise to acetone to cause a precipitate to form. The obtained precipitate was filtered off, washed with acetone and then dried under reduced pressure to obtain 363 mg of a crude polymer (referred to as "crude polymer 1-1").
This crude polymer 1-1 (330 mg) was dissolved at room temperature in 60 mL of toluene, and the resultant solution was passed through a silica gel column and an alumina column through which toluene had been passed through in advance. The solution was then again washed with toluene, concentrated, and then dissolved in chloroform. This mixture was added dropwise to methanol to again cause a precipitate to form. The precipitate was filtered off, washed with methanol and then dried under reduced pressure to obtain 277 mg of a crude polymer (referred to as "crude polymer 1-2"). The obtained crude polymer 1-2 (239 mg) was dissolved in 15 mL of toluene, and the resultant solution was added dropwise to acetone (220 mL) to again cause a precipitate to form. The precipitate was filtered off, washed with acetone and then dried under reduced pressure to obtain 225 mg of a polymer.
This polymer shall be referred to as "aromatic graft polymer 1". Aromatic graft polymer 1 had, in terms of polystyrene, a number average molecular weight of Mn = 9.0 × $10^4$, weight average molecular weight of Mw = 2.0 × $10^5$, peak top molecular weight of Mp = 1.5 × $10^5$ and degree of dispersion of Mw/Mn = 2.3 (GPC Analysis Method B).

The results of elemental analysis showed that the ratio of repeating units (Formulae P-1 and P-2) to repeating units having a Br group (Formulae P-3 and P-4) to repeating units having a side chain (Formulae P-5 and P-6) was {(P-1)+(P-2)}/{(P-3)+(P-4)}/{(P-5)+(P-6)} = 83/0/17, and that the molar ratio of total fluorene repeating units to side chains, total fluorene/side chains, was 85/15.
Elemental Analysis Measurement Result: C 88.13%, H 9.52%, N 1.00%, Br<0.1%
Elemental Analysis Calculated Result: C 89.26%, H 9.74%, N 1.00%, Br 0% (value calculated by {(P-1)+(P-2)}/{(P-3)+(P-4)}/{(P-5)+(P-6)}=87/0/17)
In aromatic graft polymer 1, the parameters k and f, which in the present invention respectively represent the number of side chain repeating units and the length of the side chains, were k = 3 and f = 5.

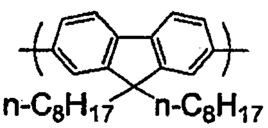
(P−1)

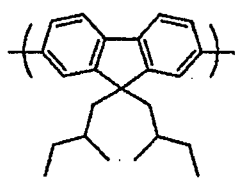
(P−2)

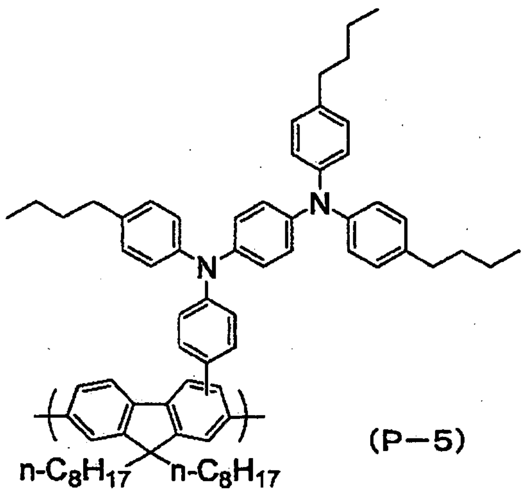
(P−5)

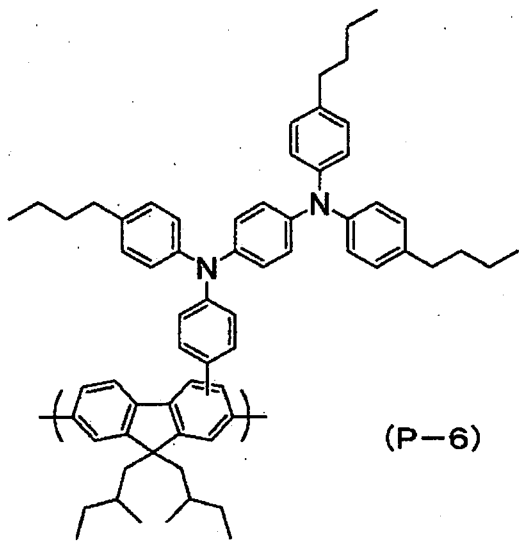
(P−6)

Synthesis Example 3

<Synthesis of Polymer 3: Bromination of Polymer 1>

Under an argon gas atmosphere, polymer 1 (2.00 g, 5.38 mmol in terms of fluorene repeating units) and 100 mL of chloroform were charged into a 200 mL flask, and the resultant solution was dissolved by stirring at room temperature. The solution was then successively charged with 8.3 mL of trifluoroacetic acid and 104 $\mu$L of bromine (2.05 mmol, 38 mole% of the fluorene repeating units) and stirred for 20 hours under light-shielding. The reaction mass was added dropwise to 500 mL of methanol under stirring to cause a precipitate to form. The obtained precipitate was filtered off, washed with methanol and dried under reduced pressure to obtain 2.17 g of a polymer. This polymer shall be referred to as "polymer 3". Polymer 3 had, in terms of polystyrene, a number average molecular weight of Mn = $9.2 \times 10^4$, weight average molecular weight of Mw = $1.7 \times 10^5$, peak top molecular weight of Mp = $1.4 \times 10^5$ and degree of dispersion of Mw/Mn = 1.90 (GPC Analysis Method C).
The results of elemental analysis showed that the ratio of repeating units having a Br group (Formula P-3, P-4) to repeating units without a Br group (Formula P-1, P-2) was {(P-1)+(P-2)}/{(P-3)+(P-4)} = 63/37, and that (total fluorene repeating units)/Br groups was 73/27.
Elemental Analysis Measurement Result: C 82.48%, H 9.25%, N <0.3%, Br 7.44%
Elemental Analysis Calculated Result: C 83.21%, H 9.35%, N 0%, Br 7.44% (values calculated by {(P-1)+(P-2)}/{(P-3)+(P-4)} = 63/37)

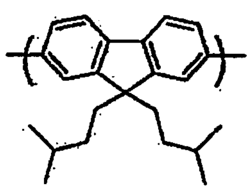

(P−1)

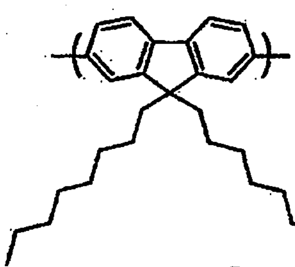

(P−2)

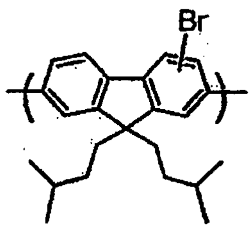

(P−3)

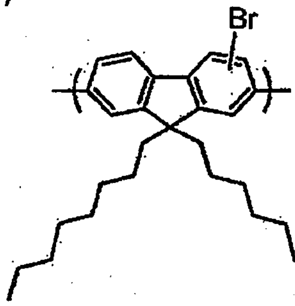

(P−4)

Example 2

<Synthesis of Aromatic Graft Polymer 2>

Polymer 3 (300 mg, 0.748 mmol in terms of fluorene repeating units), compound M-3 (96.2 mg, 0.136 mmol), palladium(II) acetate (0.65 mg, 0.0028 mmol) and tricyclohexylphosphine (1.6 mg, 0.0056 mmol) were charged into a 100 mL flask. After the flask was purged with argon gas, 72 mL of commercially-available anhydrous toluene was charged into the flask, and the resultant solution was dissolved by stirring at room temperature. The solution was charged with aqueous tetraethylammonium hydroxide (1.4 mol/L, 1.0 mL, 1.4 mmol), and then stirred for 3 hours at 110°C. The heating was temporarily stopped, and then the solution was charged with 196.3 mg of 4-(4,4,5,5-tetramethyl-[1,3,2]dioxaborolan-2-yl)butyltoluene, 0.65 mg of palladium(II) acetate, 1.64 mg of tricyclohexylphosphine and aqueous tetraethylammonium hydroxide (1.4 mol/L, 1.0 mL, 1.4 mmol). The temperature was again increased to 110°C, and the solution was stirred for 3 hours. After cooling to room temperature, the solution was diluted with 15 mL of toluene. The solution was removed and then washed twice with 18 mL of 15% brine. The obtained organic layer was passed through a filter which had been precoated with 3 g of Radiolite (manufactured by Showa Chemical Industry Co., Ltd.), and the filter was then washed with 18 mL of toluene. The obtained organic layer was concentrated and then added dropwise to acetone, to cause a precipitate to form. The obtained precipitate was filtered off, washed with acetone and then dried under reduced pressure to obtain 306 mg of a crude polymer.

305 mg of this crude polymer was dissolved at room temperature in 60 mL of toluene, and the resultant solution was passed through a silica gel column and an alumina column through which toluene had been passed through in advance. The solution was again washed with toluene, then washed with 3% ammonia water and distilled water twice, and concentrated under reduced pressure. The resultant solution was added dropwise to methanol to again form a precipitate. The precipitate was filtered off, washed with methanol and then dried under reduced pressure to obtain 270 mg of a polymer.

This polymer shall be referred to as "aromatic graft polymer 2". Aromatic graft polymer 2 had, in terms of polystyrene, a number average molecular weight of Mn = $9.6 \times 10^4$, weight average molecular weight of Mw = $1.8 \times 10^5$, peak top molecular weight of Mp = $1.4 \times 10^5$ and degree of dispersion of Mw/Mn = 1.9 (GPC Analysis Method C).

The results of elemental analysis showed that the ratio of repeating units (Formulae P-1 and P-2) to repeating units having a Br group (Formulae P-3 and P-4) to repeating units having a side chain (Formulae P-5 and P-6) was {(P-1)+(P-2)}/{(P-3)+(P-4)}/{(P-5)+(P-6)} = 90/0/10, and that the molar ratio of total fluorene repeating units to side chains, total fluorene/side chains, was 91/9.

Elemental Analysis Measurement Result: C 89.10%, H 9.83%, N 0.66%, Br < 0.1%

Elemental Analysis Calculated Result: C 88.51%, H 10.83%, N 0.66%, Br 0% (values calculated by {(P-1)+(P-2)}/{(P-3)+(P-4)}/{(P-5)+(P-6)} = 90/0/10)

In aromatic graft polymer 2, the parameters k and f, which in the present invention respectively represent the number of side chain repeating units and the length of the side chains, were k = 3 and f = 5.

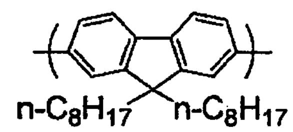

(P—1)

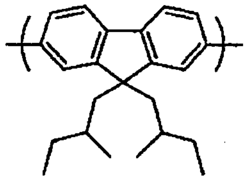

(P—2)

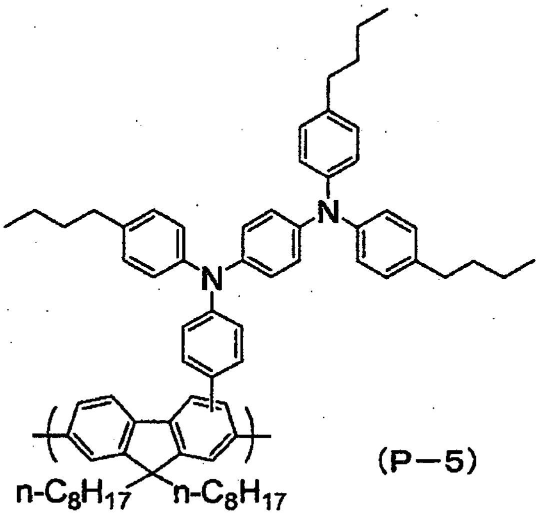

(P—5)

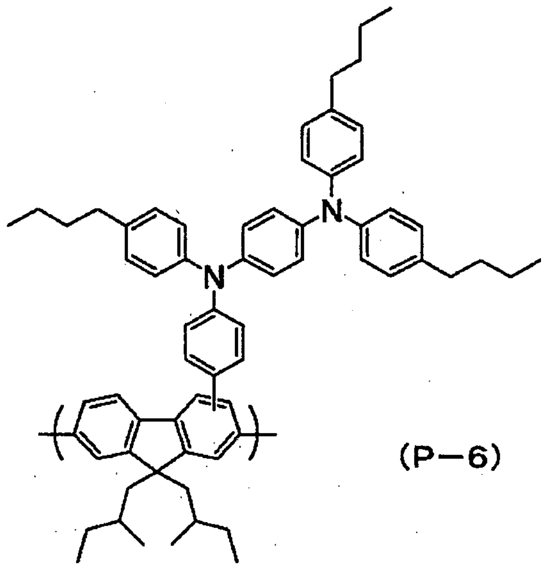

(P—6)

Synthesis Example 4

<Synthesis of Compound E and Compound G>

(Synthesis of Compound A)

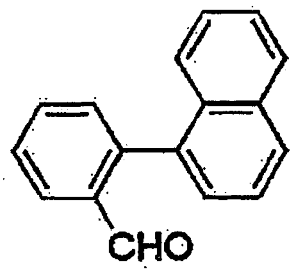

Compound A

Under an inert atmosphere, 5.00 g of 1-naphthaleneboronic acid (29 mmol), 6.46 g of 2-bromobenzaldehyde (35 mmol), 10.0 g of potassium carbonate (73 mmol), 36 mL of toluene and 36 mL of deionized water were charged into a 300 mL, three-necked flask, and the resultant solution was bubbled with argon for 20 minutes while being stirred at room temperature. Next, the solution was charged with 16.8 mg of tetrakis(triphenylphosphine)palladium (0.15 mmol) and then bubbled with argon for a further 10 minutes while being stirred at room temperature. The temperature of the solution was increased to 100°C, and then the solution reacted for 25 hours. After cooling to room temperature, the organic layer was extracted with toluene and then dried over sodium sulfate. The solvent was removed by distillation, and the resultant mixture was then purified by a silica gel column using a mixed solvent of toluene:cyclohexane = 1:2 as the developing

solvent to obtain 5.18 g of compound A (yield 86%) as white crystals.
$^1$H-NMR(300MHz/$CDCl_3$):
δ7.39~7.62(m,5H), 7.70(m,2H), 7.94(d,2H), 8.12(dd,2H), 9.63(s,1H)
MS(APCI(+)): $(M+H)^+$ 233

(Synthesis of Compound B)

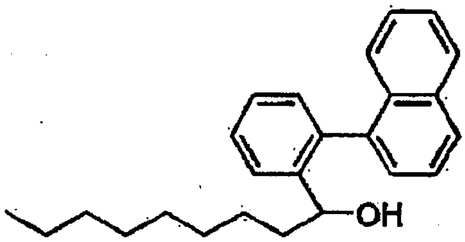

Compound B

Under an inert atmosphere, 8.00 g of compound A (34.4 mmol) synthesized in the same manner as described above and 46 mL of anhydrous THF were charged into a 300 mL, three-necked flask, and the resultant solution was cooled to -78°C. Next, 52 mL of n-octylmagnesium bromide (1.0 mol/L THF solution) was added dropwise over 30 minutes. After the addition, the temperature of the solution was then increased to 0°C. The solution was stirred for 1 hour, then the temperature of the solution was increased to room temperature, and the solution was stirred for 45 minutes. Under an ice bath, the solution was charged with 20 mL of 1 N hydrochloric acid to terminate the reaction. The organic layer was extracted with ethyl acetate and then dried over sodium sulfate. The solvent was removed by distillation, and the resultant mixture was then purified by a silica gel column using a mixed solvent of toluene:hexane= 10:1 as the developing solvent to obtain 7.64 g of compound B (yield 64%) as a pale yellow, oily substance. Although two peaks were observed under HPLC analysis, from the fact that these peaks had an identical mass number under LC-MS analysis, the substance was determined to be a mixture of isomers.

(Synthesis of Compound C)

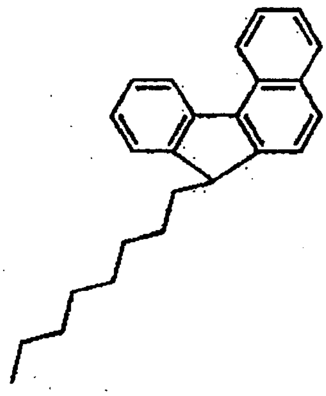

Compound C

Under an inert atmosphere, 5.00 g of compound B (mixture of isomers) (14.4 mmol) and 74 mL of anhydrous cyclohexane were charged into a 500 mL, three-necked flask, and the resultant solution was dissolved by stirring at room temperature. Next, an etherate complex of boron trifluoride was added dropwise over 1 hour, and after the addition, the resultant solution was stirred for 4 hours at room temperature. The solution was slowly charged with 125 mL of ethanol under stirring. After heat generation had abated, the organic layer was extracted with chloroform, washed with water twice and dried over magnesium sulfate. The solvent was removed by distillation, and the resultant mixture was then purified by

a silica gel column using hexane as the developing solvent to obtain 3.22 g of compound C (yield 68%) as a colorless oil.
$^1$H-NMR(300MHz/$CDCl_3$) :
δ0.90 (t, 3H), 1.03~1.26(m,14H), 2.13(m,2H), 4.05(t,1H), 7.35(dd, 1H), 7.46~7.50(m,2H), 7.59~7.65(m,3H), 7.82(d, 1H), 7.94(d, 1H), 8.35(d, 1H), 8.75(d, 1H)
MS(APCI(+)): $(M+H)^+$ 329

(Synthesis of Compound D)

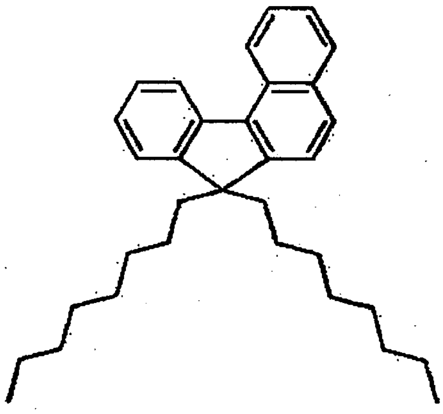

Compound D

Under an inert atmosphere, 20 mL of deionized water was charged into a 200 mL, three-necked flask. The solution was then charged in small amounts with 18.9 g of sodium hydroxide (0.47 mols) while stirring to dissolve. The temperature of the solution was cooled to room temperature, and then the solution was charged with 20 mL of toluene, 5.17 g of compound C (15.7 mmol) synthesized in the same manner as described above and 1.52 g of tributyl ammonium bromide (4.72 mmol). The temperature was of the solution was increased to 50°C. n-Octylbromide was added dropwise, and after the addition, the solution was reacted at 50°C for 9 hours. After the reaction had finished, the organic layer was extracted with toluene, washed with water twice and dried over sodium sulfate. The resultant product was then purified by a silica gel column using hexane as the developing solvent to obtain 5.13 g of compound D (yield 74%) as a yellow oil.
$^1$H-NMR(300MHz/$CDCl_3$) :
δ0.52(m,2H), 0.79(t,6H), 1.00~1.20(m, 22H), 2.05(t,4H), 7.34(d, 1H), 7.40~7.53(m, 2H), 7.63(m, 3H), 7.83(d, 1H), 7.94 (d, 1H), 8.31(d, 1H) 8.75(d, 1H)
MS(APCI(+)): $(M+H)^+$ 441

(Synthesis of Compound E)

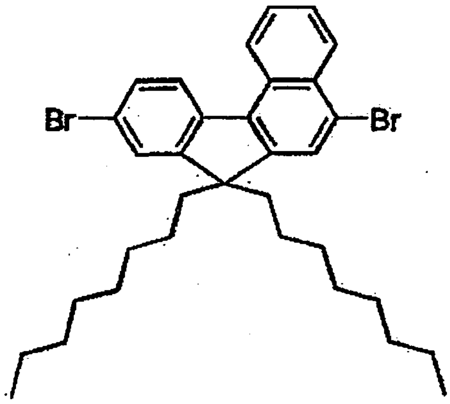

Compound E

Under an air atmosphere, 4.00 g of compound D (9.08 mmol) and 57 mL of a mixed solvent of acetic acid:dichloromethane = 1:1 were charged into a 50 mL, three-necked flask, and the resultant solution was dissolved by stirring at room temperature. Then, 7.79 g of benzyltrimethylammonium tribromide (20.0 mmol) was charged into the solution, and the zinc chloride was charged in under stirring until the benzyltrimethylammonium tribromide had completely dissolved. The solution was stirred for 20 hours at room temperature, and then charged with 10 mL of 5% aqueous sodium bisulfite to terminate the reaction. The organic layer was extracted with chloroform, washed with aqueous potassium carbonate solution twice and then dried over sodium sulfate. After twice passing through a flash column using hexane as the developing solvent, the resultant product was recrystallized with a mixed solvent of ethanol:hexane = 1:1 and the 10:1 to obtain 4.13 g of compound E (yield 76%) as white crystals.

$^1$H-NMR (300MHz/$CDCl_3$):

δ0.60(m, 4H), 0.91(t,6H), 1.01~1.38(m, 20H), 2.09(t,4H), 7.62~7.75(m, 4H), 7.89(s, 1H), 8.20(d, 1H), 8.47(d, 1H), 8.72 (d, 1H)

MS(APPI(+)): $M^+$596

(Synthesis of Compound G)

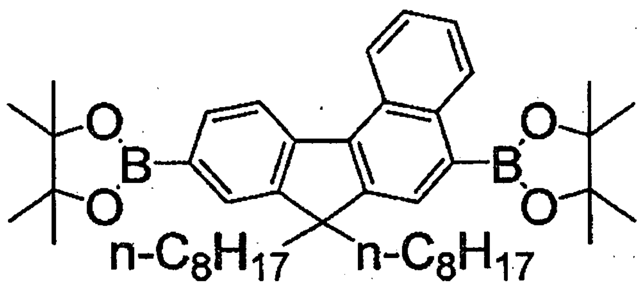

(Compound G)

A 100 mL, 4-necked, round-bottom flask was purged with argon gas, and then charged with compound E (3.2 g, 5.3 mmol) synthesized in the same manner as described above, bispinacolato diboron (3.8 g, 14.8 mmol), $PdCl_2$ (dppf) (0.39 g, 0.45 mmol), bis(diphenylphosphino)ferrocene (0.27 g, 0.45 mmol) and potassium acetate (3.1 g, 32 mmol). The resultant solution was then charged with 45 mL of anhydrous dioxane. Under an argon atmosphere, the temperature of the solution was increased to 100°C, and the solution was reacted for 36 hours. After leaving to cool, the solution was filtered using 2 g of Celite as a precoat, and then concentrated to obtain a black liquid. This liquid was dissolved in 50 g of hexane, and the coloring component was removed using activated carbon to obtain 37 g of a pale yellow liquid (during filtration precoating was carried out using 5 g of Radiolite (manufactured by Showa Chemical Industry Co., Ltd.)). This liquid was charged with 6 g of ethyl acetate, 12 g of anhydrous methanol and 2 g of hexane, and the resultant solution was dipped in a dry ice-methanol bath to obtain 2.1 g of compound G as colorless crystals.

Synthesis Example 5

<Synthesis of Polymer 4>

Under an argon atmosphere, 37.7 g of compound E (63 mmol) and 43.6 g of compound G (63 mmol) synthesized in the same manner as Synthesis Example 4 were charged into a 200 mL flask connected to a Dimroth condenser. The resultant mixture was dissolved in 70 mL of toluene, and then argon gas was bubbled therethrough to remove air. The mixture was then charged with 42 mg of palladium acetate and 266 mg of tris(o-methoxyphenyl)phosphine. While increasing the temperature, 283.4 mL of aqueous bis(tetraethylammonium) carbonate (33% by weight) was added dropwise, and the resultant solution was refluxed for 24 hours. The solution was charged with 10.8 g of bromobenzene and further refluxed for 1 hour. The solution was again charged with 8.9 g of phenyl boronate and further refluxed for 1 hour. The oil layer was washed twice with 2 N aqueous hydrochloric acid, twice with 10% aqueous acetic acid and six times with water. The oil layer was then filtered through Celite and concentrated under reduced pressure. The resultant solution was added dropwise into methanol to cause a precipitate to form. The obtained solid was filtered off, dried under reduced pressure then redissolved in toluene, and the resultant solution was again precipitated in methanol. This series of steps was carried out a total of two times, whereby 22.4 g of a polymer (hereinafter referred to as "polymer 4") was obtained. The number average molecular weight and weight average molecular weight in terms of polystyrene were Mn = $7.3 \times 10^4$ and Mw = $1.8 \times 10^5$ (GPC Analysis Method C).
Since polymer 4 does not have a side chain, the values for the parameters k and f, which in the present invention respectively represent the number of side chain repeating units and the length of the side chains, are zero.

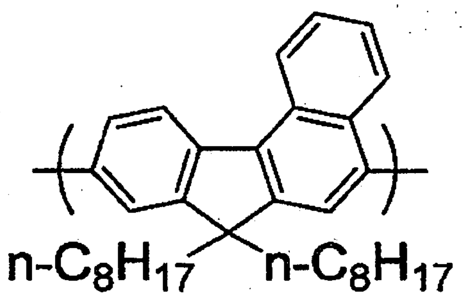

(Polymer 4)

Synthesis Example 6

<Synthesis of Polymer 5: Bromination of Polymer 4>

Under an argon gas atmosphere, polymer 3 (5.00 g, 11.4 mmol in terms of benzofluorene repeating units) and 150 mL of chloroform were charged into a 500 mL flask, and the resultant solution was dissolved by stirring at room temperature. The solution was then successively charged with 17.6 mL of trifluoroacetic acid and 236 μL of bromine (4.6 mmol, 40 mole% of the benzofluorene units) and stirred for 24 hours under light-shielding. The reaction mass was added dropwise to 1,250 mL of methanol under stirring to cause the mixture to precipitate. The obtained precipitate was filtered off, washed with methanol and dried under reduced pressure to obtain 5.29 g of a polymer. This polymer shall be referred to as "polymer 5". Polymer 5 had, in terms of polystyrene, a number average molecular weight of Mn = $7.5 \times 10^4$, weight average molecular weight of Mw = $1.6 \times 10^5$, peak top molecular weight of Mp = $1.2 \times 10^5$ and degree of dispersion of Mw/Mn = 2.1 (GPC Analysis Method C).
The results of elemental analysis showed that the ratio of repeating units having a Br group (Formula P-8) to repeating units without a Br group (Formula P-7) was (P-7)/(P-8) = 61/39, and that (total benzofluorene repeating units)/Br groups was 72/28. Elemental Analysis Measurement Result: C 84.93%, H 9.06%, N <0.3%, Br 6.57%
Elemental Analysis Calculated Result: C 84.48%, H 8.94%, N 0%, Br 6.57% (values calculated by (P-7)/(P-8) = 61/39)

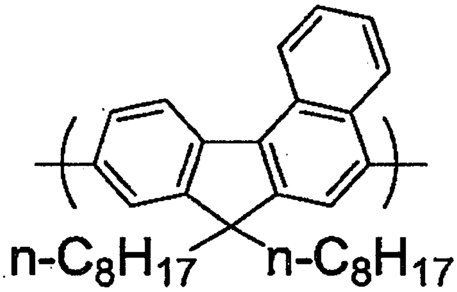

(P-7)

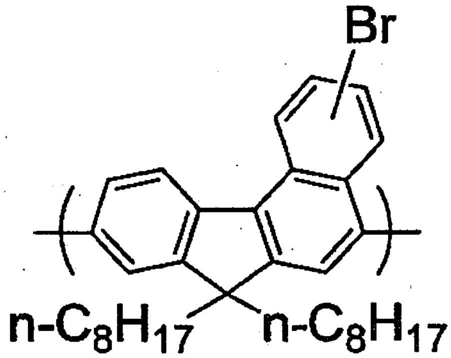

(P-8)

Example 3

<Synthesis of Aromatic Graft Polymer 3>

A 100 mL flask was charged with 300 mg of polymer 5, 83.44 mg of compound M-3, 0.43 mg of palladium(II) acetate and 1.09 mg of tricyclohexylphosphine. After the flask was purged with argon gas, 36 mL of commercially-available anhydrous toluene was charged into the flask, and the resultant solution was dissolved by stirring at room temperature. The temperature was increased to 110°C, and then the solution was charged with 0.70 mL of aqueous tetraethylammonium hydroxide (1.4 M). The solution was then stirred for 3 hours at 110°C. The heating was temporarily stopped, and then the solution was charged with 169 mg of 4-(4,4,5,5-tetramethyl-[1,3,2]dioxaborolan-2-yl)butyltoluene, 0.50 mg of palladium(II) acetate, 1.09 mg of tricyclohexylphosphine and 0.70 mL of aqueous tetraethylammonium hydroxide (1.4 M). The temperature was again increased to 110°C, and the solution was stirred for 3 hours. After cooling to room temperature, the solution was diluted with 15 mL of toluene. The solution was separated, and the resultant mixture was then washed twice with 20 mL of 15% brine. The obtained organic layer was passed through a filter which had been precoated with 3 g of Radiolite (manufactured by Showa Chemical Industry Co., Ltd.), and then washed with 20 mL of toluene. The obtained organic layer was concentrated and then added dropwise to acetone to cause a precipitate to form. The obtained precipitate was filtered off, washed with acetone and then dried under reduced pressure to obtain 318 mg of a crude polymer.
317 mg of this crude polymer was dissolved at room temperature in 70 mL of toluene, and the resultant solution was passed through a silica gel column and an alumina column through which toluene had been passed through in advance. The solution was again washed with toluene, then washed with 3% ammonia water and distilled water twice, and concentrated under reduced pressure. The resultant solution was added dropwise to methanol to again form a precipitate. The precipitate was filtered off, washed with methanol and then dried under reduced pressure to obtain 308 mg of a polymer.
This polymer shall be referred to as "aromatic graft polymer 3". Aromatic graft polymer 3 had, in terms of polystyrene, a number average molecular weight of $Mn = 8.5 \times 10^4$, weight average molecular weight of $Mw = 1.7 \times 10^5$, peak top molecular weight of $Mp = 1.2 \times 10^5$ and degree of dispersion of $Mw/Mn = 2.0$ (GPC Analysis Method C).
The results of elemental analysis showed that the ratio of repeating units (Formula P-7) to repeating units having a Br group (Formula P-8) to repeating units having a substituent (Formula P-9) was (P-7)/(P-8)/(P-9) = 89/0/11, and that the molar ratio of benzofluorene repeating units to side chains, bezofluorene/side chains, was 90/10.

Elemental Analysis Measurement Result: C 89.31%, H 9.15%, N 0.61%, Br<0.1%
Elemental Analysis Calculated Result: C 89.91%, H 9.47%, N 0.61%, Br 0% (value calculated by (P-7)/(P-8)/(P-9) =89/0/11)
In aromatic graft polymer 3, the parameters k and f, which in the present invention respectively represent the number of side chain repeating units and the length of the side chains, were k = 3 and f = 5.

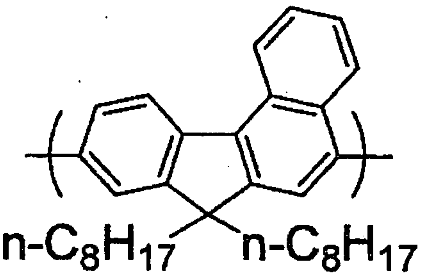

(P-7)

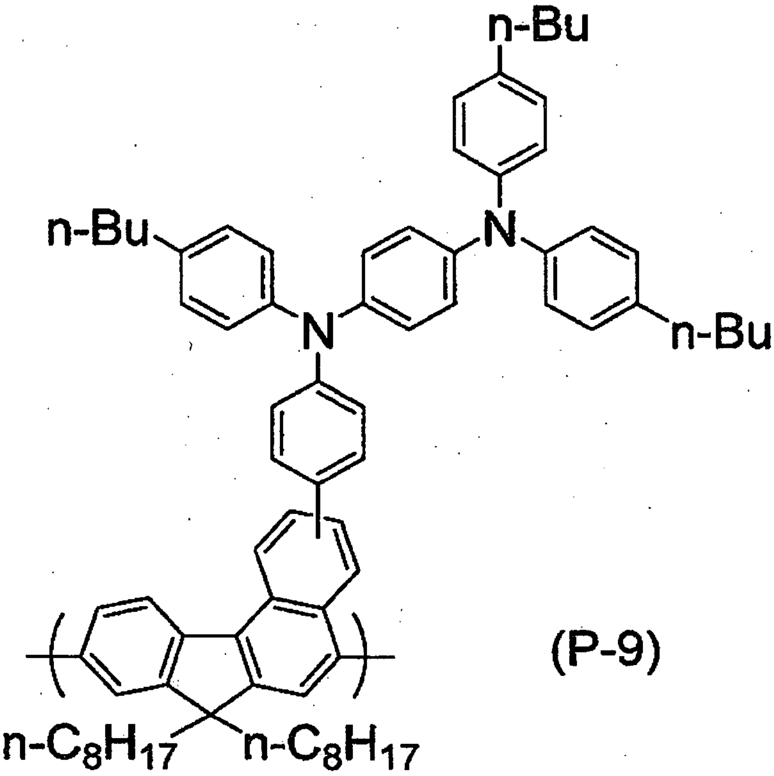

(P-9)

Synthesis Example 7

<Synthesis of Compound N>

(Synthesis of 4-t-butyl-2,6-dimethylbromobenzene)

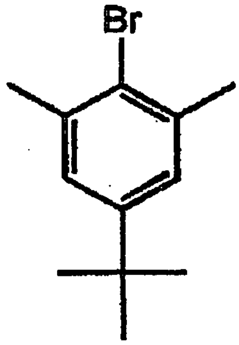

Under an inert atmosphere, a 500 mL, 3-necked flask was charged with 225 g of acetic acid, and then charged with 24.3 g of 5-t-butyl-m-xylene. Next, the flask was charged with 31.2 g of bromine, and the resultant solution was reacted for 3 hours at 15 to 20°C.
The reaction solution was charged with 500 mL of water, and the formed precipitate was filtered off. The resultant product was washed twice with 250 mL of water to obtain 34.2 g of a white solid.
$^1$H-NMR(300MHz/$CDCl_3$) :
δ(ppm) = 1.3[s,9H], 2.4[s,6H], 7.1[s,2H]
MS($FD^+$)$M^+$ 241

(Synthesis of N,N-diphenyl-N-(4-t-butyl-2,6-dimethylphenyl)-amine)

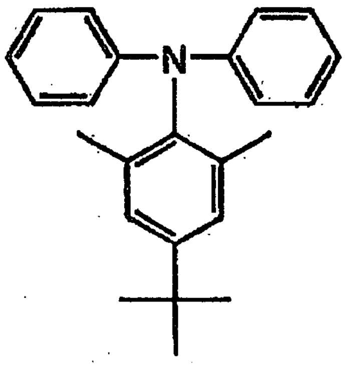

Under an inert atmosphere, a 300 mL, 3-necked flask was charged with 100 mL of deaerated, anhydrous toluene, and then charged with 16.9 g of diphenylamine and 25.3 g of 4-t-butyl-2,6-dimethylbromobenzene. Next, the flask was charged with 0.92 g of tris(dibenzylideneacetone)dipalladium and 12.0 g of t-butoxysodium, and then charged with 1.01 g of tri(t-butyl)phosphine. The resultant solution was then reacted for 7 hours at 100°C.
The reaction solution was charged into saturated brine, and then the resultant mixture was extracted with 100 mL of toluene. The toluene layer was washed with dilute hydrochloric acid and saturated brine, then the solvent was removed to obtain a black solid. This solid was isolated by purifying by silica gel column chromatography (hexane:chloroform 9/1) to obtain 30.1 g of a white solid.
$^1$H-NMR (300MHz/$CDCl_3$) : δ (ppm) =1.3 [s, 9H], 2.0 [s,6H], 6.8~7.3[m,10H]

(Synthesis of N,N-bis(4-bromophenyl)-N-(4-t-butyl-2,6-dimethylphenyl)-amine)

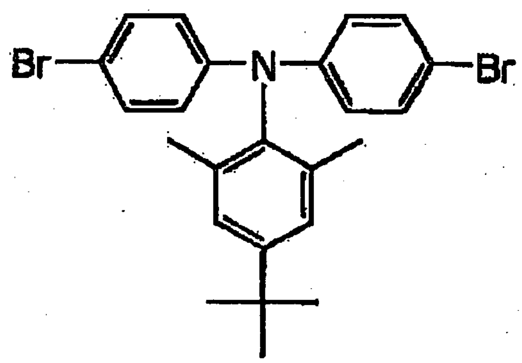

Under an inert atmosphere, a 1,000 mL, 3-necked flask was charged with 333 mL of anhydrous N,N-dimethylformamide and 166 mL of hexane, and then 29.7 g of N,N-diphenyl-N-(4-t-butyl-2,6-dimethylphenyl)-amine synthesized in the above-described manner was dissolved in the solution. Then, under light-shielding and in an ice bath, 33.6 g of N-bromosuccinimide in 100 mL of N,N-dimethylformamide was added dropwise, and the resultant solution was reacted for one day and night.
The reaction solution was concentrated under reduced pressure to 200 mL, and the resultant product was charged into 100 mL of water. The formed precipitate was filtered off. The obtained crystals were twice re-crystallized with DMF/methanol to obtain 23.4 g of a white solid.
$^1$H-NMR (300MHz/$CDCl_3$) :
$\delta$(ppm) = 1.3[s, 9H], 2.0[s,6H], 6.8[d, 2H], 7.1[s,2H], 7.3[d, 2H],
MS(APCI(+)): $M^+$ 488

<Synthesis of Compound N>

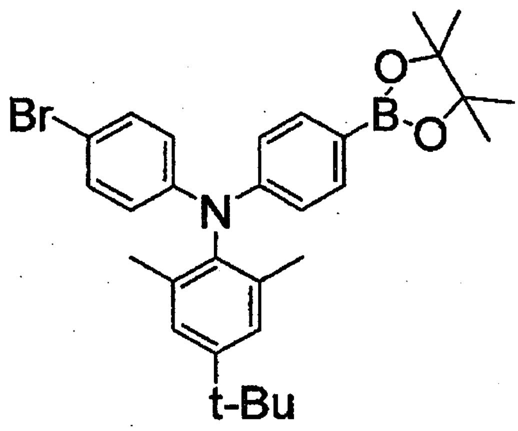

Compound N

(Synthesis of (4-bromophenyl)-(4-tert-butyl-2,6-dimethylphenyl)-[4-(4,4,5,5-tetramethyl-[1,3,2]dioxaborolan-2-yl)-phenyl]amine)

A dried four-necked flask was charged under an argon atmosphere with 91.89 g of bis-(4-bromophenyl)-(4-tert-butyl-2,6-dimethylphenyl)amine (188.58 mmol), and then charged with 2,750 mL of anhydrous tetrahydrofuran. The resultant solution was then made homogeneous. The reaction solution was cooled to -70°C, and then 98 mL of a 1.54 M solution of n-butyllithium in n-hexane (150.9 mmol) was added dropwise thereto over 78 minutes. The solution was then stirred as is for 65 minutes. Next, 35.1 g of 2-isopropoxy-4,4,5,5-tetramethyl-[1,3,2]dioxaborane (188.65 mmol)

was added dropwise over 60 minutes at - 70°C, and the solution was stirred as is for 1 hour. The temperature of the solution was then increased to 15 to 20°C. The solution was stirred for 2 hours, then charged with 1 L of water at room temperature. The tetrahydrofuran was then removed though concentration under reduced pressure. The concentrated suspension was charged with 2 L of toluene, and the resultant mixture was stirred. The oil layer was separated from the aqueous layer. This separation operation was repeated three times, and the resultant oil layers were added together. This mixture was charged with anhydrous sodium sulfate and stirred. The anhydrous sodium sulfate was removed by filtration, and the resulting filtrate was concentrated under reduced pressure to obtain 113.54 g of a white solid. This white solid was purified by silica gel column chromatography using toluene and n-hexane as the developing solution, then concentrated and solidified by drying to obtain 45.5 g of a yellow solid. This yellow solid was dissolved in 800 mL of tetrahydrofuran, and 800 mL of distilled water was then added dropwise at 25°C over 3 hours, whereby crystals precipitated. After stirring for 1 hour, the solution was filtered. This four-step operation was repeated 7 times. The obtained crystals were dried under reduced pressure to obtain the title compound (4-bromophenyl)-(4-tert-butyl-2,6-dimethylphenyl)-[4-(4,4,5,5-tetramethyl-[1,3,2]dioxaborolan-2-yl)-phenyl]amine (compound N) as a white solid (yield amount: 40.2 g; yield: 37.8%; LC area percentage: 98.0%)
$^1$H-NMR: 1.32(s,9H), 1.32(s,12H), 1.98(s,6H), 6.87(d,2H), 6.90(d,2H), 7.09(s,2H), 7.28(d,2H), 7.63(d,2H)
LC-MS: 535.1(M+H)

Example 4

<Synthesis of Aromatic Graft Polymer 4>

A 100 mL flask was charged with 300 mg of polymer 5, 791 mg of compound N, 3.9 mg of palladium(II) acetate and 9.8 mg of tricyclohexylphosphine. After the flask was purged with argon gas, 36 mL of commercially-available anhydrous toluene was charged into the flask, and the resultant solution was dissolved by stirring at room temperature. The solution was charged with 6.2 mL of aqueous tetraethylammonium hydroxide (1.4 M). The temperature was increased to 110°C, and the solution was then stirred for 3 hours at 110°C. The heating was temporarily stopped, and then the solution was charged with 166 mg of 4-(4,4,5,5-tetramethyl-[1,3,2]dioxaborolan-2-yl)butylbenzene, 3.88 mg of palladium (II) acetate, 9.69 mg of tricyclohexylphosphine and 1.2 mL of aqueous tetraethylammonium hydroxide (1.4 M). The temperature was again increased to 110°C, and the solution was stirred for 3 hours. After cooling to room temperature, the solution was diluted with 15 mL of toluene. The solution was separated, and the resultant mixture was then washed twice with 15 mL of 15% brine. The obtained organic layer was passed through a filter which had been precoated with 3 g of Radiolite (manufactured by Showa Chemical Industry Co., Ltd.), and then washed with 18 mL of toluene. The obtained organic layer was concentrated and then added dropwise to acetone to cause a precipitate to form. The obtained precipitate was filtered off, washed with acetone and then dried under reduced pressure to obtain 730 mg of a crude polymer.
728 mg of this crude polymer was dissolved at room temperature in 140 mL of toluene, and the resultant solution was passed through a silica gel column and an alumina column through which toluene had been passed through in advance. The solution was again washed with toluene, and then concentrated under reduced pressure. The resultant solution was added dropwise to acetone to again form a precipitate. The precipitate was filtered off, washed with acetone and then dried under reduced pressure to obtain 705 mg of a polymer.
This polymer shall be referred to as "aromatic graft polymer 4". Aromatic graft polymer 4 had, in terms of polystyrene, a number average molecular weight of $Mn = 4.2 \times 10^4$, weight average molecular weight of $Mw = 1.8 \times 10^5$, peak top molecular weight of $Mp = 1.6 \times 10^5$ and degree of dispersion of Mw/Mn = 4.4 (GPC Analysis Method C).
The results of elemental analysis showed that aromatic graft polymer 4 was composed of repeating units (Formula P-7)-and repeating units having a side chain (Formula P-10), and that the side chain length was 4.1 times that of the triphenylamine derivative repeating units (represented by the letter n in the following (Formula P-10)). The results also showed that the ratio (P-7)/(P-10) = 61/39, and that the ratio of the benzofluorene repeating units to triphenylamine derivative repeating units, bezofluorene/side chains, was 38/62.
Elemental Analysis Measurement Result: C 88.57%, H 8.57%, N 2.32%, Br <0.1%
Elemental Analysis Calculated Result: C 88.94%, H 8.74%, N 2.32%, Br 0% (values calculated by (P-7)/(P-10) = 61/39)
In aromatic graft polymer 4, the parameters k and f, which in the present invention respectively represent the number of side chain repeating units and the length of the side chains, were k = 8 and f = 12.

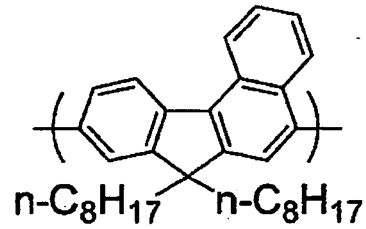

(P-7)

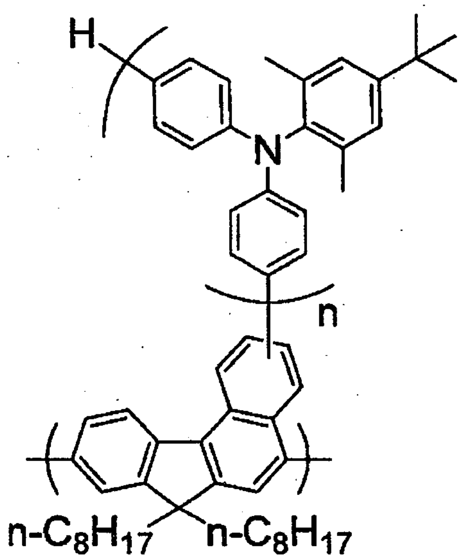

(P-10)

Reference Synthesis Example 1

<Synthesis of Polymer 6>

2,7-Dibromo-9,9-di-n-octylfluorene (0.700 g, 1.28 mmol), N,N'-bis(4-n-butylphenyl)-N,N'-bis(4-bromophenyl)-1,4-phenylenediamine (0.046 g, 0.067 mmol) and 2,2'-bipyridyl (0.525 g) were dissolved in 40 mL of anhydrous tetrahydrofuran. Nitrogen was then bubbled to purge the system with nitrogen. Under a nitrogen atmosphere, the solution was charged with bis (1,5-cyclooctadiene)nickel(0){Ni $COD)_2$} (0.924 g). The temperature was increased to 60°C, and the solution was reacted for 5 hours while stirring. After the reaction, the reaction solution was cooled to room temperature (about 25°C), and then added dropwise to a mixed solution of 5 mL of 25% ammonia water, 50 mL of methanol and 50 mL of deionized water, and the resultant solution was stirred for 1 hour. The formed precipitate was then filtered off and dried for 2 hours under reduced pressure. The resultant product was then dissolved in 50 mL of toluene, and the solution was filtered. The filtrate was purified by passing through an alumina column. The resultant organic layer was then washed for 3 hours with 50 mL of 5.2% aqueous hydrochloric acid, for 2 hours with 50 mL of 4% ammonium water, and then with 50 mL of deionized water. Next, the organic layer was added dropwise to about 100 mL of methanol, and the resultant solution was stirred for 1 hour. The formed precipitate was filtered off and then dried under reduced pressure for 2 hours. The yield amount of the obtained copolymer (hereinafter, referred to as "polymer 6") was 252 mg.
The number average molecular weight and weight average molecular weight in terms of polystyrene were respectively Mn = $8.6 \times 10^4$ and Mw = $1.8 \times 10^5$ (GPC Analysis Method A).
The ratio of repeating units (P-7) to (P-11) estimated from the charged ratio in polymer 6 is (P-7)/(P-11) = 95/5.
Since polymer 6 does not have a side chain, the values for the parameters k and f, which in the present invention respectively represent the number of side chain repeating units and the length of the side chain, are zero.

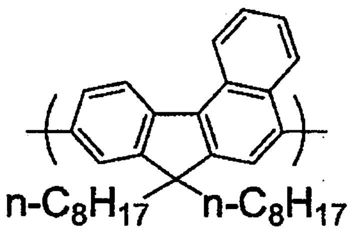

(P-7)

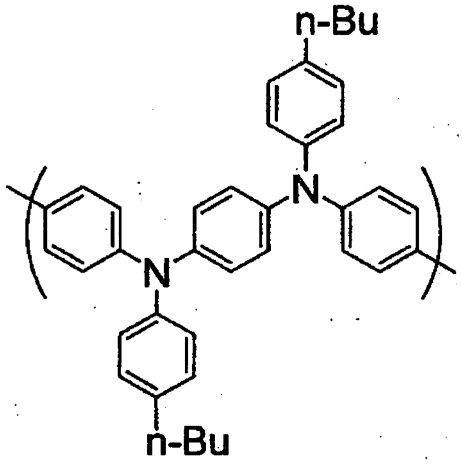

(P-11)

Reference Synthesis Example 2

<Synthesis of N-(4-(4,4,5,5-tetramethyl-[1,3,2]dioxaborolan-2-yl)phenyl)-N-(4-t-butyl-2,6-dimethylphenyl)-N-phenylamine>

(Synthesis of N-(4-bromophenyl)-N-(4-t-butyl-2,6-dimethylphenyl)-N-phenylamine)

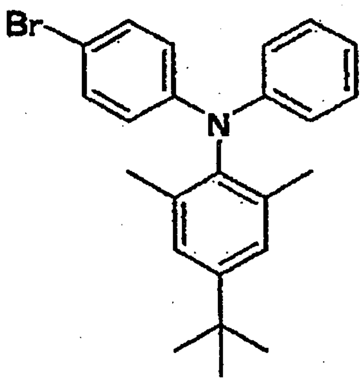

A dried 3-necked flask was charged with 3.0 g of N,N-diphenyl-N-(4-t-butyl-2,6-dimethylphenyl)-amine (9.1 mmol) synthesized in the same manner as described above. The vessel interior was purged with argon gas, and 105 mL of anhydrous dimethlformamide was injected therein with a syringe. The resultant solution was then made uniform. The reaction solution was cooled by an ice bath to 0 to 5°C, and then a solution consisting of 1.5 g (0.9 equivalents) of N-bromosuccinimide and 5.2 mL of anhydrous dimethylformamide was added dropwise over 30 minutes. The solution was then stirred as is for 30 minutes. Next, the ice bath was removed, and the temperature of the solution was returned to

room temperature. The solution was then stirred for 5 hours. Next, the reaction solution was charged with 130 mL of distilled water and 150 mL of chloroform, and then thoroughly stirred. The organic layer was separated from the aqueous layer, dried over anhydrous magnesium sulfate, then concentrated and dried to form a solid. This solid was dissolved in 200 mL of toluene, passed through a silica gel column, and then the solution was concentrated and dried to form a solid. The solid was purified by silica gel column chromatography using chloroform and cyclohexane as the developing solution, then concentrated and solidified by drying to obtain 2.0 g of N-(4-bromophenyl)-N-(4-t-butyl-2,6-dimethylphenyl)-N-phenylamine as a white solid (LC area percentage: 99.7%; yield: 53.3%).
$^1$H-NMR(300MHz, $CDCl_3$): δ1.32 (s, 9H) 2.00(s,6H), 6.81-6.98 (m, 5H), 7.09 (s, 2H), 7.16-7.27(m,4H)
LC/MS(APPI(+)): M+407

(Synthesis of N-(4-(4,4,5,5-tetramethyl-[1,3,2]dioxaborolan-2-yl)phenyl)-N-(4-t-butyl-2,6-dimethylphenyl)-N-phenylamine)

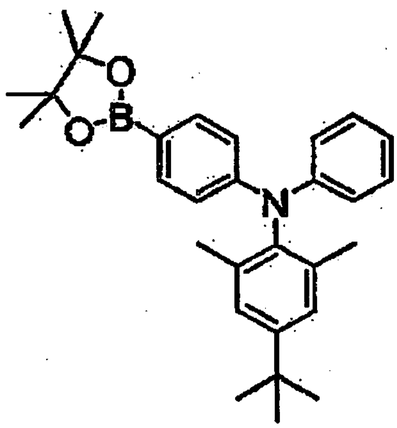

A dried 3-necked flask was charged with 7.78 g of N-(4-bromophenyl)-N-(4-t-butyl-2,6-dimethylphenyl)-N-phenylamine (19.1 mmol) synthesized in the same manner as described above. The vessel interior was purged with argon gas, and 76 mL of anhydrous tetrahydrofuran and 191 mL of anhydrous diethylether were charged therein, and the resultant solution was stirred. The reaction solution was cooled to -76°C, and then 13.61 mL of a 1.54 mol/L solution of n-butyllithium in n-hexane (21.0 mmol) was added dropwise thereto over 30 minutes. The solution was then stirred as is for 0.5 hours. Next, 5.83 mL of 2-isopropoxy-4,4,5,5-tetramethyl-[1,3,2]dioxaborane (28.6 mmol) was added dropwise over 20 minutes at -76°C, and the solution was stirred as is for 1 hour. The temperature of the solution was then increased to room temperature and stirred for 2 hours. The reaction solution was added dropwise over 15 minutes into 200 mL of 0.2 N hydrochloric acid cooled to 0°C, and the resultant solution was stirred at room temperature for 15 minutes. The organic layer was then separated from the aqueous layer. The aqueous layer was extracted with diethylether, and the resultant solution was added to the organic layer. This mixture was successively washed with distilled water, aqueous 5% sodium bicarbonate and then distilled water. The obtained organic layer was dried over anhydrous sodium sulfate, the concentrated and dried to form a solid, whereby 9.0 g of a crude composition was obtained as a pale peach color. 8.6 g of this crude composition was dissolved by heating at 50°C in 17.1 g of tetrahydrofuran. The resultant solution was slowly charged with 85.6 g of methanol to cause crystals to form. These crystals were filtered off and then dried under reduced pressure to obtain 7.6 g of N-(4-(4,4,5,5-tetramethyl-[1,3,2]dioxaborolan-2-yl)phenyl)-N-(4-t-butyl-2,6-dimethylphenyl)-N-phenylamine as a white solid. (LC area percentage: 98.5%; yield: 86.7%) This product contained as impurities N,N-diphenyl-N-(4-t-butyl-2,6-dimethylphenyl)-amine at an LC index value of 1.5%.
$^1$H-NMR(300MHz,CDCl3) : δ1.32(s,9H), 1.32(s,12H), 2.00(s,6H), 6.81-6.98(m,3H), 7.01(d,2H), 7.09(s,2H), 7.15-7.27 (m,2H), 7.62(d,2H),
LC/MS(APPI(+)); $[M+H]^+$ 456

Reference Synthesis Example 3

<Synthesis of Polymer 7>

A 100 mL flask was charged with 600 mg of polymer 5, 147 mg of N-(4-(4,4,5,5-tetramethyl-[1,3,2]dioxaborolan-2-yl)phenyl)-N-(4-t-butyl-2,6-dimethylphenyl)-N-phenylamine, 0.96 mg of palladium(II) acetate and 2.40 mg of tricyclohexylphosphine. After the flask was purged with argon gas, 72 mL of commercially-available anhydrous toluene was charged into the flask, and the resultant solution was dissolved by stirring at room temperature. The temperature was increased to 110°C, and then the solution was charged with 1.55 mL of aqueous tetraethylammonium hydroxide (1.4 M). The solution was then stirred for 3 hours at 110°C. The heating was temporarily stopped, and then the solution was charged with 336 mg of 4-(4,4,5,5-tetramethyl-[1,3,2]dioxaborolan-2-yl)butylbenzene, 1.00 mg of palladium(II) acetate, 2.43 mg of tricyclohexylphosphine and 1.55 mL of aqueous tetraethylammonium hydroxide (1.4 M). The temperature was again increased to 110°C, and the solution was stirred for 3 hours. After cooling to room temperature, the solution was diluted with 30 mL of toluene. The solution was separated, and the resultant mixture was then washed twice with 36 mL of 15% brine. The obtained organic layer was passed through a filter which had been precoated with 6 g of Radiolite (manufactured by Showa Chemical Industry Co., Ltd.), and then washed with 36 mL of toluene. The obtained organic layer was concentrated and then added dropwise to acetone to cause a precipitate to form. The obtained precipitate was filtered off, washed with acetone and then dried under reduced pressure to obtain 630 mg of a crude polymer.

630 mg of this crude polymer was dissolved at room temperature in 130 mL of toluene, and the resultant solution was passed through a silica gel column and an alumina column through which toluene had been passed through in advance. The solution was again washed with toluene, then washed with 3% ammonia water and distilled water twice, and concentrated under reduced pressure. The resultant solution was added dropwise to methanol to again form a precipitate. The precipitate was filtered off, washed with methanol and then dried under reduced pressure to obtain 627 mg of a polymer.

The obtained polymer shall be referred to as "polymer 7". The obtained polymer 7 had, in terms of polystyrene, a number average molecular weight of Mn = $8.3 \times 10^4$, weight average molecular weight of Mw = $1.6 \times 10^5$, peak top molecular weight of Mp = $1.3 \times 10^5$ and degree of dispersion of Mw/Mn = 1.9 (GPC Analysis Method C).

The results of elemental analysis showed that the ratio of repeating units (P-7) to repeating units having a substituent (Formula P-12) was (P-7)/(P-12) = 82/18, and that the ratio of benzofluorene repeating units to substituents, benzofluorene/side chains, was 85/15.

Elemental Analysis Measurement Result: C 90.46%, H 9.18%, N 0.49%, Br <0.1%

Elemental Analysis Calculated Result: C 90.08%, H 9.43%, N 0.49%, Br 0% (values calculated by (P-7)/(P-12) = 82/18)

In polymer 7, the parameters k and f, which in the present invention respectively represent the number of side chain repeating units and the length of the side chains, were k = 2 and f = 3.

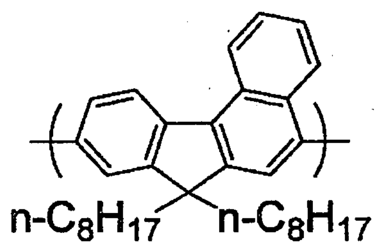

(P-7)

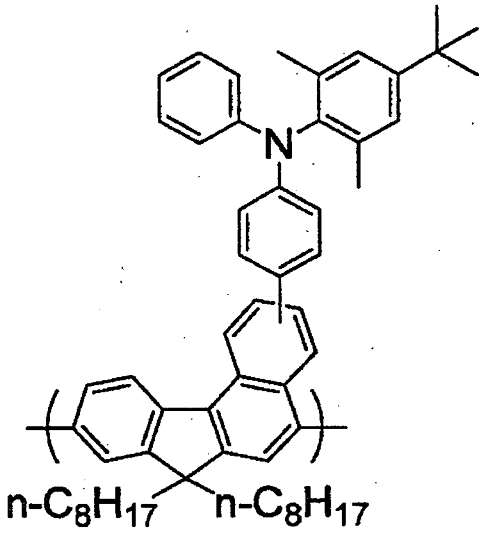

(P-12)

Example 5

Preparation of Solution

The above-described aromatic graft polymer 2 was dissolved in toluene to prepare a toluene solution having a polymer concentration of 1.5% by weight.

EL Device Fabrication

On a glass substrate sputtered with a 150 nm thick ITO film, a 80 nm thick thin film was formed by spin coating using a solution of poly(3,4)ethylene dioxythiophene)/polystyrene sulfonic acid (BaytronP Al 4083 (product name), manufactured by H.C. Starck) which had been filtered using a 0.1 μm membrane filter. This film was then dried for 15 minutes at 200°C on a hot plate. Then, the above-described toluene solution was deposited thereon by spin coating at a revolution rate of 2,500 rpm. The film thickness after deposition was about 86 nm. The produced substrate was dried under a nitrogen atmosphere at 90°C for 1 hour. During the drying process, the oxygen concentration and the moisture concentration were 10 ppm or less. About 4 nm of lithium fluoride was deposited onto the substrate, on which as the cathode, about 5 nm of calcium and about 100 nm of aluminum were deposited to fabricate the EL device. It is noted that the deposition of the metals was started after the degree of vacuum reached $1 \times 10^{-4}$ Pa or below.

EL Device Performance

Application of voltage to the thus-obtained EL device obtained an EL emission from the device having a peak at 465 nm. The device started to show luminance at 4.2 V, and had a maximum luminance efficiency at 1.37 cd/A. The voltage (V)-current (I) characteristics obtained from this measurement are shown in Fig. 1.

Example 6

An EL device was fabricated in the same manner as in Example 5, except that the aromatic graft polymer 3 was used instead of the aromatic graft polymer 2 of Example 5, and that the revolution speed during spin coating was 1,700 rpm. The film thickness after deposition was about 81 nm. Application of voltage to the EL device obtained an EL emission from the device having a peak at 475 nm. The device started to show luminance at 3.2 V, and the maximum luminance efficiency was at 3.72 cd/A. The voltage (V)-current (I) characteristics obtained from this measurement are shown in Fig. 2.

Example 7

An EL device was fabricated in the same manner as in Example 5, except that the aromatic graft polymer 4 was used instead of the aromatic graft polymer 2 of Example 5, and that the revolution speed during spin coating was

1,300 rpm. The film thickness after deposition was about 81 nm. Application of voltage to the EL device obtained an EL emission from the device having a peak at 465 nm. The device started to show luminance at 2.8 V, and the maximum luminance efficiency was at 0.72 cd/A. The voltage (V)-current (I) characteristics obtained from this measurement are shown in Fig. 3.

Comparative Example 1

An EL device was fabricated in the same manner as in Example 5, except that the polymer 6 was used instead of the aromatic graft polymer 2 of Example 5, and that the revolution speed during spin coating was 2,000 rpm. The film thickness after deposition was about 121 nm. Application of voltage to the device obtained an EL emission from the device having a peak at 480 nm. The device started to show luminance at 4.7 V, and the maximum luminance efficiency was at 2.28 cd/A. The voltage (V)-current (I) characteristics obtained from this measurement are shown in Fig. 4.

Comparative Example 2

An EL device was fabricated in the same manner as in Example 5, except that the polymer 4 was used instead of the aromatic graft polymer 2 of Example 5, and that the revolution speed during spin coating was 1,300 rpm. The film thickness after deposition was about 103 nm. Application of voltage to the EL device obtained an EL emission from the device having a peak at 470 nm. The device started to show luminance at 4.4 V, and the maximum luminance efficiency was at 0.18 cd/A. The voltage (V)-current (I) characteristics obtained from this measurement are shown in Fig. 5.

Comparative Example 3

An EL device was fabricated in the same manner as in Example 5, except that the aromatic graft polymer 7 was used instead of the aromatic graft polymer 2 of Example 5, and that the revolution speed during spin coating was 1,700 rpm. The film thickness after deposition was about 83 nm. Application of voltage to the EL device obtained an EL emission from the device having a peak at 460 nm. The device started to show luminance at 3.3 V, and the maximum luminance efficiency was at 0.69 cd/A. The voltage (V)-current (I) characteristics obtained from this measurement are shown in Fig. 6.

If Example 1 is compared with Comparative Example 1, the polymer light-emitting device using the aromatic graft polymer 2 had a lower luminescence starting voltage and a higher current value than in the case of using polymer 6. These traits mean that the carrier mobility is especially high for an aromatic graft polymer, which contributes to reducing drive voltage when used as a luminescent material or charge transport material.

Similarly, compared with the corresponding polymer 4, aromatic graft polymers 3 and 4 also had a lower luminescence starting voltage, an especially large current value in the low electric field region, as well as high luminescence efficiency. It can also be seen that compared with polymer 7, which has short side chains, the longer the side chains, the lower that luminescence starting voltage becomes and the larger that the current value in the low electric field region becomes. Thus, the aromatic graft polymer according to the present invention has characteristics which are excellent as a material used in polymer light-emitting devices.

INDUSTRIAL APPLICABILITY

The aromatic graft polymer of the present invention is expected as a useful polymeric material for producing various highly functional materials in an electronic industry material, chemistry, energy material and medicinal fields or the like.

## Claims

1. An aromatic graft polymer comprising one or more kinds of repeating units represented by the following formula (1),

$$-Ar^1- \qquad (1)$$

wherein $Ar^1$ represents a divalent residue of a π-conjugated cyclic compound having a side chain represented by the following formula (2), the side chain is bonded to a carbon atom which is contained in a cyclic structure of the divalent residue of the π-conjugated cyclic compound represented by $Ar^1$ and has an $sp^2$ hybrid orbital,

$$-\!\!\left[ Ar^2 - X^1 - Z \right]_k\!\! - E^1 \qquad (2)$$

wherein $Ar^2$ represents a group having a divalent residue of a π-conjugated cyclic compound; $X^1$ represents a direct bond or a divalent group selected from the group consisting of $NQ^1$-, $-PQ^2$-, and $-BQ^3$-, wherein $Q^1$ to $Q^3$ each independently represents a substituent; Z represents a direct bond or a divalent linking group; k is an integer of 3 or more; $E^1$ represents a hydrogen atom, a halogen atom, or a monovalent organic group; when a plurality of $Ar^2$'s, $X^1$'s, and Z's are present, $Ar^2$'s, $X^1$'s, and Z's each may be the same or different, and when a plurality of side chains represented by the formula (2) are present, the side chains may be the same or different.

2. The aromatic graft polymer according to claim 1, wherein the aromatic graft polymer has a side chain for which a parameter f defined by the following formula (3) and representing the length of the side chain represented by the formula (2) satisfies a condition of $f \geq 4$,

$$f = k + m \quad (3)$$

wherein m represents the number of the divalent groups among the direct bond and divalent groups represented by $X^1$ in the side chain represented by the formula (2).

3. The aromatic graft polymer according to claim 2, wherein the parameter f satisfies a condition of $f \geq 5$.

4. The aromatic graft polymer according to claim 3, wherein k is 5 or more.

5. The aromatic graft polymer according to any one of claims 1 to 4, wherein the aromatic graft polymer, which contains the one or more kinds of repeating units represented by the formula (1), is a copolymer further containing another repeating unit.

6. The aromatic graft polymer according to claim 5, wherein the another repeating unit is a repeating unit selected from the group consisting of the following formulae (5) to (9),

$-Ar^4-$ (5)

$-Ar^5-$ (6)

$$-\!\left( Ar^6 - X^2 \right)_p\! - Ar^7 - \qquad (7)$$

$-Ar^8-X^3-$ (8)

$-X^4-$ (9)

wherein $Ar^4$ represents a repeating unit in which a side chain in $Ar^1$ in the formula (1) is substituted by a hydrogen atom; $Ar^5$, $Ar^6$, $Ar^7$, and $Ar^8$ each independently represent a group having a divalent residue of a π-conjugated cyclic compound; and $X^2$, $X^3$, and $X^4$ each independently represent a divalent linking group.

7. The aromatic graft polymer according to any one of claims 1 to 6, wherein the total amount of the repeating unit represented by the formula (1) to the total amount of the repeating units which are contained in the main chain and are represented by the formula (1) and the formulae (5) to (9) is 11 mol% or more and 100 mol% or less.

**8.** The aromatic graft polymer according to any one of claims 1 to 4, wherein the aromatic graft polymer comprises the repeating unit represented by the formula (1).

**9.** The aromatic graft polymer according to claim 6 or 7, wherein the aromatic graft polymer comprises the repeating units represented by the formulae (1) and (5).

**10.** The aromatic graft polymer according to claim 8 or 9, wherein a dispersion degree (weight average molecular weight/ number average molecular weight) is 1 or more and 12 or less.

**11.** The aromatic graft polymer according to any one of claims 1 to 10, wherein a number average molecular weight in terms of polystyrene is $10^3$ to $10^8$.

**12.** The aromatic graft polymer according to any one of claims 1 to 11, wherein the aromatic graft polymer has a charge transporting property or photoluminescence in a solid state.

**13.** A polymer composition **characterized by** comprising at least one material selected from the group consisting of a hole transporting material, an electron transporting material and a light emitting material, and the aromatic graft polymer according to any one of claims 1 to 12.

**14.** A solution **characterized by** comprising the aromatic graft polymer according to any one of claims 1 to 12.

**15.** A solution **characterized by** comprising the polymer composition according to claim 13.

**16.** A light emitting thin film **characterized by** comprising the aromatic graft polymer according to any one of claims 1 to 12 or the polymer composition according to claim 13.

**17.** A conductive thin film **characterized by** comprising the aromatic graft polymer according to any one of claims 1 to 12 or the polymer composition according to claim 13.

**18.** An organic semiconductor thin film **characterized by** comprising the aromatic graft polymer according to any one of claims 1 to 12 or the polymer composition according to claim 13.

**19.** An organic transistor **characterized by** comprising the organic semiconductor thin film according to claim 18.

**20.** A method for forming the thin film according to any one of claims 16 to 18, **characterized by** using an ink-jet method.

**21.** A method for forming the thin film according to any one claims 16 to 18, **characterized by** using a screen printing method, a flexo printing method, or an offset printing method.

**22.** A polymer light emitting device **characterized by** having an organic layer between electrodes consisting of an anode and a cathode, wherein the organic layer comprises the aromatic graft polymer according to any one of claims 1 to 12 or the polymer composition according to claim 13.

**23.** A planar light source **characterized by** comprising the polymer light emitting device according to claim 22.

**24.** A segment display device **characterized by** comprising the polymer light emitting device according to claim 22.

**25.** A dot matrix display device **characterized by** comprising the polymer light emitting device according to claim 22.

**26.** A liquid crystal display device **characterized by** comprising a backlight composed of the polymer light emitting device according to claim 22.

FIG.1

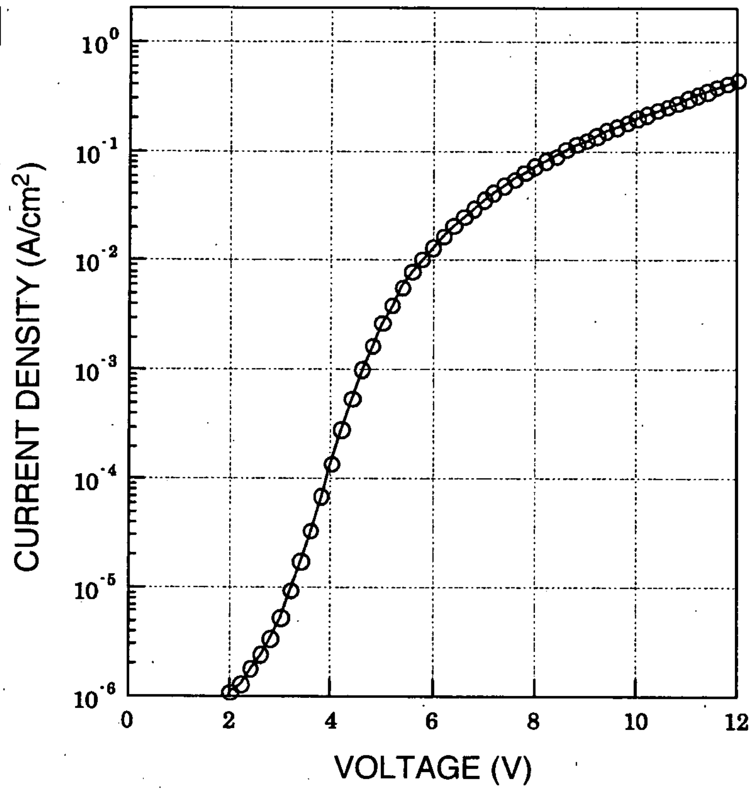
CURRENT DENSITY (A/cm2)
10^0
10^-1
10^-2
10^-3
10^-4
10^-5
10^-6
0
2
4
6
8
10
12
VOLTAGE (V)

FIG.2

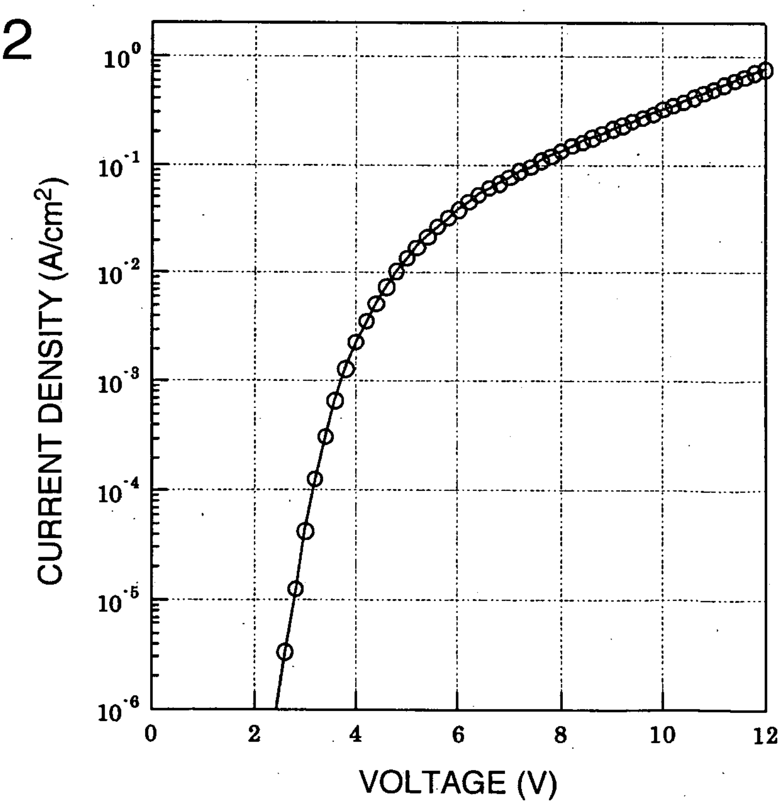
CURRENT DENSITY (A/cm2)
10^0
10^-1
10^-2
10^-3
10^-4
10^-5
10^-6
0
2
4
6
8
10
12
VOLTAGE (V)

FIG.3

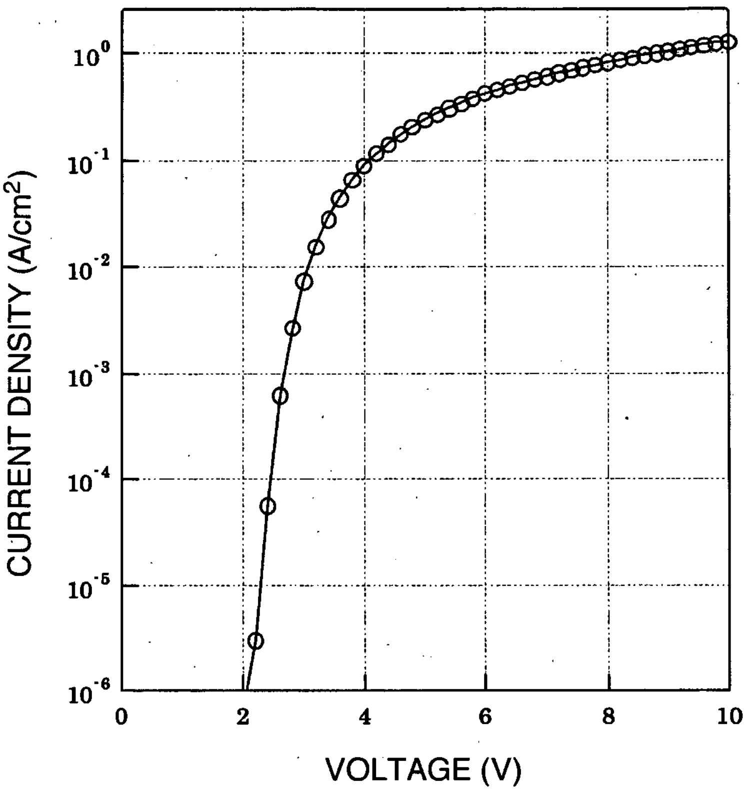
CURRENT DENSITY (A/cm²)
VOLTAGE (V)
10^0
10^-1
10^-2
10^-3
10^-4
10^-5
10^-6
0
2
4
6
8
10

FIG.4

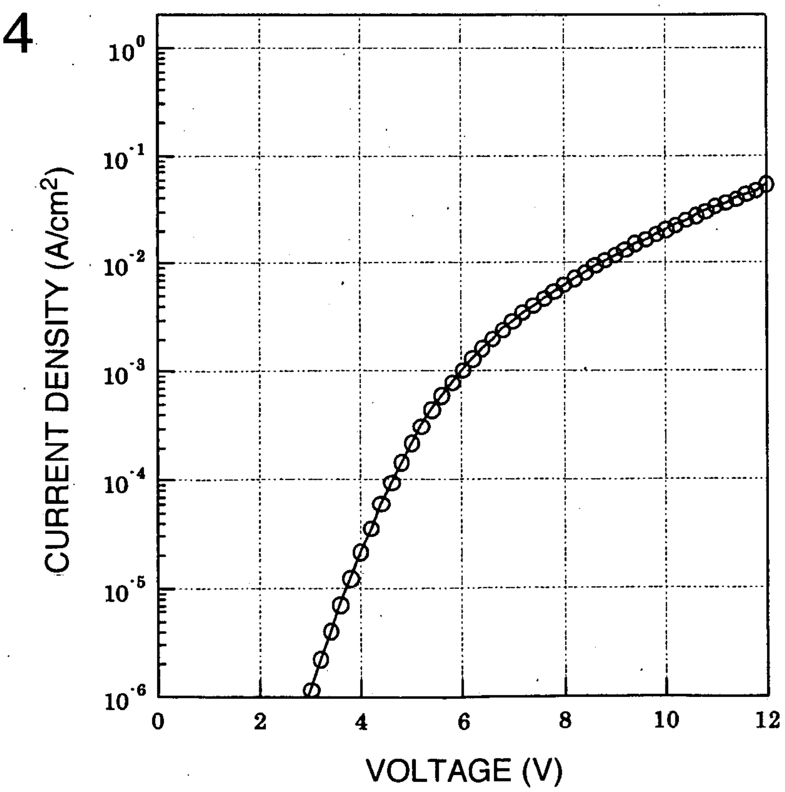
CURRENT DENSITY (A/cm²)
VOLTAGE (V)
10^0
10^-1
10^-2
10^-3
10^-4
10^-5
10^-6
0
2
4
6
8
10
12

FIG.5

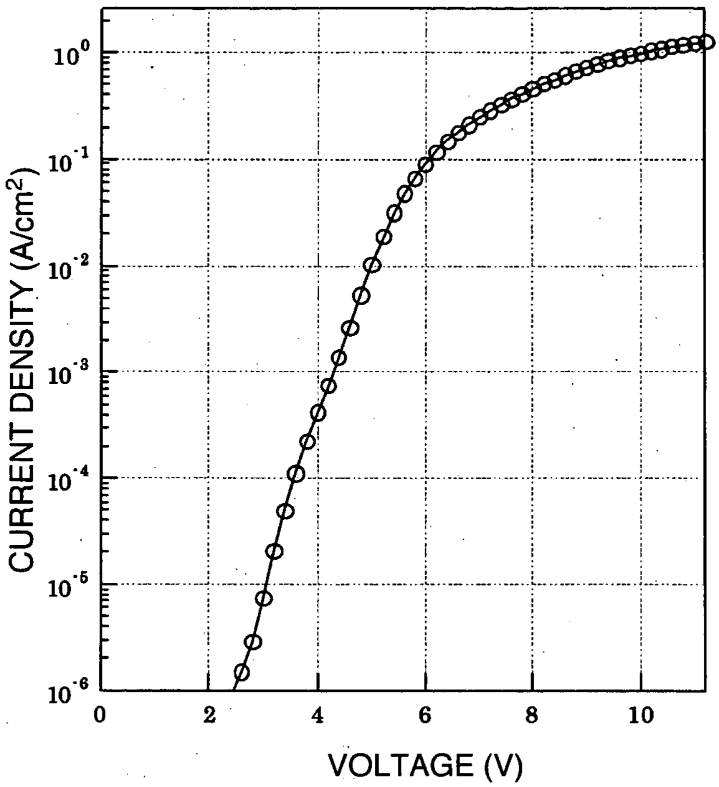
CURRENT DENSITY (A/cm$^2$)
$10^0$
$10^{-1}$
$10^{-2}$
$10^{-3}$
$10^{-4}$
$10^{-5}$
$10^{-6}$
0
2
4
6
8
10
VOLTAGE (V)

FIG.6

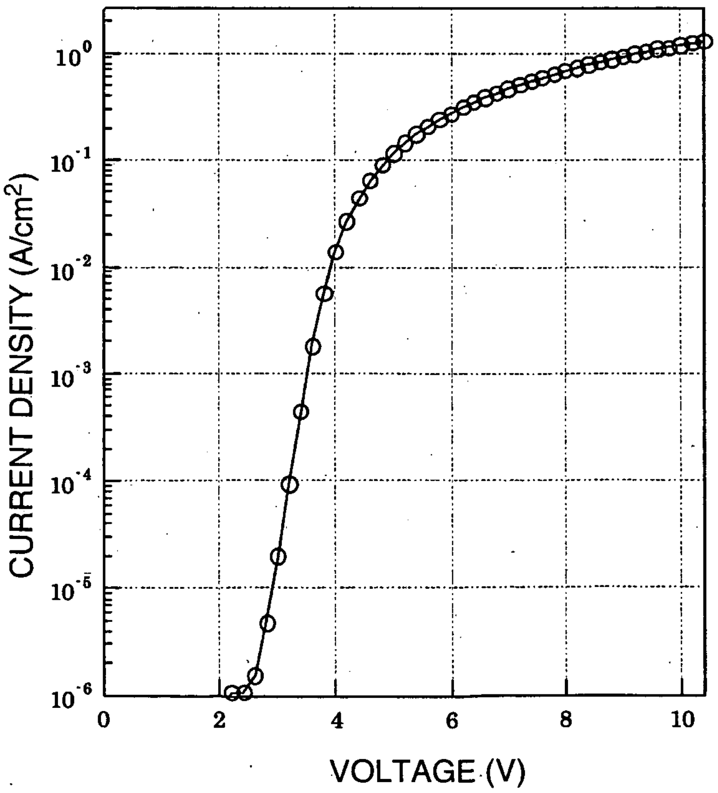
CURRENT DENSITY (A/cm$^2$)
$10^0$
$10^{-1}$
$10^{-2}$
$10^{-3}$
$10^{-4}$
$10^{-5}$
$10^{-6}$
0
2
4
6
8
10
VOLTAGE (V)

**INTERNATIONAL SEARCH REPORT**

International application No.
PCT/JP2006/311608

A. CLASSIFICATION OF SUBJECT MATTER
*C08G61/00*(2006.01), *C09K11/06*(2006.01), *H01L51/50*(2006.01), *H05B33/10*(2006.01)

According to International Patent Classification (IPC) or to both national classification and IPC

B. FIELDS SEARCHED

Minimum documentation searched (classification system followed by classification symbols)
C08G61/00-61/12

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,A | JP 2006-96871 A (JSR Corp.), 13 April, 2006 (13.04.06), Full text (Family: none) | 1-26 |
| P,A | JP 2005-306998 A (JSR Corp.), 04 November, 2005 (04.11.05), Full text (Family: none) | 1-26 |
| A | JP 2005-8860 A (Kanto Chemical Co., Inc.), 13 January, 2005 (13.01.05), Full text (Family: none) | 1-26 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 July, 2006 (06.07.06) | 18 July, 2006 (18.07.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

International application No.
PCT/JP2006/311608

<With respect to subject matter for search>

Claims 1-26 involve an extremely large number of aromatic graft polymers. However, the polymers which are disclosed in the meaning of Article 5 of the PCT are limited to an extremely small part of the polymers claimed. The claims are not sufficiently supported in the meaning of Article 6 of the PCT.

Therefore, a search was made for the part which is disclosed in and supported by the description, i.e., "one having the following formula (i) as the structure represented by [Chemical formula 2]."

Formula (i)

(R is unsubstituted alkyl)

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 3606217 B
- US 2001037000 A1
- JP 2001342459 A
- US 2002027623 A1
- JP 5202355 A
- WO 9913692 A
- WO 9948160 A
- GB 2340304 A
- WO 0053656 A
- WO 0119834 A
- WO 0055927 A
- GB 2348316 A
- WO 0046321 A
- WO 0006665 A
- WO 9954943 A
- WO 9954385 A
- US 5777070 A
- WO 9806773 A
- WO 9705184 A
- WO 0035987 A
- WO 0053655 A
- WO 0134722 A
- WO 9924526 A
- WO 0022027 A
- WO 0022026 A
- WO 9827136 A
- US 573636 A
- WO 9821262 A
- US 5741921 A
- WO 9709394 A
- WO 9629356 A
- WO 9610617 A
- EP 0707020 A
- WO 9507955 A
- JP 2001181618 A
- JP 2001123156 A
- JP 2001003045 A
- JP 2000351967 A
- JP 2000303066 A
- JP 2000299189 A
- JP 2000252065 A
- JP 2000136379 A
- JP 2000104057 A
- JP 2000080167 A
- JP 10324870 A
- JP 10114891 A
- JP 9111233 A
- JP 9045478 A
- JP 57051781 A
- JP 59194393 A
- JP 63070257 A
- JP 63175860 A
- JP 2135359 A
- JP 2135361 A
- JP 2209988 A
- JP 3037992 A
- JP 3152184 A
- GB 2300196 A

### Non-patent literature cited in the description

- Encyclopedia of Polymer Science and Technology. John Wiley & Sons, Inc, 15 July 2002
- *Journal of Polymer Science: Part A: Polymer Chemistry,* 2001, vol. 39, 1533-1556
- Organic Reactions. John Wiley & Sons, Inc, 1965, vol. 14, 270-490
- Organic Syntheses, Collective. John Wiley & Sons, Inc, 1988, vol. VI, 407-411
- *Chemical Review,* 1995, vol. 95, 2457
- *Journal of Organometallic Chemistry,* 1999, vol. 576, 147
- *Macromolecular Chemistry, Macromolecular Symposium,* 1987, vol. 12, 229
- *Nature,* 1998, vol. 395, 151
- *Appl. Phys. Lett.,* 1999, vol. 75 (1), 4
- *Proc. SPIE-Int. Soc. Opt. Eng.,* 2001, 4105
- *Organic Light emitting materials and Devices,* vol. IV, 119
- *J. Am. Chem. Soc.,* 2001, vol. 123, 4304
- *Appl. Phys. Lett.,* 1997, vol. 71 (18), 2596
- *Syn. Met.,* 1998, vol. 94 (1), 103
- *Syn. Met.,* 1999, vol. 99 (2), 1361
- *Adv. Mater.,* 1999, vol. 11 (10), 852
- *Jpn.J.Appl.Phys.,* 1995, vol. 34, 1883
- *Chem. Rev.,* 1989, vol. 89, 1359